# EUROPEAN PATENT APPLICATION

(11) **EP 4 647 286 A1**
(43) Date of publication of application: **12.11.2025**
(21) Application number: 23917242.2
(22) Date of filing: 05.12.2023
(51) Int. Cl.: B60L 53/22, H05K 5/00, H05K 7/20, B60L 1/00

(54) **VEHICLE-MOUNTED POWER SUPPLY DEVICE AND VEHICLE**

(30) Priority: 18.01.2023 CN 202310090162
(71) Applicant: Huawei Digital Power Technologies Co., Ltd., Shenzhen, Guangdong 518043 (CN)
(72) Inventor: LI, Ping, Shenzhen, Guangdong 518043 (CN); LIANG, Tao, Shenzhen, Guangdong 518043 (CN); HUANG, Yaqi, Shenzhen, Guangdong 518043 (CN); LIU, Ren, Shenzhen, Guangdong 518043 (CN)
(74) Representative: Epping - Hermann - Fischer
(86) International application number: PCT/CN2023/136399
(87) International publication number: WO 2024/152774

(57) **Abstract**

A vehicle-mounted power supply apparatus (10) and a vehicle (1) are disclosed. The vehicle-mounted power supply apparatus (10) includes a power conversion circuit (600), and an upper-layer PCB board (200), a lower-layer PCB board (300), and a heat dissipator (400) that are sequentially stacked and fastened to a bottom housing (100). The upper-layer PCB board (200) and the lower-layer PCB board (300) are configured to carry a plurality of power switching transistors (660) of the power conversion circuit (600). The bottom housing (100) is configured to support the upper-layer PCB board (200), the lower-layer PCB board (300), the heat dissipator (400), and a plurality of transformers (650).

## Description

This application claims priority to Chinese Patent Application 202310090162.8, filed with the China National Intellectual Property Administration on January 18, 2023 and entitled "VEHICLE-MOUNTED POWER SUPPLY APPARATUS AND VEHICLE", which is incorporated herein by reference in its entirety.

### TECHNICAL FIELD

This application relates to the field of vehicle power supply technologies, and in particular, to a vehicle-mounted power supply apparatus and a vehicle.

### BACKGROUND

A vehicle-mounted power supply apparatus is an important part of an electric vehicle. The vehicle-mounted power supply apparatus converts electrical energy transmitted by an external power source into a direct current, to supply power to a high-voltage battery pack and a low-voltage electrical device. A power conversion circuit of the vehicle-mounted power supply apparatus includes a plurality of components, and these components are configured to implement power conversion. With an increasing requirement on autonomous driving of the electric vehicle and use of various low-voltage electrical devices in the vehicle, low-voltage supply power is increasing, a size of the power conversion circuit of the vehicle-mounted power supply apparatus is increasing rapidly, and an increase in the size of the vehicle-mounted power supply apparatus affects a layout of the entire vehicle and space in the vehicle. In addition, the power conversion circuit further needs a heat dissipation apparatus to dissipate heat for the power conversion circuit, and so many components directly affect structural strength of mounting of the vehicle-mounted power supply apparatus.

### SUMMARY

This application provides a vehicle-mounted power supply apparatus and a vehicle.

According to a first aspect, an embodiment of this application provides a vehicle-mounted power supply apparatus. The vehicle-mounted power supply apparatus includes a power conversion circuit, an upper-layer PCB board, a lower-layer PCB board, a bottom housing, and a heat dissipator. The lower-layer PCB board, the upper-layer PCB board, and the heat dissipator are sequentially stacked and fastened to the bottom housing. The power conversion circuit includes a plurality of power switching transistors and a plurality of transformers. The upper-layer PCB board and the lower-layer PCB board are configured to carry the plurality of power switching transistors. The bottom housing is configured to support the upper-layer PCB board, the lower-layer PCB board, the heat dissipator, and the plurality of transformers.

The heat dissipator, the upper-layer PCB board, and the lower-layer PCB board are sequentially stacked, so that a size of internal space occupied in the vehicle-mounted power supply apparatus can be reduced. The heat dissipator, the upper-layer PCB board, and the lower-layer PCB board are all fastened to the bottom housing and supported by the bottom housing, so that fastening stability of the heat dissipator, the upper-layer PCB board, the lower-layer PCB board, and the bottom housing is high, and overall structural strength of the vehicle-mounted power supply apparatus is higher. When an external environment applies an external force to the vehicle-mounted power supply apparatus, the lower-layer PCB board, the upper-layer PCB board, the heat dissipator, and the power conversion circuit are not prone to displacement relative to the bottom housing. This helps the vehicle-mounted power supply apparatus operate in a stable state.

The upper-layer PCB board and the lower-layer PCB board each are configured to carry some of the power switching transistors, so that the power conversion circuit is distributed on the upper-layer PCB board and the lower-layer PCB board that are stacked. Compared with an implementation in which the power conversion circuit is distributed on one PCB board, in this implementation, the power conversion circuit is distributed more flexibly, and an area of the vehicle-mounted power supply apparatus on a horizontal plane can be reduced.

The lower-layer PCB board, the upper-layer PCB board, and the heat dissipator are sequentially stacked, and the heat dissipator is located on a side, away from the bottom housing, of the upper-layer PCB board. In this way, the heat dissipator can cool and dissipate heat for a heat generating component on the upper-layer PCB board, and the power conversion circuit can operate within a proper temperature range.

The power switching transistors are carried on the upper-layer PCB board and the lower-layer PCB board, and the transformers are supported by the bottom housing. In this way, the upper-layer PCB board, the lower-layer PCB board, and the bottom housing each carry a part of the power conversion circuit, and components of the power conversion circuit are distributed at different positions in the vehicle-mounted power supply apparatus, so that a layout of the power conversion circuit is optimized, and space utilization of the vehicle-mounted power supply apparatus can be improved. This facilitates a miniaturization design of the vehicle-mounted power supply apparatus. In a possible implementation, the vehicle-mounted power supply apparatus includes a cover. The cover is configured to form an accommodation cavity together with the bottom housing. The accommodation cavity is configured to accommodate the lower-layer PCB board, the upper-layer PCB board, the heat dissipator, and the plurality of transformers. The lower-layer PCB board, the upper-layer PCB board, the heat dissipator, and the cover are sequentially stacked along a height direction of the vehicle-mounted power supply apparatus.

In this implementation, the accommodation cavity is configured to protect the lower-layer PCB board, the upper-layer PCB board, the heat dissipator, and the plurality of transformers inside from being affected by the external environment. Along the height direction of the vehicle-mounted power supply apparatus, the upper-layer PCB board is disposed closer to the cover than the lower-layer PCB board, and the heat dissipator is disposed between the cover and the upper-layer PCB board. The heat dissipator may be configured to cool and dissipate heat for power switching transistors of the upper-layer PCB board. In this implementation, the lower-layer PCB board, the upper-layer PCB board, the heat dissipator, and the cover are sequentially stacked, so that these components are arranged more compactly. This helps reduce a size of the vehicle-mounted power supply apparatus.

In a possible implementation, the power conversion circuit includes an alternating current-to-direct current conversion circuit, a low-voltage direct current conversion circuit, and a high-voltage direct current conversion circuit. The alternating current-to-direct current conversion circuit is configured to receive an alternating current and supply power to at least one of the high-voltage direct current conversion circuit or the low-voltage direct current conversion circuit. The low-voltage direct current conversion circuit is configured to receive power supply from at least one of the alternating current-to-direct current conversion circuit or the high-voltage direct current conversion circuit and output a first direct current. The high-voltage direct current conversion circuit is configured to receive power supply from the alternating current-to-direct current conversion circuit and output a second direct current. A voltage of the second direct current is higher than a voltage of the first direct current.

In this implementation, an external power source inputs an alternating current to the power conversion circuit, and the alternating current is transmitted to at least one of the low-voltage direct current conversion circuit and the high-voltage direct current conversion circuit after passing through the alternating current-to-direct current conversion circuit. After receiving the alternating current, the high-voltage direct current conversion circuit converts the alternating current into the second direct current to supply power to a battery. Alternatively, the high-voltage direct current conversion circuit converts the alternating current into the second direct current to supply power to the low-voltage direct current conversion circuit. After receiving the alternating current, the low-voltage direct current conversion circuit converts the alternating current into the first direct current to supply power to a first-type load. Alternatively, the low-voltage direct current conversion circuit receives the second direct current and converts the second direct current into the first direct current to supply power to a first-type load. The voltage of the second direct current is higher than the voltage of the first direct current. After the alternating current supplied by the external power source passes through the power conversion circuit, alternating current-to-direct current conversion occurs, and a voltage value changes, so that the vehicle-mounted power supply apparatus can supply power to different types of vehicle-mounted loads. This improves adaptability of the vehicle-mounted power supply apparatus.

In a possible implementation, the low-voltage direct current conversion circuit includes a low-voltage transformer, a primary-side circuit, and a secondary-side circuit. The primary-side circuit is configured to receive power supply from at least one of the alternating current-to-direct current conversion circuit or the high-voltage direct current conversion circuit. The secondary-side circuit is configured to output the first direct current. The upper-layer PCB board is configured to carry a plurality of power switching transistors of the primary-side circuit in the low-voltage direct current conversion circuit. The lower-layer PCB board is configured to carry a plurality of power switching transistors of the secondary-side circuit in the low-voltage direct current conversion circuit. The bottom housing is configured to fasten the low-voltage transformer of the low-voltage direct current conversion circuit.

In this implementation, the upper-layer PCB board and the lower-layer PCB board are configured to carry the plurality of power switching transistors of the primary-side circuit and the plurality of power switching transistors of the secondary-side circuit respectively, so that the low-voltage direct current conversion circuit is distributed on the upper-layer PCB board and the lower-layer PCB board. In this way, components are distributed more flexibly compared with an implementation in which all power switching transistors of the low-voltage direct current conversion circuit are carried on one PCB board.

In this implementation, the low-voltage transformer is fastened to both the upper-layer PCB board and the lower-layer PCB board, so that other components electrically connected to the low-voltage transformer can be respectively disposed on the upper-layer PCB board and the lower-layer PCB board. This prevents all components in the power conversion circuit from being centrally mounted on the upper-layer PCB board or the lower-layer PCB board, so that areas of mounting surfaces of the upper-layer PCB board and the lower-layer PCB board can be effectively reduced. This facilitates a miniaturization design of the vehicle-mounted power supply apparatus.

In this implementation, the low-voltage transformer is also fastened to the bottom housing, so that the low-voltage transformer, the lower-layer PCB board, the upper-layer PCB board, and the heat dissipator are all fastened to the bottom housing. In this way, overall structural strength of these components in the vehicle-mounted power supply apparatus is higher.

In a possible implementation, the bottom housing includes a plurality of first protrusions and two shield protrusions. The plurality of first protrusions are distributed in a bottom housing region between the two shield protrusions. Heights of the plurality of first protrusions are less than heights of the two shield protrusions along a height direction of the vehicle-mounted power supply apparatus. The plurality of first protrusions are configured to fasten the lower-layer PCB board. The two shield protrusions are configured to fasten the upper-layer PCB board. The two shield protrusions and the upper-layer PCB board form a lower-layer PCB board shield region. The lower-layer PCB board shield region is configured to reduce electrical interference to the lower-layer PCB board.

In this implementation, the lower-layer PCB board is located in the lower-layer PCB board shield region between the two shield protrusions, the lower-layer PCB board with a lower height is fastened to the bottom housing through the first protrusion with a lower height, and the upper-layer PCB board with a higher height is fastened through the shield protrusion with a higher height, so that the upper-layer PCB board and the lower-layer PCB board can be sequentially stacked and fastened to the bottom housing. This can improve overall structural strength of the vehicle-mounted power supply apparatus and reduce a size. In addition, the upper-layer PCB board can be further reused to form the lower-layer PCB board shield region together with the shield protrusion, to ensure shielding effect of the shield protrusion for the lower-layer PCB board. In this way, mutual electrical interference between the lower-layer PCB board and a component located on the other side of the shield protrusion is small. In this implementation, the shield protrusion can simultaneously perform a support function, a fastening function, and a shielding function.

In a possible implementation, the bottom housing includes a base plate, a front side wall, a rear side wall, a left side wall, and a right side wall. The front side wall and the rear side wall are arranged opposite to each other. The left side wall and the right side wall are arranged opposite to each other. The base plate, the front side wall, the rear side wall, the left side wall, and the right side wall form a groove structure. A height of any one of the front side wall, the rear side wall, the left side wall, and the right side wall is greater than a height of the upper-layer PCB board along a height direction of the vehicle-mounted power supply apparatus.

In this implementation, the height of the upper-layer PCB board is a distance between the upper-layer PCB board and the base plate, and a height of any side wall in the bottom housing is greater than the height of the upper-layer PCB board, so that the upper-layer PCB board is located in the bottom housing. In this way, space is available above the upper-layer PCB board to accommodate the heat dissipator or a plurality of power switching transistors on an upper surface of the upper-layer PCB board.

In a possible implementation, the lower-layer PCB board and the plurality of transformers are tiled above the base plate, the upper-layer PCB board is stacked above the lower-layer PCB board and the plurality of transformers, the heat dissipator is stacked above the upper-layer PCB board, and an orthographic projection of the lower-layer PCB board on the base plate and an orthographic projection of the heat dissipator on the base plate are staggered.

In this implementation, that the lower-layer PCB board and the plurality of transformers are tiled above the base plate means that orthographic projections of the lower-layer PCB board and the plurality of transformers on the base plate do not overlap. For example, the lower-layer PCB board and the plurality of transformers may be arranged along a left-right direction or a front-rear direction of the vehicle-mounted power supply apparatus. In this tiled arrangement mode, space above the base plate can be fully utilized, and the lower-layer PCB board and the plurality of transformers are distributed in the bottom housing more compactly. This facilitates miniaturization of the vehicle-mounted power supply apparatus.

In this implementation, the upper-layer PCB board is stacked above the lower-layer PCB board and the plurality of transformers, so that the upper-layer PCB board covers the lower-layer PCB board and the plurality of transformers. In addition, this helps electrically connect the transformers to a lower surface of the upper-layer PCB board in a plug-connected manner.

In this implementation, the plurality of transformers and the lower-layer PCB board are tiled, and the orthographic projection of the lower-layer PCB board on the base plate and the orthographic projection of the heat dissipator on the base plate are staggered, so that the heat dissipator can be better stacked with the plurality of transformers along the height direction. This helps improve heat dissipation effect of the heat dissipator for the plurality of transformers, and further helps improve heat dissipation effect for the vehicle-mounted power supply apparatus and increase power of the vehicle-mounted power supply apparatus.

In a possible implementation, the front side wall includes a plurality of electrical interfaces, and the rear side wall includes a cooling channel interface. The lower-layer PCB board is closer to the front side wall than the heat dissipator. The lower-layer PCB board and the upper-layer PCB board are configured to electrically connect to at least one of the plurality of electrical interfaces. The heat dissipator is closer to the rear side wall than the lower-layer PCB board, and the heat dissipator is configured to connect to the cooling channel interface.

In this implementation, the plurality of electrical interfaces are disposed on the front side wall, and the cooling channel interface is disposed on the rear side wall, so that the electrical interfaces and the cooling channel interface are isolated in physical space. This prevents a coolant leaking from the cooling channel interface from affecting electrical performance of the electrical interfaces, so that the vehicle-mounted power supply apparatus is safer.

In this implementation, the electrical interfaces are disposed on the front side wall, the secondary-side circuit of the low-voltage direct current conversion circuit is located on the lower-layer PCB board, and the lower-layer PCB board is disposed close to the front side wall along the front-rear direction of the vehicle-mounted power supply apparatus. This helps transmit the first direct current output by the secondary-side circuit of the low-voltage direct current conversion circuit to the first-type load through the electrical interface, and shorten a distance between an output end of the secondary-side circuit of the low-voltage direct current conversion circuit and the electrical interface, so that a layout of the vehicle-mounted power supply apparatus is more appropriate.

In this implementation, the cooling channel interface is disposed on the rear side wall, and the heat dissipator is closer to the rear side wall than the lower-layer PCB board, so that a connection distance between the heat dissipator and the cooling channel interface is shorter. This better helps ensure sealing between the heat dissipator and the cooling channel interface. In addition, the lower-layer PCB board is farther away from the cooling channel interface of the rear side wall, so that the lower-layer PCB board can be prevented from being damaged by a coolant leaking from a cooling channel.

In a possible implementation, the front side wall includes a first direct current interface and a control signal interface, and the power conversion circuit outputs a first direct current through the first direct current interface and receives a control signal through the control signal interface. A lower surface of the upper-layer PCB board includes a control signal connector, and the control signal connector is configured to electrically connect the control signal interface to the upper-layer PCB board. An upper surface of the lower-layer PCB board includes at least a part of a low-voltage filter circuit, and the low-voltage filter circuit is configured to electrically connect the first direct current interface to the lower-layer PCB board.

In this implementation, the control signal connector is disposed on the lower surface of the upper-layer PCB board, and a part of the low-voltage filter circuit is disposed on the upper surface of the lower-layer PCB board, so that space between the upper-layer PCB board and the lower-layer PCB board can be fully utilized.

In a possible implementation, a shield can is disposed between the upper-layer PCB board and the lower-layer PCB board. The shield can is configured to form a control signal shield cavity together with the lower surface of the upper-layer PCB board. The control signal shield cavity is configured to accommodate the control signal connector. The shield can is configured to form a low-voltage filter shield cavity together with the upper surface of the lower-layer PCB board. The low-voltage filter shield cavity is configured to accommodate at least a part of the low-voltage filter circuit. In this implementation, space between the upper-layer PCB board and the lower-layer PCB board is used for placing the shield can, so that the space between the two PCB boards can be fully utilized. In addition, a shield wall may be formed between the shield can and the two PCB boards to shield electrical components on the two PCB boards. The shield can shields and isolates the control signal connector from at least a part of the low-voltage filter circuit, to prevent the low-voltage filter circuit from interfering with a signal transmitted in the control signal connector. This improves signal transmission quality.

In a possible implementation, the heat dissipator includes an upper-layer cooling channel, the bottom housing includes a lower-layer cooling channel, and the rear side wall includes a cooling channel interface. The cooling channel interface is configured for an external cooling system to communicate with the lower-layer cooling channel and the upper-layer cooling channel. The external cooling system is configured to exchange a cooling medium with the lower-layer cooling channel and the upper-layer cooling channel through the cooling channel interface.

In this implementation, the upper-layer cooling channel may be configured to cool and dissipate heat for power switching transistors of the upper-layer PCB board, and the lower-layer cooling channel may cool and dissipate heat for components, such as the plurality of transformers, an inductor, and a capacitor, that are fastened to the bottom housing. In addition, the two layers of cooling channels communicate with each other through the cooling channel interface, so that a coolant can circulate between the two layers of cooling channels. This improves even cooling effect for the vehicle-mounted power supply apparatus, and improves temperature uniformity of the vehicle-mounted power supply apparatus.

In a possible implementation, the cooling channel interface includes two heat dissipator interfaces. The heat dissipator interfaces are disposed on an upper surface of the rear side wall, and the two heat dissipator interfaces are configured to communicate with an inlet and an outlet of the upper-layer cooling water channel respectively. In this implementation, the external cooling system communicates with the upper-layer cooling channel through the heat dissipator interfaces. This performs a coolant guiding function.

In a possible implementation, the cooling channel interface further includes two external cooling system interfaces. The external cooling system interfaces are disposed on a side surface, away from the upper-layer PCB board, of the rear side wall, and the two external cooling system interfaces are configured to communicate with an outlet and an inlet of the external cooling system respectively. A coolant enters a cooling channel in the vehicle-mounted power supply apparatus through the external cooling system interface.

In a possible implementation, the cooling channel interface further includes two bottom housing connection interfaces. The two bottom housing connection interfaces are configured to communicate with an inlet and an outlet of the lower-layer cooling water channel respectively. The external cooling system communicates with the lower-layer cooling channel through the bottom housing connection interfaces. This performs a coolant guiding function. The external cooling system interface communicates with the heat dissipator interface and the bottom housing connection interface. A coolant enters the upper-layer cooling channel and the lower-layer cooling channel through the external cooling system interface, flows through the upper-layer cooling channel and the lower-layer cooling channel, and then flows out from the external cooling system interface. In this implementation, the heat dissipator interface communicates with the bottom housing connection interface, so that the upper-layer cooling channel communicates with the lower-layer cooling channel. This helps increase an area of contact between the coolant and the vehicle-mounted power supply apparatus.

In a possible implementation, the power conversion circuit includes an AC filter, a PFC capacitor, a PFC inductor, a low-voltage transformer, an LLC transformer, and an HVDC filter. The PFC capacitor, the PFC inductor, and the LLC transformer are adjacently arranged close to the rear side wall of the vehicle-mounted power supply apparatus. The PFC capacitor and the AC filter are adjacently arranged close to the right side wall of the vehicle-mounted power supply apparatus. The HVDC filter and the LLC transformer are adjacently arranged close to the left side wall of the vehicle-mounted power supply apparatus.

In this implementation, components in the power conversion circuit are disposed close to at least one side wall of the vehicle-mounted power supply apparatus, so that other components can be disposed in regions left empty between the front side wall and the right side wall and between the left side wall and the right side wall. This improves utilization of internal space of the vehicle-mounted power supply apparatus.

In a possible implementation, the base plate includes a first shield protrusion, a second shield protrusion, a third shield protrusion, and a fourth shield protrusion. The first shield protrusion and the second shield protrusion form a lower-layer PCB board mounting region, and the lower-layer PCB board mounting region is configured to accommodate the lower-layer PCB board. The first shield protrusion and the right side wall form an AC filter mounting region, and the AC filter mounting region is configured to accommodate the AC filter. The second shield protrusion and the left side wall form an HVDC filter mounting region, and the HVDC filter mounting region is configured to accommodate the HVDC filter. The third shield protrusion and the right side wall form a PFC capacitor mounting region, and the PFC capacitor mounting region is configured to accommodate the PFC capacitor. The fourth shield protrusion and the rear side wall form a PFC inductor mounting region, and the PFC inductor mounting region is configured to accommodate the PFC inductor.

In this implementation, the first shield protrusion, the second shield protrusion, the third shield protrusion, and the fourth shield protrusion divide the base plate into a plurality of mounting regions, including a lower-layer PCB board mounting region, an AC filter mounting region, an HVDC filter mounting region, a PFC capacitor mounting region, and a PFC inductor mounting region. The mounting regions are arranged, so that a mounting operation for the power conversion circuit can be performed more easily, components in the mounting regions can be protected to some extent, and the components in the mounting regions can be further shielded and isolated. This improves electromagnetic compatibility of the vehicle-mounted power supply apparatus.

According to a second aspect, this application provides a vehicle, including a first-type load, a battery, and the vehicle-mounted power supply apparatus according to any one of the foregoing implementations. The power conversion circuit is configured to output a first direct current and a second direct current. The first direct current is to be transmitted to the first-type load to supply power. The second direct current is to be transmitted to the battery to supply power. A voltage of the second direct current is higher than a voltage of the first direct current. The vehicle-mounted power supply apparatus provided in this application has a smaller size, higher overall structural strength, and higher electromagnetic compatibility, and is applied to the vehicle. This helps optimize an overall layout of the vehicle.

### BRIEF DESCRIPTION OF DRAWINGS

To describe technical solutions in embodiments of this application more clearly, the following describes accompanying drawings used in embodiments of this application.
FIG. 1 is a diagram of a structure of a vehicle according to an embodiment of this application;
FIG. 2 is a diagram of an application scenario of a vehicle-mounted power supply apparatus according to an embodiment of this application;
FIG. 3 is an exploded view of a vehicle-mounted power supply apparatus according to an implementation of this application;
FIG. 4 is a diagram of a structure of a vehicle-mounted power supply apparatus according to an implementation of this application;
FIG. 5 is a diagram of a structure of an upper-layer PCB board and a lower-layer PCB board according to an implementation of this application;
FIG. 6 is a diagram of a structure of an upper-layer PCB board and a lower-layer PCB board according to an implementation of this application;
FIG. 7 is a diagram of a structure of an upper-layer PCB board and a lower-layer PCB board according to an implementation of this application;
FIG. 8 is a diagram of an application scenario of a power conversion circuit according to an implementation of this application;
FIG. 9 is a diagram of a structure of an upper-layer PCB board, a lower-layer PCB board, and a power conversion circuit according to an implementation of this application;
FIG. 10 is a diagram of a structure of a vehicle-mounted power supply apparatus according to an implementation of this application;
FIG. 11 is a diagram of a structure of a bottom housing and an upper-layer PCB board according to an implementation of this application;
FIG. 12 is a diagram of a structure of a bottom housing according to an implementation of this application;
FIG. 13 is a partial exploded view of a vehicle-mounted power supply apparatus according to an implementation of this application;
FIG. 14 is a diagram of a partial structure of a vehicle-mounted power supply apparatus according to an implementation of this application;
FIG. 15 is a partial exploded view of a vehicle-mounted power supply apparatus according to an implementation of this application;
FIG. 16 is a diagram of a partial structure of a vehicle-mounted power supply apparatus according to an implementation of this application;
FIG. 17 is a partial exploded view of a vehicle-mounted power supply apparatus according to an implementation of this application;
FIG. 18 is a partial exploded view of a vehicle-mounted power supply apparatus according to an implementation of this application;
FIG. 19 is a diagram of a partial structure of a vehicle-mounted power supply apparatus according to an implementation of this application;
FIG. 20 is a diagram of a partial structure of a vehicle-mounted power supply apparatus according to an implementation of this application;
FIG. 21 is a diagram of a structure of a bottom housing and a power conversion circuit according to an implementation of this application;
FIG. 22 is a diagram of a structure of a bottom housing and a power conversion circuit according to an implementation of this application;
FIG. 23 is a diagram of a structure of an upper-layer PCB board, a lower-layer PCB board, and a part of a power conversion circuit according to an implementation of this application;
FIG. 24 is a diagram of a structure of an upper-layer PCB board, a lower-layer PCB board, and a part of a power conversion circuit according to an implementation of this application;
FIG. 25 is a diagram of a structure of an upper-layer PCB board, a lower-layer PCB board, and a part of a power conversion circuit according to an implementation of this application;
FIG. 26 is a diagram of a structure of an upper-layer PCB board, a lower-layer PCB board, and a part of a power conversion circuit according to an implementation of this application;
FIG. 27 is a diagram of a partial structure of a vehicle-mounted power supply apparatus according to an implementation of this application;
FIG. 28 is a diagram of a structure of a lower-layer PCB board and a part of a power conversion circuit according to an implementation of this application;
FIG. 29 is a diagram of a partial structure of a vehicle-mounted power supply apparatus according to an implementation of this application;
FIG. 30 is a diagram of a structure of a bottom housing and electrical interfaces according to an implementation of this application;
FIG. 31 is a partial exploded view of a vehicle-mounted power supply apparatus according to an implementation of this application;
FIG. 32 is a diagram of a structure of a control signal connector and a low-voltage filter circuit in a vehicle-mounted power supply apparatus according to an implementation of this application;
FIG. 33 is a diagram of a structure of an upper-layer PCB board and a part of a power conversion circuit according to an implementation of this application;
FIG. 34 is a diagram of a structure of an upper-layer PCB board and a part of a power conversion circuit according to an implementation of this application;
FIG. 35 is a diagram of a structure of a lower-layer PCB board and a part of a power conversion circuit according to an implementation of this application;
FIG. 36 is a diagram of a partial structure of a vehicle-mounted power supply apparatus according to an implementation of this application;
FIG. 37 is a diagram of a partial structure of a vehicle-mounted power supply apparatus according to an implementation of this application;
FIG. 38 is a diagram of a partial structure of a vehicle-mounted power supply apparatus according to an implementation of this application;
FIG. 39 is a diagram of a partial structure of a vehicle-mounted power supply apparatus according to an implementation of this application;
FIG. 40 is a diagram of a partial structure of a vehicle-mounted power supply apparatus according to an implementation of this application;
FIG. 41 is a diagram of a partial structure of a vehicle-mounted power supply apparatus according to an implementation of this application;
FIG. 42 is a diagram of a structure of a shield can according to an implementation of this application;
FIG. 43 is a diagram of a structure of a shield can according to an implementation of this application;
FIG. 44 is a partial exploded view of a vehicle-mounted power supply apparatus according to an implementation of this application;
FIG. 45 is a diagram of a structure of a first shield can in a shield can according to an implementation of this application;
FIG. 46 is a diagram of a structure of a second shield can in a shield can according to an implementation of this application;
FIG. 47 is a diagram of a structure of a shield can according to an implementation of this application;
FIG. 48 is a diagram of a structure of a shield can and a bottom housing according to an implementation of this application;
FIG. 49 is a diagram of a structure of a shield can and an upper-layer PCB board according to an implementation of this application;
FIG. 50 is a diagram of a structure of a shield can and a lower-layer PCB board according to an implementation of this application;
FIG. 51 is a partial exploded view of a vehicle-mounted power supply apparatus according to an implementation of this application;
FIG. 52 is a diagram of a partial structure of a vehicle-mounted power supply apparatus according to an implementation of this application;
FIG. 53 is a diagram of a structure of a signal filter shield can and a control signal connector according to an implementation of this application;
FIG. 54 is a diagram of a partial structure of a vehicle-mounted power supply apparatus according to an implementation of this application;
FIG. 55 is a partial exploded view of a vehicle-mounted power supply apparatus according to an implementation of this application;
FIG. 56 is a diagram of a partial structure of a vehicle-mounted power supply apparatus according to an implementation of this application;
FIG. 57 is a diagram of a partial structure of a vehicle-mounted power supply apparatus according to an implementation of this application;
FIG. 58 is a diagram of a partial structure of a vehicle-mounted power supply apparatus according to an implementation of this application;
FIG. 59 is a diagram of a partial structure of a vehicle-mounted power supply apparatus according to an implementation of this application;
FIG. 60 is a diagram of a partial structure of a vehicle-mounted power supply apparatus according to an implementation of this application;
FIG. 61 is a diagram of a partial structure of a vehicle-mounted power supply apparatus according to an implementation of this application;
FIG. 62 is a diagram of a partial structure of a vehicle-mounted power supply apparatus according to an implementation of this application;
FIG. 63 is a cross-sectional view of a vehicle-mounted power supply apparatus according to an implementation of this application;
FIG. 64 is a diagram of a structure of an upper-layer PCB board and a heat dissipator according to an implementation of this application;
FIG. 65 is a diagram of a partial structure of a vehicle-mounted power supply apparatus according to an implementation of this application;
FIG. 66 is a diagram of a structure of an upper-layer cooling channel and power switching transistors according to an implementation of this application;
FIG. 67 is a diagram of a structure of a cover and an upper-layer PCB board according to an implementation of this application;
FIG. 68 is a diagram of a structure of an upper-layer cooling channel according to an implementation of this application;
FIG. 69 is a diagram of a structure of an upper-layer cooling channel according to an implementation of this application;
FIG. 70 is a diagram of a structure of an upper-layer cooling channel according to an implementation of this application;
FIG. 71 is a diagram of a partial structure of a vehicle-mounted power supply apparatus according to an implementation of this application;
FIG. 72 is a diagram of a partial structure of a vehicle-mounted power supply apparatus according to an implementation of this application;
FIG. 73 is a diagram of a partial structure of a vehicle-mounted power supply apparatus according to an implementation of this application;
FIG. 74 is a diagram of a partial structure of a vehicle-mounted power supply apparatus according to an implementation of this application;
FIG. 75 is a diagram of a partial structure of a vehicle-mounted power supply apparatus according to an implementation of this application;
FIG. 76 is a diagram of a partial structure of a vehicle-mounted power supply apparatus according to an implementation of this application;
FIG. 77 is a partial enlarged view of a vehicle-mounted power supply apparatus according to an implementation of this application;
FIG. 78 is a partial enlarged view of a vehicle-mounted power supply apparatus according to an implementation of this application;
FIG. 79 is a diagram of a partial structure of a vehicle-mounted power supply apparatus according to an implementation of this application;
FIG. 80 is a partial exploded view of a vehicle-mounted power supply apparatus according to an implementation of this application;
FIG. 81 is a partial exploded view of a vehicle-mounted power supply apparatus according to an implementation of this application;
FIG. 82 is a partial exploded view of a vehicle-mounted power supply apparatus according to an implementation of this application;
FIG. 83 is a diagram of a structure of a bottom housing in a vehicle-mounted power supply apparatus according to an implementation of this application;
FIG. 84 is a diagram of a structure of a shield protrusion according to an implementation of this application;
FIG. 85 is a diagram of a structure of a shield protrusion according to an implementation of this application;
FIG. 86 is a diagram of a structure of a bottom housing and an upper-layer PCB board according to an implementation of this application;
FIG. 87 is a diagram of a structure of a bottom housing and a power conversion circuit according to an implementation of this application;
FIG. 88 is a diagram of a structure of a bottom housing in a vehicle-mounted power supply apparatus according to an implementation of this application;
FIG. 89 is a diagram of a structure of a third shield protrusion and a fourth shield protrusion according to an implementation of this application; and
FIG. 90 is a diagram of a structure of a bottom housing in a vehicle-mounted power supply apparatus according to an implementation of this application.

### DESCRIPTION OF EMBODIMENTS

The following describes technical solutions in embodiments of this application with reference to accompanying drawings in embodiments of this application. Clearly, the described embodiments are merely some but not all of embodiments of this application.

Terms "first", "second", and the like in this specification are merely intended for a purpose of description, and shall not be understood as an indication or implication of relative importance or an implicit indication of a quantity of indicated technical features. Therefore, a feature limited by "first" or "second" may explicitly or implicitly include one or more features. In descriptions of this application, "a plurality of" means two or more, unless otherwise specified.

In this specification, orientation terms such as "above", "below", "front", "rear", "left", "right", "top", "bottom", "inside", and "outside" are defined relative to placement orientations of structures shown in the accompanying drawings. It should be understood that these directional terms are relative concepts used for relative description and clarification, and may correspondingly change based on changes in the placement orientations of the structures.

In this specification, unless otherwise explicitly specified and limited, that a first feature is "above" or "below" a second feature may be that the first and second features are in direct contact, or the first and second features are in indirect contact through an intermediate medium. In addition, that a first feature is "above" a second feature may be that the first feature is directly above or obliquely above the second feature, or merely indicates that a horizontal height of the first feature is greater than a horizontal height of the second feature. That a first feature is "below" a second feature may be that the first feature is directly below or obliquely below the second feature, or merely indicates that a horizontal height of the first feature is lower than a horizontal height of the second feature. For ease of understanding, the following first describes English abbreviations and related technical terms used in embodiments of this application.

PCB: Printed Circuit Board, printed circuit board. The PCB is a carrier for electrical interconnection between electronic components.

AC: AC is short for Alternating Current, alternating current. An AC filter is a filter in an alternating current-to-direct current conversion circuit.

PFC: Power Factor Correction, which means "power factor correction". A PFC capacitor is a capacitor in an alternating current-to-direct current conversion circuit, and a PFC inductor is an inductor in an alternating current-to-direct current conversion circuit.

HVDC: HVDC usually stands for high-voltage direct current transmission. An HVDC filter is a filter in a high-voltage direct current conversion circuit, and the HVDC filter may also be referred to as a high-voltage direct current filter.

LVDC: LVDC usually stands for low-voltage direct current transmission. An LVDC filter is a filter in a low-voltage direct current conversion circuit, and the LVDC filter may also be referred to as a low-voltage filter.

In this specification, a "high voltage" and a "low voltage" indicate relative voltage values, a voltage of the "high voltage" is higher than a voltage of the "low voltage", and the "high voltage" and the "low voltage" do not indicate specific voltage values.

Parallelism: Parallelism defined in this application is not limited to absolute parallelism. A definition of the parallelism may be understood as being substantially parallel. Non-absolute parallelism caused by impact of an assembly tolerance, a design tolerance, structural flatness, and other factors is allowed.

Perpendicularity: Perpendicularity defined in this application is not limited to an absolute perpendicular intersection (an included angle is 90 degrees) relationship. A non-absolute perpendicular intersection relationship caused by impact of an assembly tolerance, a design tolerance, structural flatness, and other factors is allowed. An error within a small angle range is allowed. For example, an intersection relationship within an assembly error range of 80 degrees to 100 degrees may be understood as a relationship of perpendicularity.

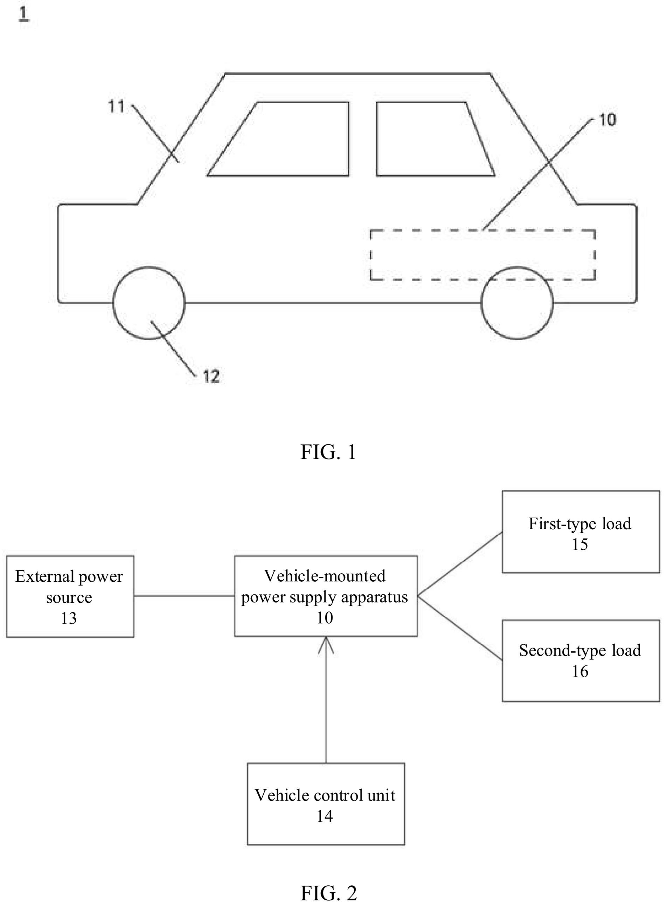

FIG. 1 is a diagram of a structure of a vehicle 1 according to an embodiment of this application. In an implementation, the vehicle 1 includes a vehicle body 11 and wheels 12, and a vehicle-mounted power supply apparatus 10 is mounted on the vehicle body 11. The vehicle-mounted power supply apparatus 10 is configured to supply electric energy to electrical components in the vehicle 1 and drive the wheels 12 to rotate.

The vehicle 1 is a wheeled vehicle that is driven or pulled by a power apparatus and that is used for passengers traveling on a road or for transporting goods and performing special engineering operations. The vehicle 1 includes an electric vehicle (Electric Vehicle, EV for short), a pure electric vehicle (Pure Electric Vehicle /Battery Electric Vehicle, PEV/BEV for short), a hybrid electric vehicle (Hybrid Electric Vehicle, HEV for short), a range extended electric vehicle (Range Extended Electric Vehicle, REEV for short), a plug-in hybrid electric vehicle (Plug-in Hybrid Electric Vehicle, PHEV for short), a new energy vehicle (New Energy Vehicle), and the like. In some implementations, the vehicle 1 includes a passenger vehicle and various special-purpose vehicles with specific functions, such as an engineering rescue vehicle, a sprinkler, a suction-type sewer scavenger, a cement mixer truck, a crane, and a medical vehicle. The vehicle 1 may alternatively be a mobile robot. The vehicle 1 may include three or more wheels 12. This is not limited in this application.

FIG. 2 is a diagram of an application scenario of a vehicle-mounted power supply apparatus 10 according to an embodiment of this application. In an implementation, the vehicle-mounted power supply apparatus 10 is electrically connected to an external power source 13, a vehicle control unit 14, a first-type load 15, and a second-type load 16.

In an implementation, the external power source 13 may be an alternating current power grid, an alternating current charging pile, or an uninterruptible power system (uninterruptible power system, UPS). In this case, the external power source 13 is an alternating current power supply. The vehicle-mounted power supply apparatus 10 is configured to electrically connect to the external power source 13 and receive an alternating current. For example, the vehicle-mounted power supply apparatus 10 converts the received alternating current into a direct current, and the vehicle-mounted power supply apparatus 10 supplies the direct current to supply power to the first-type load 15 and the second-type load 16.

In an implementation, the first-type load 15 is a low-voltage load. For example, the first-type load 15 includes at least one of a low-voltage battery, a vehicle lamp, a wiper, an air conditioner, a speaker, a USB interface, a dashboard, and a control display. For example, the low-voltage battery may also supply power to other first-type loads 15. For example, the second-type load 16 is a battery. When the battery is configured to supply power to a motor in a power system, the battery may also be referred to as a power battery.

The vehicle-mounted power supply apparatus 10 is electrically connected to the vehicle control unit 14, and the vehicle control unit 14 is configured to send a control signal to the vehicle-mounted power supply apparatus 10 to optimize energy distribution of the entire vehicle.

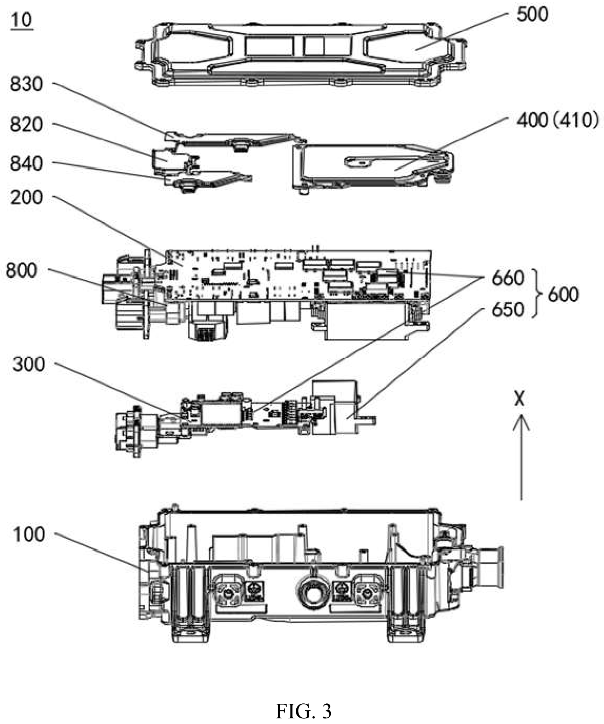

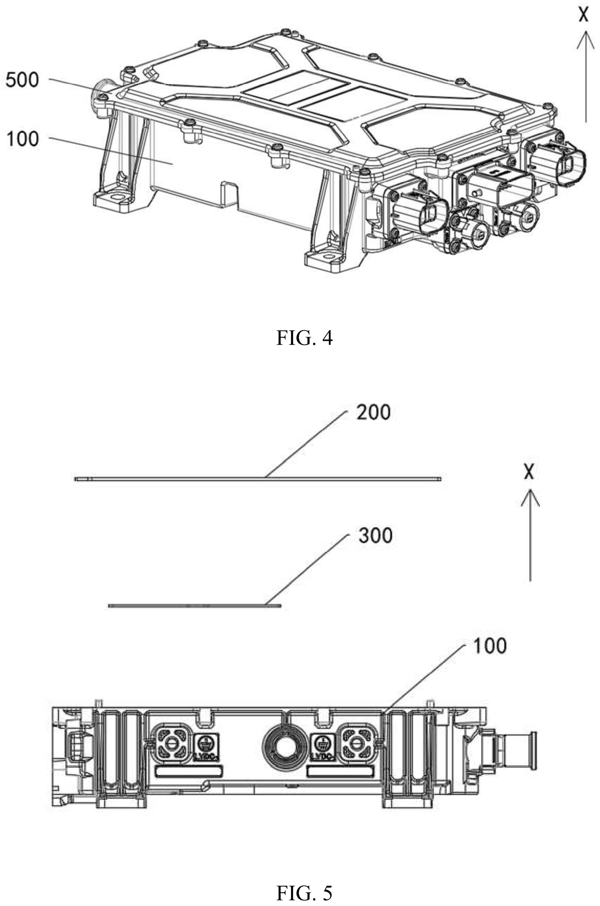

FIG. 3 is an exploded view of a vehicle-mounted power supply apparatus 10 according to an implementation of this application. FIG. 4 is a diagram of a structure of a vehicle-mounted power supply apparatus 10 according to an implementation of this application. In an implementation, the vehicle-mounted power supply apparatus 10 includes a bottom housing 100, a lower-layer PCB board 300, an upper-layer PCB board 200, a power conversion circuit 600, a heat dissipator 400, and a cover 500 (as shown in FIG. 3). The bottom housing 100 and the cover 500 are combined to form an accommodation cavity. The lower-layer PCB board 300, the upper-layer PCB board 200, the heat dissipator 400, and the power conversion circuit 600 are located in the accommodation cavity (as shown in FIG. 3 and FIG. 4). A part of the power conversion circuit 600 is disposed on each of the upper-layer PCB board 200 and the lower-layer PCB board 300 (as shown in FIG. 3). The power conversion circuit 600 is configured to receive an alternating current and output at least two direct currents with different voltages, where the direct currents are used to supply power to a first-type load and a second-type load. A cooling channel is provided in each of the heat dissipator 400 and the bottom housing 100. The cooling channel in each of the heat dissipator 400 and the bottom housing 100 is configured to cool the power conversion circuit 600. For example, the cooling channel may be configured to cool components such as a transformer 650, a capacitor, and an inductor in the power conversion circuit 600. The bottom housing 100 includes a plurality of protrusions, and some of the protrusions are configured to support and fasten the upper-layer PCB board 200, the lower-layer PCB board 300, the heat dissipator 400, and at least one of the components such as the transformer 650, the capacitor, and the inductor in the power conversion circuit 600. Some of the protrusions and a side wall of the bottom housing 100 form at least one shield region. The shield region is configured to shield electrical interference between a component located in the shield region and an external component.

In the vehicle-mounted power supply apparatus 10 provided in this embodiment of this application, a structure, a position relationship, and an interaction relationship of the bottom housing 100, the lower-layer PCB board 300, the upper-layer PCB board 200, the power conversion circuit 600, the heat dissipator 400, and the cover 500 are designed, so that a layout of the lower-layer PCB board 300, the upper-layer PCB board 200, the power conversion circuit 600, and the heat dissipator 400 is more compact, and the vehicle-mounted power supply apparatus 10 is better miniaturized. In this way, components of the vehicle-mounted power supply apparatus 10 are more reliably fastened, electrical connections are more stable, electrical interference is lower, cooling effect is better, and power density is higher.

Further, refer to FIG. 3. In an implementation, the lower-layer PCB board 300, the upper-layer PCB board 200, and the heat dissipator 400 are sequentially stacked and fastened to the bottom housing 100. The power conversion circuit 600 includes a plurality of power switching transistors 660 and a plurality of transformers 650. The upper-layer PCB board 200 and the lower-layer PCB board 300 are configured to carry the plurality of power switching transistors 660. The bottom housing 100 is configured to support the upper-layer PCB board 200, the lower-layer PCB board 300, the heat dissipator 400, and the plurality of transformers 650.

In this implementation, along a height direction X of the vehicle-mounted power supply apparatus 10, the lower-layer PCB board 300, the upper-layer PCB board 200, and the heat dissipator 400 are sequentially stacked, and the heat dissipator 400 is located on a side, away from the lower-layer PCB board 300, of the upper-layer PCB board 200. The heat dissipator 400, the upper-layer PCB board 200, and the lower-layer PCB board 300 are all fastened to the bottom housing 100, so that fastening stability of the heat dissipator 400, the upper-layer PCB board 200, the lower-layer PCB board 300, and the bottom housing 100 is high, and overall structural strength of the vehicle-mounted power supply apparatus 10 is higher.

In this implementation, the lower-layer PCB board 300, the upper-layer PCB board 200, the heat dissipator 400, and the power conversion circuit 600 in the vehicle-mounted power supply apparatus 10 are designed to be directly or indirectly fastened to the bottom housing 100. This helps improve overall structural stability of the vehicle-mounted power supply apparatus 10. When an external environment applies an external force to the vehicle-mounted power supply apparatus 10, the lower-layer PCB board 300, the upper-layer PCB board 200, the heat dissipator 400, and the power conversion circuit 600 are not prone to displacement relative to the bottom housing 100. This helps the vehicle-mounted power supply apparatus 10 operate in a stable state.

The power switching transistor 660 in the power conversion circuit 600 is a power electronic device that can implement a power conversion function, including but not limited to an IGBT (Insulated Gate Bipolar Transistor, insulated gate bipolar transistor), a silicon carbide power transistor, a silicon transistor, a MOS transistor (Metal-Oxide-Semiconductor Field-Effect Transistor, metal-oxide-semiconductor field-effect transistor), a diode, and the like. The transformer 650 in the power conversion circuit 600 is an apparatus that changes an alternating current voltage by using a principle of electromagnetic induction. In this implementation, the power switching transistor 660 and the transformer 650 are used together, so that an alternating current is converted into at least two direct currents after passing through the power conversion circuit 600, to meet power supply requirements of at least two types of loads.

In this implementation, the power conversion circuit 600 includes the plurality of power switching transistors 660 and the plurality of transformers 650 that are configured to implement power conversion. The upper-layer PCB board 200 and the lower-layer PCB board 300 each are configured to carry some of the power switching transistors 660, so that the power conversion circuit 600 is distributed on the upper-layer PCB board 200 and the lower-layer PCB board 300 that are stacked. Compared with an implementation in which the power conversion circuit 600 is distributed on one PCB board, in this implementation, the power conversion circuit 600 is distributed more flexibly, and an area of the vehicle-mounted power supply apparatus 10 on a horizontal plane can be reduced.

In this implementation, the power switching transistors 660 are carried on the upper-layer PCB board 200 and the lower-layer PCB board 300, and the transformers 650 are supported by the bottom housing 100. In this way, the upper-layer PCB board 200, the lower-layer PCB board 300, and the bottom housing 100 each carry a part of the power conversion circuit 600, and components of the power conversion circuit 600 are distributed at different positions in the vehicle-mounted power supply apparatus 10, so that a layout of the power conversion circuit 600 is optimized, and space utilization of the vehicle-mounted power supply apparatus 10 can be improved. This facilitates a miniaturization design of the vehicle-mounted power supply apparatus 10.

Further, refer to FIG. 3. In an implementation, the cover 500 and the bottom housing 100 of the vehicle-mounted power supply apparatus 10 are combined to form an accommodation cavity, and the accommodation cavity is configured to accommodate the lower-layer PCB board 300, the upper-layer PCB board 200, the heat dissipator 400, and the plurality of transformers 650. The lower-layer PCB board 300, the upper-layer PCB board 200, the heat dissipator 400, and the cover 500 are sequentially stacked along the height direction X of the vehicle-mounted power supply apparatus 10.

In this implementation, the accommodation cavity is configured to protect the lower-layer PCB board 300, the upper-layer PCB board 200, the heat dissipator 400, and the plurality of transformers 650 inside from being affected by the external environment. Along the height direction X of the vehicle-mounted power supply apparatus 10, the upper-layer PCB board 200 is disposed closer to the cover 500 than the lower-layer PCB board 300, and the heat dissipator 400 is disposed between the cover 500 and the upper-layer PCB board 200. The heat dissipator 400 may be configured to cool and dissipate heat for power switching transistors 660 of the upper-layer PCB board 200.

In this implementation, the lower-layer PCB board 300, the upper-layer PCB board 200, the heat dissipator 400, and the cover 500 are sequentially stacked, so that these components are arranged more compactly. This helps reduce a size of the vehicle-mounted power supply apparatus 10.

In an implementation, the cover 500 is detachably connected to the bottom housing 100. When an internal component of the vehicle-mounted power supply apparatus 10 needs to be repaired or replaced, the detachable connection relationship helps reduce operation difficulty and costs. For example, the detachable connection may be a screw connection.

In an implementation, along the height direction X of the vehicle-mounted power supply apparatus 10, edges of two opposite end faces of the cover 500 and the bottom housing 100 are detachably connected. In this solution, a position at which the cover 500 is connected to the bottom housing 100 is on a periphery of the accommodation cavity, without occupying internal space of the vehicle-mounted power supply apparatus 10. This facilitates assembly and disassembly between the cover 500 and the bottom housing 100.

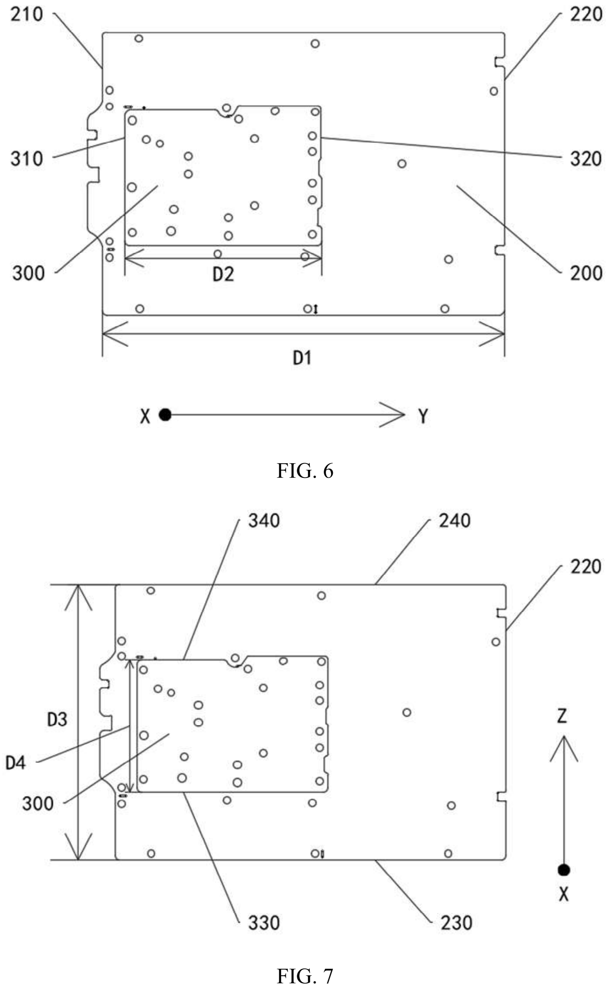

FIG. 5 is a diagram of a structure of an upper-layer PCB board 200 and a lower-layer PCB board 300 according to an implementation of this application. FIG. 6 is a diagram of a structure of an upper-layer PCB board 200 and a lower-layer PCB board 300 according to an implementation of this application. In an implementation, the upper-layer PCB board 200 and the lower-layer PCB board 300 are spaced away (as shown in FIG. 5). An area of a board surface of the upper-layer PCB board 200 is greater than an area of a board surface of the lower-layer PCB board 300 (as shown in FIG. 6). Both the board surface of the upper-layer PCB board 200 and the board surface of the lower-layer PCB board 300 are perpendicular to the height direction X of the vehicle-mounted power supply apparatus 10 (as shown in FIG. 6).

In this implementation, the upper-layer PCB board 200 and the lower-layer PCB board 300 are spaced away along the height direction X of the vehicle-mounted power supply apparatus 10, so that space can be provided for relative arrangement of a power conversion circuit 600 between the upper-layer PCB board 200 and the lower-layer PCB board 300. This helps reduce a size that needs to be occupied for mounting the power conversion circuit 600. The area of the board surface of the upper-layer PCB board 200 is greater than the area of the board surface of the lower-layer PCB board 300, so that a large quantity of power conversion circuits 600 and/or a power conversion circuit 600 with a large size can be mounted on the upper-layer PCB board 200, and mounting space on the board surface of the upper-layer PCB board 200 and the board surface of the lower-layer PCB board 300 is flexibly used. This helps improve space utilization of the vehicle-mounted power supply apparatus 10. The height direction X of the vehicle-mounted power supply apparatus 10 is a direction from the board surface of the lower-layer PCB board 300 to the board surface of the upper-layer PCB board 200. The board surface of the upper-layer PCB board 200 and the board surface of the lower-layer PCB board 300 are arranged in parallel. This helps fasten the upper-layer PCB board 200 and the lower-layer PCB board 300 to the bottom housing 100 by using screws.

Further, refer to FIG. 5. In an implementation, the board surface of the upper-layer PCB board 200 and the board surface of the lower-layer PCB board 300 are arranged in parallel, and the board surface of the upper-layer PCB board 200 and the board surface of the lower-layer PCB board 300 are perpendicular to the height direction X of the vehicle-mounted power supply apparatus 10. In this implementation, the board surface of the upper-layer PCB board 200 and the board surface of the lower-layer PCB board 300 are arranged in parallel, and both are perpendicular to the height direction X of the vehicle-mounted power supply apparatus 10. When the upper-layer PCB board 200 and the lower-layer PCB board 300 are fastened to the bottom housing 100 by using screws or in other manners, a mounting operation is more convenient, and stability of connection between the bottom housing 100 and each of the upper-layer PCB board 200 and the lower-layer PCB board 300 can be improved.

Further, refer to FIG. 6. In an implementation, the upper-layer PCB board 200 includes an upper-layer front side edge 210 and an upper-layer rear side edge 220 that are arranged opposite to each other along a front-rear direction Y of the vehicle-mounted power supply apparatus 10, and the lower-layer PCB board 300 includes a lower-layer front side edge 310 and a lower-layer rear side edge 320 that are arranged opposite to each other along the front-rear direction Y. Along the front-rear direction Y of the vehicle-mounted power supply apparatus 10, the lower-layer front side edge 310 and the lower-layer rear side edge 320 are located between the upper-layer front side edge 210 and the upper-layer rear side edge 220.

In this implementation, the upper-layer front side edge 210 is a front side edge of the upper-layer PCB board 200, the upper-layer rear side edge 220 is a rear side edge of the upper-layer PCB board 200, the lower-layer front side edge 310 is a front side edge of the lower-layer PCB board 300, and the lower-layer rear side edge 320 is a rear side edge of the lower-layer PCB board 300. To distinguish the front side edge and the rear side edge of the upper-layer PCB board 200 from the front side edge and the rear side edge of the lower-layer PCB board 300, the side edges are respectively named as the upper-layer front side edge 210, the upper-layer rear side edge 220, the lower-layer front side edge 310, and the lower-layer rear side edge 320.

In this implementation, along the front-rear direction Y of the vehicle-mounted power supply apparatus 10, the upper-layer front side edge 210 and the upper-layer rear side edge 220 of the upper-layer PCB board 200 are located on an outer side of the lower-layer front side edge 310 and an outer side of the lower-layer rear side edge 320 of the lower-layer PCB board 300 respectively. The outer side of the lower-layer front side edge 310 is a side, away from the lower-layer rear side edge 320 along the front-rear direction Y, of the lower-layer front side edge 310. The outer side of the lower-layer rear side edge 320 is a side, away from the lower-layer front side edge 310 along the front-rear direction Y, of the lower-layer rear side edge 320. A dimension value of a spacing between the upper-layer front side edge 210 and the upper-layer rear side edge 220 along the front-rear direction Y of the vehicle-mounted power supply apparatus 10 is D1. A dimension value of a spacing between the lower-layer front side edge 310 and the lower-layer rear side edge 320 along the front-rear direction Y of the vehicle-mounted power supply apparatus 10 is D2. D1 is set to be greater than D2, so that an orthographic projection of the upper-layer PCB board 200 on the lower-layer PCB board 300 can cover the lower-layer PCB board 300 along the front-rear direction Y. In this way, a component with a large size can be mounted on the upper-layer PCB board 200, and the component with a large size can also be fastened to the bottom housing 100. This improves overall stability of the vehicle-mounted power supply apparatus 10.

FIG. 7 is a diagram of a structure of an upper-layer PCB board 200 and a lower-layer PCB board 300 according to an implementation of this application. In an implementation, the upper-layer PCB board 200 includes an upper-layer left side edge 230 and an upper-layer right side edge 240 that are arranged opposite to each other along a left-right direction Z of the vehicle-mounted power supply apparatus 10, and the lower-layer PCB board 300 includes a lower-layer left side edge 330 and a lower-layer right side edge 340 that are arranged opposite to each other along a front-rear direction Y. Along the left-right direction Z of the vehicle-mounted power supply apparatus 10, the lower-layer left side edge 330 and the lower-layer right side edge 340 are located between the upper-layer left side edge 230 and the upper-layer right side edge 240.

In this implementation, the upper-layer left side edge 230 is a left side edge of the upper-layer PCB board 200, the upper-layer right side edge 240 is a right side edge of the upper-layer PCB board 200, the lower-layer left side edge 330 is a left side edge of the lower-layer PCB board 300, and the lower-layer right side edge 340 is a right side edge of the lower-layer PCB board 300. To distinguish the left side edge and the right side edge of the upper-layer PCB board 200 from the left side edge and the right side edge of the lower-layer PCB board 300, the side edges are respectively named as the upper-layer left side edge 340, the upper-layer right side edge 240, the lower-layer left side edge 330, and the lower-layer right side edge 340.

In this implementation, along the left-right direction Z of the vehicle-mounted power supply apparatus 10, the upper-layer left side edge 230 and the upper-layer right side edge 240 of the upper-layer PCB board 200 are located on an outer side of the lower-layer left side edge 330 and an outer side of the lower-layer right side edge 340 of the lower-layer PCB board 300 respectively. The outer side of the lower-layer left side edge 330 is a side, away from the lower-layer right side edge 340 along the left-right direction Z, of the lower-layer left side edge 330. The outer side of the lower-layer right side edge 340 is a side, away from the lower-layer left side edge 330 along the left-right direction Z, of the lower-layer right side edge 340. A dimension value of a spacing between the upper-layer left side edge 230 and the upper-layer right side edge 240 along the left-right direction Z of the vehicle-mounted power supply apparatus 10 is D3. A dimension value of a spacing between the lower-layer left side edge 330 and the lower-layer right side edge 340 along the left-right direction Z of the vehicle-mounted power supply apparatus 10 is D4. D3 is set to be greater than D4, so that an orthographic projection of the upper-layer PCB board 200 on the lower-layer PCB board 300 can cover the lower-layer PCB board 300 along the left-right direction Z. In this way, a component with a large size can be mounted on the upper-layer PCB board 200, and the component with a large size can also be fastened to the bottom housing 100. This improves overall stability of the vehicle-mounted power supply apparatus 10.

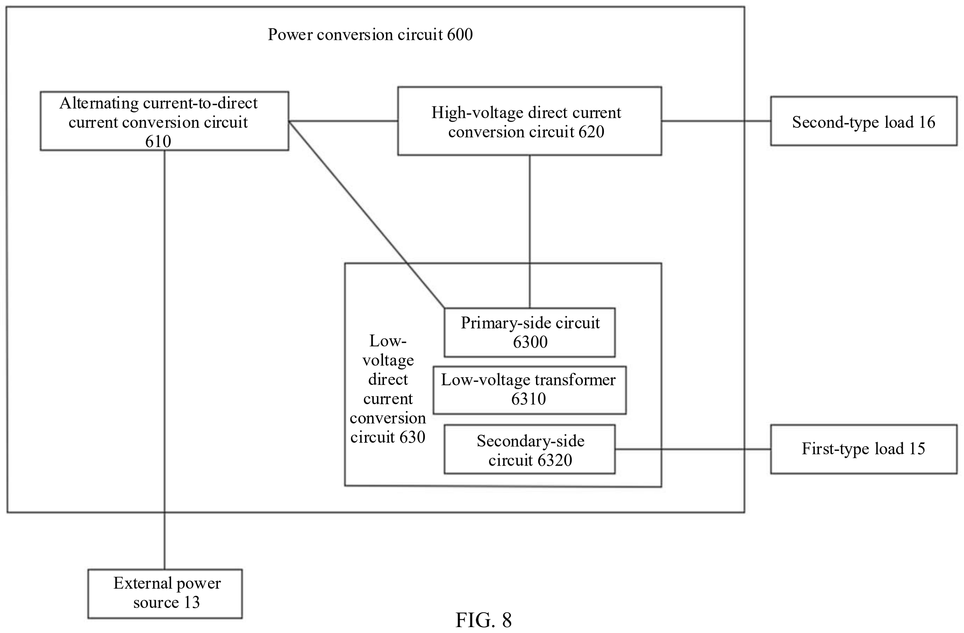

FIG. 8 is a diagram of an application scenario of a power conversion circuit 600 according to an implementation of this application. In an implementation, the power conversion circuit 600 includes an alternating current-to-direct current conversion circuit 610, a low-voltage direct current conversion circuit 630, and a high-voltage direct current conversion circuit 620. The alternating current-to-direct current conversion circuit 610 is configured to receive an alternating current and supply power to at least one of the high-voltage direct current conversion circuit 620 or the low-voltage direct current conversion circuit 630. The low-voltage direct current conversion circuit 630 is configured to receive power supply from at least one of the alternating current-to-direct current conversion circuit 610 or the high-voltage direct current conversion circuit 620 and output a first direct current. The high-voltage direct current conversion circuit 620 is configured to receive power supply from the alternating current-to-direct current conversion circuit 610 and output a second direct current. A voltage of the second direct current is higher than a voltage of the first direct current.

In this implementation, an external power source 13 inputs an alternating current to the power conversion circuit 600, and the alternating current is transmitted to at least one of the low-voltage direct current conversion circuit 630 and the high-voltage direct current conversion circuit 620 after passing through the alternating current-to-direct current conversion circuit 610. After receiving the alternating current, the high-voltage direct current conversion circuit 620 converts the alternating current into the second direct current to supply power to a second-type load 16. Alternatively, the high-voltage direct current conversion circuit 620 converts the alternating current into the second direct current to supply power to the low-voltage direct current conversion circuit 630. After receiving the alternating current, the low-voltage direct current conversion circuit 630 converts the alternating current into the first direct current to supply power to a first-type load. Alternatively, the low-voltage direct current conversion circuit 630 receives the second direct current and converts the second direct current into the first direct current to supply power to the first-type load. The voltage of the second direct current is higher than the voltage of the first direct current. After the alternating current supplied by the external power source 13 passes through the power conversion circuit 600, alternating current-to-direct current conversion occurs, and a voltage value changes, so that the vehicle-mounted power supply apparatus 10 can supply power to different types of vehicle-mounted loads. This improves adaptability of the vehicle-mounted power supply apparatus 10.

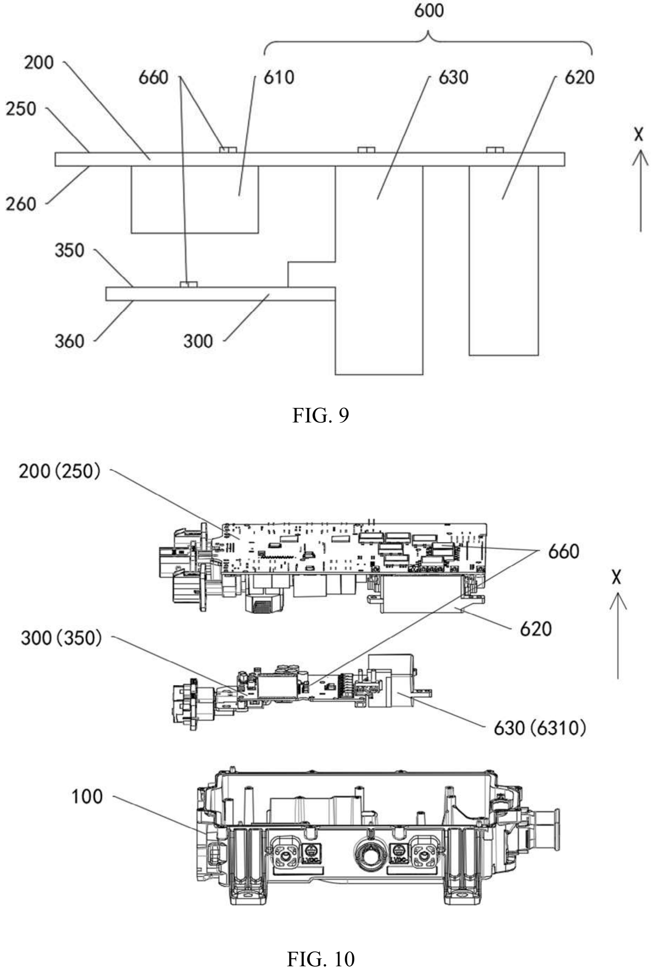

In an implementation, the voltage of the first direct current is 12 V, the first-type load is a low-voltage load, the second-type load is a high-voltage load, and the voltage of the second direct current ranges from 200 V to 750 V. In some other implementations, specific voltage values of the first direct current and the second direct current may be set according to a requirement, but the voltage of the second direct current needs to be higher than the voltage of the first direct current. FIG. 9 is a diagram of a structure of an upper-layer PCB board 200, a lower-layer PCB board 300, and a power conversion circuit 600 according to an implementation of this application. In an implementation, an alternating current-to-direct current conversion circuit 610, a high-voltage direct current conversion circuit 620, and a part of a low-voltage direct current conversion circuit 630 are disposed on the upper-layer PCB board 200, and a part of the low-voltage direct current conversion circuit 630 is disposed on the lower-layer PCB board 300.

In this implementation, the alternating current-to-direct current conversion circuit 610 and the high-voltage direct current conversion circuit 620 are fastened to the upper-layer PCB board 200, and the low-voltage direct current conversion circuit 630 is fastened to both the upper-layer PCB board 200 and the lower-layer PCB board 300. This helps arrange components on the upper-layer PCB board 200 and the lower-layer PCB board 300 based on different functions of the alternating current-to-direct current conversion circuit 610, the high-voltage direct current conversion circuit 620, and the low-voltage direct current conversion circuit 630, so that a layout of the power conversion circuit 600 is more appropriate. In an implementation, a part of the alternating current-to-direct current conversion circuit 610, a part of the high-voltage direct current conversion circuit 620, and the part of the low-voltage direct current conversion circuit 630 that are disposed on the upper-layer PCB board 200 are located on peripheries of at least two side edges of the lower-layer PCB board 300.

It should be noted that the power conversion circuit 600 shown in FIG. 9 only schematically indicates arrangement positions of different components, but does not indicate specific structures, sizes, or position relationships of the components.

Refer to FIG. 9 and FIG. 10. FIG. 10 is a diagram of a structure of a vehicle-mounted power supply apparatus 10 according to an implementation of this application. In an implementation, a lower surface 260 of the upper-layer PCB board 200 and an upper surface 350 of the lower-layer PCB board 300 are arranged opposite to each other (as shown in FIG. 9). An upper surface 250 of the upper-layer PCB board 200 is configured to carry a plurality of power switching transistors 660 of the alternating current-to-direct current conversion circuit 610, a plurality of power switching transistors 660 of the high-voltage direct current conversion circuit 620, and a plurality of power switching transistors 660 of a primary-side circuit (as shown in FIG. 9 and FIG. 10). The upper surface 350 of the lower-layer PCB board 300 is configured to carry a plurality of power switching transistors 660 of a secondary-side circuit (as shown in FIG. 9 and FIG. 10).

In this implementation, the lower surface 260 of the upper-layer PCB board 200 and the upper surface 350 of the lower-layer PCB board 300 are arranged opposite to each other along a height direction X of the vehicle-mounted power supply apparatus 10. The lower surface 260 of the upper-layer PCB board 200 is used for mounting a large quantity of components. Therefore, some power switching transistors 660 are disposed on the upper surface 250 of the upper-layer PCB board 200. This facilitates an overall layout of the alternating current-to-direct current conversion circuit 610, the high-voltage direct current conversion circuit 620, and the low-voltage direct current conversion circuit 630 on the upper-layer PCB board 200. In an implementation, some power switching transistors 660 are located between the upper surface 250 of the upper-layer PCB board 200 and a heat dissipator 400, so that the heat dissipator 400 can effectively cool and dissipate heat for the power switching transistors 660. This ensures that operation efficiency of the power switching transistors 660 is not affected by temperature.

It should be noted that the power switching transistors 660 shown in FIG. 9 only schematically indicate arrangement positions of the power switching transistors 660, but do not indicate a specific structure, size, or position relationship.

Refer to FIG. 8 and FIG. 10. In an implementation, the low-voltage direct current conversion circuit 630 includes a low-voltage transformer 6310, a primary-side circuit 6300, and a secondary-side circuit 6320. The primary-side circuit 6300 is configured to receive power supply from at least one of the alternating current-to-direct current conversion circuit 610 or the high-voltage direct current conversion circuit 620. The secondary-side circuit 6320 is configured to output the first direct current. The upper-layer PCB board 200 is configured to carry a plurality of power switching transistors 660 of the primary-side circuit 6300 in the low-voltage direct current conversion circuit 630. The lower-layer PCB board 300 is configured to carry a plurality of power switching transistors 660 of the secondary-side circuit 6320 in the low-voltage direct current conversion circuit 630. The bottom housing 100 is configured to fasten the low-voltage transformer 6310 of the low-voltage direct current conversion circuit 630.

In this implementation, the primary-side circuit 6300 is electrically connected to a part of the power conversion circuit 600 on the upper-layer PCB board 200, and the primary-side circuit 6300 converts a direct current into a square wave that alternates between a positive value and a negative value. After the square wave passes through the low-voltage transformer 6310, a voltage of the square wave is reduced. Finally, the secondary-side circuit 6320 converts a transformed square wave into the first direct current. For example, the voltage of the direct current is 100 V, the voltage of the square wave that alternates between a positive value and a negative value ranges from +100 V to -100 V, a voltage of the transformed square wave ranges from +12 V to -12 V, and a voltage of the second direct current is 12 V. In this solution, the primary-side circuit 6300, the low-voltage transformer 6310, and the secondary-side circuit 6320 are disposed in the low-voltage direct current conversion circuit 630, so that the vehicle-mounted power supply apparatus 10 can convert the direct current into the second direct current and supply power to a battery.

In this implementation, the upper-layer PCB board 200 and the lower-layer PCB board 300 are configured to carry the plurality of power switching transistors 660 of the primary-side circuit 6300 and the plurality of power switching transistors 660 of the secondary-side circuit 6320 respectively, so that the low-voltage direct current conversion circuit 630 is distributed on the upper-layer PCB board 200 and the lower-layer PCB board 300. In this way, components are distributed more flexibly compared with an implementation in which all power switching transistors 660 of the low-voltage direct current conversion circuit 630 are carried on one PCB board.

In this implementation, the low-voltage transformer 6310 is fastened to both the upper-layer PCB board 200 and the lower-layer PCB board 300, so that other components electrically connected to the low-voltage transformer 6310 can be respectively disposed on the upper-layer PCB board 200 and the lower-layer PCB board 300. This prevents all components in the power conversion circuit 600 from being centrally mounted on the upper-layer PCB board 200 or the lower-layer PCB board 300, so that areas of mounting surfaces of the upper-layer PCB board 200 and the lower-layer PCB board 300 can be effectively reduced. This facilitates a miniaturization design of the vehicle-mounted power supply apparatus 10.

In this implementation, the low-voltage transformer 6310 is also fastened to the bottom housing 100, so that the low-voltage transformer 6310, the lower-layer PCB board 300, the upper-layer PCB board 200, and the heat dissipator 400 are all fastened to the bottom housing 100. In this way, overall structural strength of these components in the vehicle-mounted power supply apparatus 10 is higher.

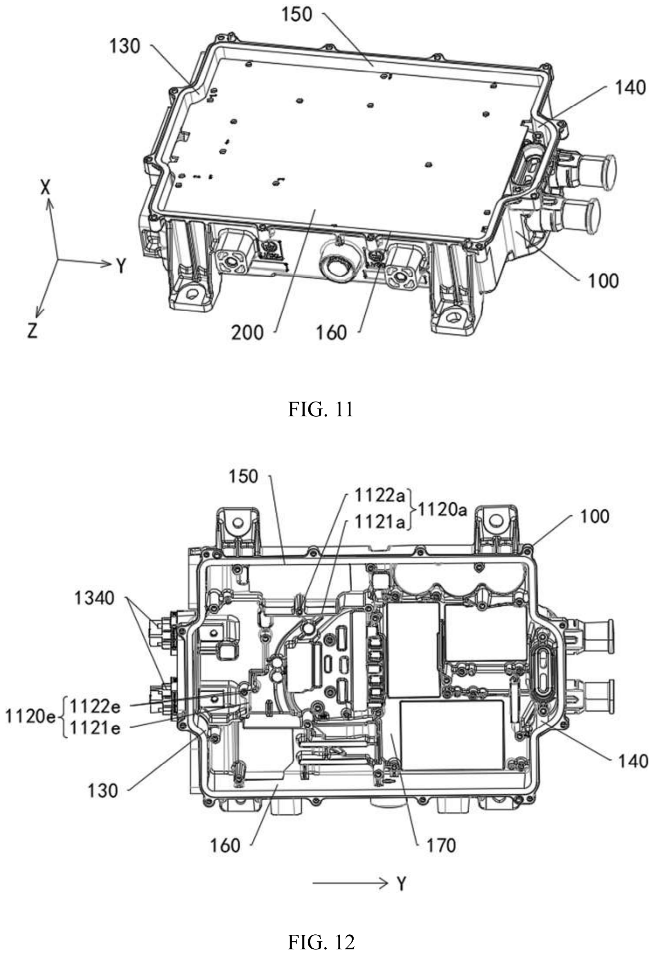

FIG. 11 is a diagram of a structure of a bottom housing 100 and an upper-layer PCB board 200 according to an implementation of this application. FIG. 12 is a diagram of a structure of a bottom housing 100 according to an implementation of this application. In an implementation, the bottom housing 100 includes a base plate 170, a front side wall 130, a rear side wall 140, a left side wall 150, and a right side wall 160 (as shown in FIG. 11 and FIG. 12). The front side wall 130 and the rear side wall 140 are arranged opposite to each other (as shown in FIG. 12). The left side wall 150 and the right side wall 160 are arranged opposite to each other (as shown in FIG. 11 and FIG. 12). The base plate 170, the front side wall 130, the rear side wall 140, the left side wall 150, and the right side wall 160 form a groove structure (as shown in FIG. 11). A height of any one of the front side wall 130, the rear side wall 140, the left side wall 150, and the right side wall 160 is greater than a height of the upper-layer PCB board 200 along the height direction X of the vehicle-mounted power supply apparatus 10 (as shown in FIG. 11).

In this implementation, the bottom housing 100 includes four side walls that are sequentially connected. The four side walls are the front side wall 130, the rear side wall 140, the left side wall 150, and the right side wall 160. The front side wall 130 and the rear side wall 140 are arranged along the front-rear direction Y of the vehicle-mounted power supply apparatus 10, where the front-rear direction Y of the vehicle-mounted power supply apparatus 10 is a direction from the front side wall 130 to the rear side wall 140. The left side wall 150 and the right side wall 160 are arranged along the left-right direction Z of the vehicle-mounted power supply apparatus 10, where the left-right direction Z of the vehicle-mounted power supply apparatus 10 is a direction from the left side wall 150 to the right side wall 160. The base plate 170 and the cover 500 are arranged along the height direction X of the vehicle-mounted power supply apparatus 10, where the height direction X of the vehicle-mounted power supply apparatus 10 is a direction from the base plate 170 to the cover 500. The front-rear direction Y and the left-right direction Z of the vehicle-mounted power supply apparatus 10 perpendicularly intersect each other, and both perpendicularly intersect the height direction X.

It should be noted that, in this application, "front", "rear", "left", and "right" indicate a relative relationship. When a manner of placing the vehicle-mounted power supply apparatus 10 is changed, the front-rear direction Y may alternatively be the left-right direction Z, and the left-right direction Z may alternatively be the front-rear direction Y. In an implementation, the left side wall and the right side wall may be interchanged with each other. In an implementation, the front side wall and the rear side wall may be interchanged with each other.

In this implementation, the height of the upper-layer PCB board 200 is a distance between the upper-layer PCB board 200 and the base plate 170, and a height of any side wall in the bottom housing 100 is greater than the height of the upper-layer PCB board 200, so that the upper-layer PCB board 200 is located in the bottom housing 100. In this way, space is available above the upper-layer PCB board 200 to accommodate the heat dissipator 400 or a plurality of power switching transistors 660 on an upper surface of the upper-layer PCB board 200.

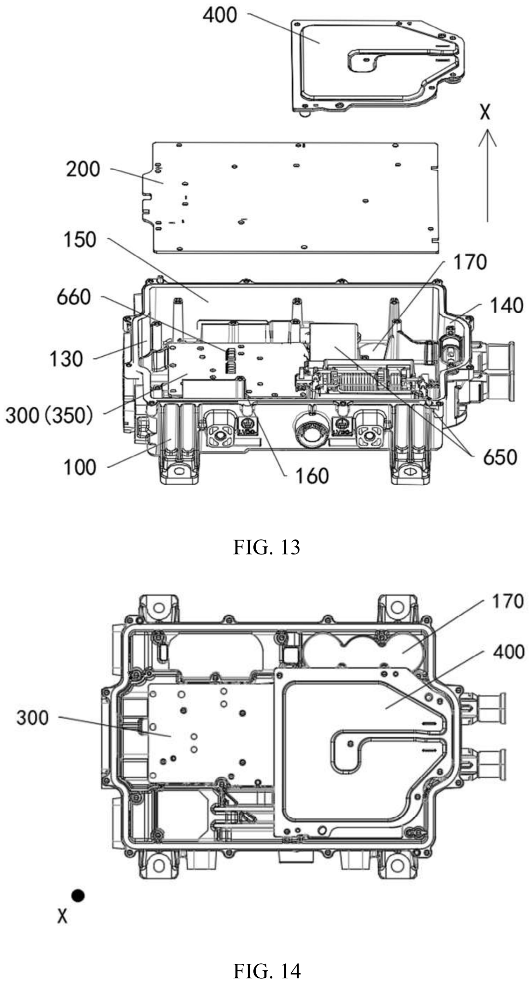

FIG. 13 is a partial exploded view of a vehicle-mounted power supply apparatus 10 according to an implementation of this application. FIG. 14 is a diagram of a partial structure of a vehicle-mounted power supply apparatus 10 according to an implementation of this application. In an implementation, a lower-layer PCB board 300 and a plurality of transformers 650 are tiled above a base plate 170 (as shown in FIG. 13), an upper-layer PCB board 200 is stacked above the lower-layer PCB board 300 and the plurality of transformers 650 (as shown in FIG. 13), a heat dissipator 400 is stacked above the upper-layer PCB board 200 (as shown in FIG. 13), and an orthographic projection of the lower-layer PCB board 300 on the base plate 170 and an orthographic projection of the heat dissipator 400 on the base plate 170 are staggered (as shown in FIG. 14).

In this implementation, that the lower-layer PCB board 300 and the plurality of transformers 650 are tiled above the base plate 170 means that orthographic projections of the lower-layer PCB board 300 and the plurality of transformers 650 on the base plate 170 do not overlap. In an implementation, the lower-layer PCB board 300 and the plurality of transformers 650 may be arranged along a left-right direction Z or a front-rear direction Y of the vehicle-mounted power supply apparatus 10. In this tiled arrangement mode, space above the base plate 170 can be fully utilized, and the lower-layer PCB board 300 and the plurality of transformers 650 are distributed in a bottom housing 100 more compactly. This facilitates miniaturization of the vehicle-mounted power supply apparatus 10.

In this implementation, the upper-layer PCB board 200 is stacked above the lower-layer PCB board 300 and the plurality of transformers 650, so that the upper-layer PCB board 200 covers the lower-layer PCB board 300 and the plurality of transformers 650. In addition, this helps electrically connect the transformers 650 to a lower surface 260 of the upper-layer PCB board 200 in a plug-connected manner.

In an implementation, an area of a board surface of the upper-layer PCB board 200 is greater than an area of a board surface of the lower-layer PCB board 300, so that the lower-layer PCB board 300 and the plurality of transformers 650 can be tiled between the upper-layer PCB board 200 and the base plate 170.

In an implementation, the plurality of transformers 650 include an LLC transformer 6200 of a high-voltage direct current conversion circuit 620 and a low-voltage transformer 6310 of a low-voltage direct current conversion circuit 630.

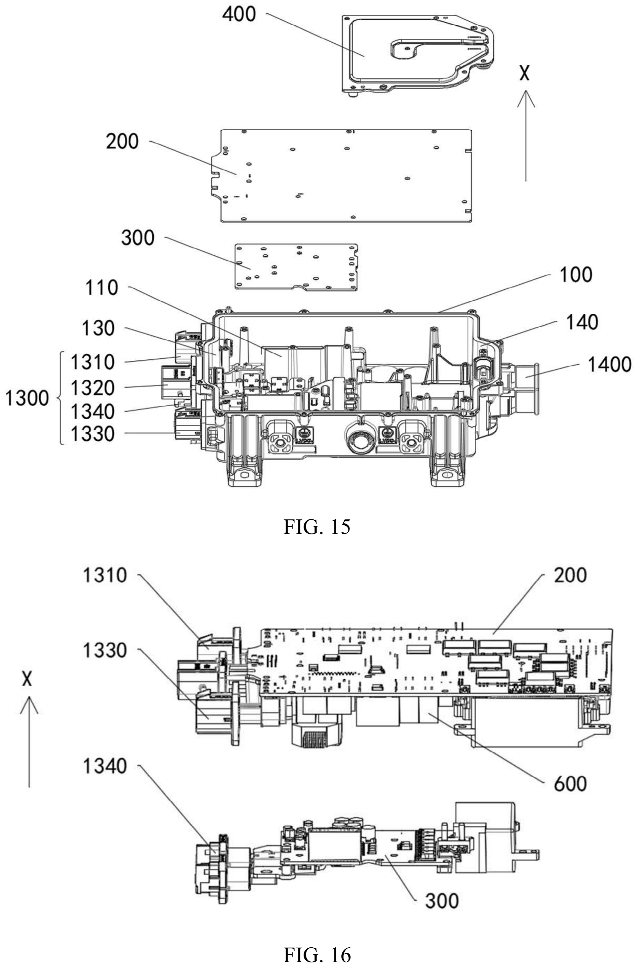

In this implementation, the plurality of transformers 650 and the lower-layer PCB board 300 are tiled, and the orthographic projection of the lower-layer PCB board 300 on the base plate 170 and the orthographic projection of the heat dissipator 400 on the base plate 170 are staggered, so that the heat dissipator 400 can be better stacked with the plurality of transformers 650 along a height direction X. This helps improve heat dissipation effect of the heat dissipator 400 for the plurality of transformers 650, and further helps improve heat dissipation effect for the vehicle-mounted power supply apparatus 10 and increase power of the vehicle-mounted power supply apparatus 10. FIG. 15 is a partial exploded view of a vehicle-mounted power supply apparatus 10 according to an implementation of this application. In an implementation, a front side wall 130 includes a plurality of electrical interfaces 1300, and a rear side wall 140 includes a cooling channel interface 1400. A lower-layer PCB board 300 is closer to the front side wall 130 than a heat dissipator 400. The lower-layer PCB board 300 and an upper-layer PCB board 200 are configured to electrically connect to at least one of the plurality of electrical interfaces 1300. A heat dissipator 400 is closer to the rear side wall 140 than the lower-layer PCB board 300. The heat dissipator 400 is configured to connect to the cooling channel interface 1400.

In an implementation, the plurality of electrical interfaces 1300 include two first direct current interfaces 1340, a second direct current interface 1330, a power interface 1310, and a control signal interface 1320. The first direct current interface 1340 is configured to output a first direct current. The second direct current interface 1330 is configured to output a second direct current. The power interface 1310 is configured to input an alternating current. The control signal interface 1320 is configured to transmit a signal.

In this implementation, the plurality of electrical interfaces 1300 are disposed on the front side wall 130, and the cooling channel interface 1400 is disposed on the rear side wall 140, so that the electrical interfaces 1300 and the cooling channel interface 1400 are isolated in physical space. This prevents a coolant leaking from the cooling channel interface 1400 from affecting electrical performance of the electrical interfaces 1300, so that the vehicle-mounted power supply apparatus 10 is safer.

In this implementation, the electrical interfaces 1300 are disposed on the front side wall 130, a secondary-side circuit 6320 of a low-voltage direct current conversion circuit 630 is located on the lower-layer PCB board 300, and the lower-layer PCB board 300 is disposed close to the front side wall 130 along a front-rear direction Y of the vehicle-mounted power supply apparatus 10. This helps transmit the first direct current output by the secondary-side circuit 6320 of the low-voltage direct current conversion circuit 630 to a first-type load through the electrical interface 1300, and shorten a distance between an output end of the secondary-side circuit 6320 of the low-voltage direct current conversion circuit 630 and the electrical interface 1300, so that a layout of the vehicle-mounted power supply apparatus 10 is more appropriate.

In this implementation, the cooling channel interface 1400 is disposed on the rear side wall 140, and the heat dissipator 400 is closer to the rear side wall 140 than the lower-layer PCB board 300, so that a connection distance between the heat dissipator 400 and the cooling channel interface 1400 is shorter. This better helps ensure sealing between the heat dissipator 400 and the cooling channel interface 1400. In addition, the lower-layer PCB board 300 is farther away from the cooling channel interface 1400 of the rear side wall 140, so that the lower-layer PCB board 300 can be prevented from being damaged by a coolant leaking from a cooling channel.

Refer to FIG. 3 and FIG. 16. In an implementation, the power conversion circuit 600 is configured to receive an external power source 13 through a power interface 1310, and is configured to output a first direct current through a first direct current interface 1340 and output a second direct current through a second direct current interface 1330. A voltage of the second direct current is higher than a voltage of the first direct current. The lower-layer PCB board 300 is configured to electrically connect to the first direct current interface 1340 (as shown in FIG. 16). The upper-layer PCB board 200 is configured to electrically connect to the second direct current interface 1330 and the power interface 1310 (as shown in FIG. 16).

In this implementation, the power conversion circuit 600 performs functions of alternating current-to-direct current conversion and voltage conversion. The power conversion circuit 600 converts the alternating current input by the external power source 13 through the power interface 1310 into the first direct current and the second direct current. The second direct current is output, through the second direct current interface 1330, by a part of the power conversion circuit 600 that is located on the upper-layer PCB board 200. The first direct current is output, through the first direct current interface 1340, by a part of the power conversion circuit 600 that is located on the lower-layer PCB board 300. The voltage of the second direct current is higher than the voltage of the first direct current, so that the vehicle-mounted power supply apparatus 10 can meet power requirements of different loads.

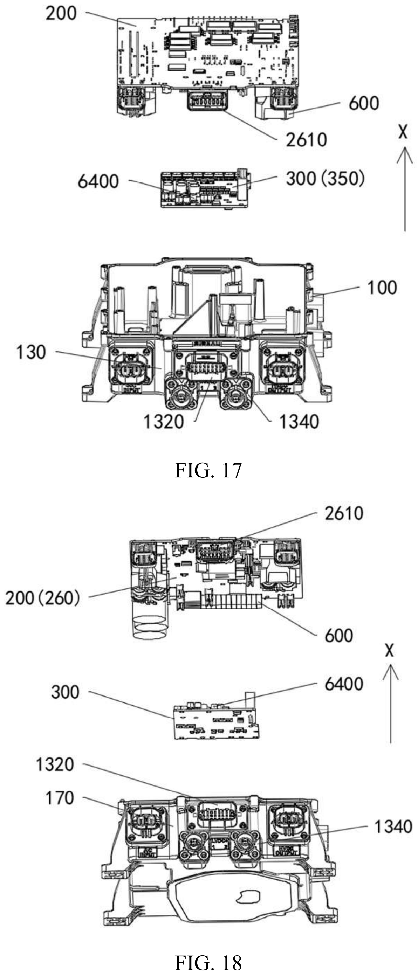

In this implementation, the upper-layer PCB board 200 and the lower-layer PCB board 300 that are stacked are respectively electrically connected to different interfaces, so that electrical interfaces are arranged more flexibly and electrical isolation between the electrical interfaces is higher and safer compared with an implementation in which these different interfaces are electrically connected to one PCB board. In addition, the upper-layer PCB board 200 and the lower-layer PCB board 300 are respectively configured to carry components with different functions, so that the power conversion circuit 600 is properly arranged on the upper-layer PCB board 200 and the lower-layer PCB board 300. This facilitates a miniaturization design of the vehicle-mounted power supply apparatus 10 and therefore optimizes an overall layout of a vehicle. FIG. 17 is a partial exploded view of a vehicle-mounted power supply apparatus 10 according to an implementation of this application. FIG. 18 is a partial exploded view of a vehicle-mounted power supply apparatus 10 according to an implementation of this application. In an implementation, a front side wall 130 includes a first direct current interface 1340 and a control signal interface 1320. A power conversion circuit 600 outputs a first direct current through the first direct current interface 1340 and receives a control signal through the control signal interface 1320. A lower surface 260 of an upper-layer PCB board 200 includes a control signal connector 2610. The control signal connector 2610 is configured to electrically connect the control signal interface 1320 to the upper-layer PCB board 200. An upper surface 350 of a lower-layer PCB board 300 includes at least a part of a low-voltage filter circuit 6400. The low-voltage filter circuit 6400 is configured to electrically connect the first direct current interface 1340 to the lower-layer PCB board 300.

In this implementation, the control signal connector 2610 is disposed on the lower surface 260 of the upper-layer PCB board 200, and the part of the low-voltage filter circuit 6400 is disposed on the upper surface 350 of the lower-layer PCB board 300, so that space between the upper-layer PCB board 200 and the lower-layer PCB board 300 can be fully utilized.

In an implementation, the low-voltage filter circuit 6400 includes a capacitor, an inductor, and a copper bar. The capacitor may be disposed on the upper surface 350 of the lower-layer PCB board 300, and the inductor and the copper bar may be disposed on the lower surface 360 of the lower-layer PCB board 300. In another implementation, another arrangement may alternatively be used according to an actual requirement.

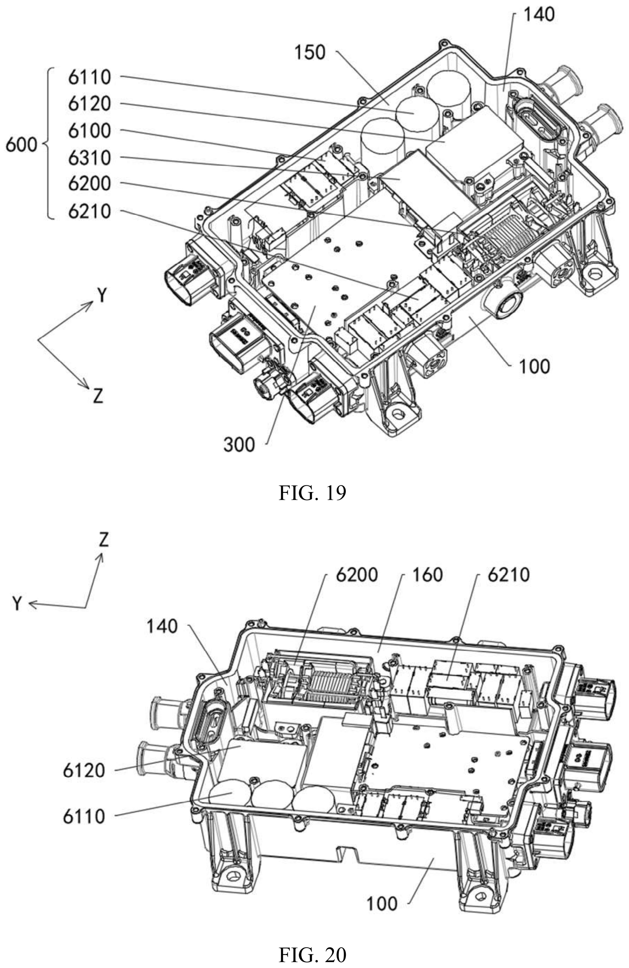

FIG. 19 is a diagram of a partial structure of a vehicle-mounted power supply apparatus 10 according to an implementation of this application. FIG. 20 is a diagram of a partial structure of a vehicle-mounted power supply apparatus 10 according to an implementation of this application. In an implementation, a power conversion circuit 600 includes an AC filter 6100, a PFC capacitor 6110, a PFC inductor 6120, a low-voltage transformer 6310, an LLC transformer 6200, and an HVDC filter 6210 (as shown in FIG. 19). The PFC capacitor 6110, the PFC inductor 6120, and the LLC transformer 6200 are adjacently arranged close to a rear side wall 140 of the vehicle-mounted power supply apparatus 10 (as shown in FIG. 19). The PFC capacitor 6110 and the AC filter 6100 are adjacently arranged close to a right side wall 160 of the vehicle-mounted power supply apparatus 10 (as shown in FIG. 19). The HVDC filter 6210 and the LLC transformer 6200 are adjacently arranged close to a left side wall 150 of the vehicle-mounted power supply apparatus 10 (as shown in FIG. 20).

In this implementation, components in the power conversion circuit 600 are disposed close to at least one side wall of the vehicle-mounted power supply apparatus 10, so that other components can be disposed in regions left empty between the front side wall 130 and the right side wall 160 and between the left side wall 150 and the right side wall 160. This improves utilization of internal space of the vehicle-mounted power supply apparatus 10.

Further, refer to FIG. 19. In an implementation, a power conversion circuit 600 includes an AC filter 6100, a PFC capacitor 6110, a PFC inductor 6120, an HVDC filter 6210, an LLC transformer 6200, and a low-voltage transformer 6310, and the AC filter 6100, the PFC capacitor 6110, the PFC inductor 6120, the HVDC filter 6210, the LLC transformer 6200, the low-voltage transformer 6310, and a lower-layer PCB board 300 are tiled in a bottom housing 100.

The AC filter 6100 is a filter in an alternating current-to-direct current conversion circuit 610, and the AC filter 6100 may also be referred to as an alternating current filter. The HVDC filter 6210 is a filter in a high-voltage direct current conversion circuit 620, and the HVDC filter 6210 may also be referred to as a high-voltage direct current filter.

The PFC capacitor 6110 is a capacitor in the alternating current-to-direct current conversion circuit 610, and the PFC inductor 6120 is an inductor in the alternating current-to-direct current conversion circuit 610.

The LLC transformer 6200 and the low-voltage transformer 6310 are two transformers in the power conversion circuit 600. The LLC transformer 6200 is a transformer in the high-voltage direct current conversion circuit 620, and may also be referred to as a high-voltage transformer. The low-voltage transformer 6310 is a transformer in a low-voltage direct current conversion circuit 630.

In this implementation, the AC filter 6100, the PFC capacitor 6110, the PFC inductor 6120, the HVDC filter 6210, the LLC transformer 6200, and the low-voltage transformer 6310 are components with large sizes and heights in the vehicle-mounted power supply apparatus 10. These components are tiled and are disposed close to the bottom housing 100, so that a size occupied by the power conversion circuit 600 along a height direction X is small. This facilitates miniaturization of the vehicle-mounted power supply apparatus 10, and can simplify a mounting process of the power conversion circuit 600. The height is a size along the height direction X of the vehicle-mounted power supply apparatus 10.

In an implementation, the AC filter 6100, the PFC capacitor 6110, the PFC inductor 6120, the HVDC filter 6210, the LLC transformer 6200, and the low-voltage transformer 6310 are disposed around peripheries of side edges of the lower-layer PCB board 300, and these components are arranged close to each other. This can improve utilization of internal space of the vehicle-mounted power supply apparatus 10.

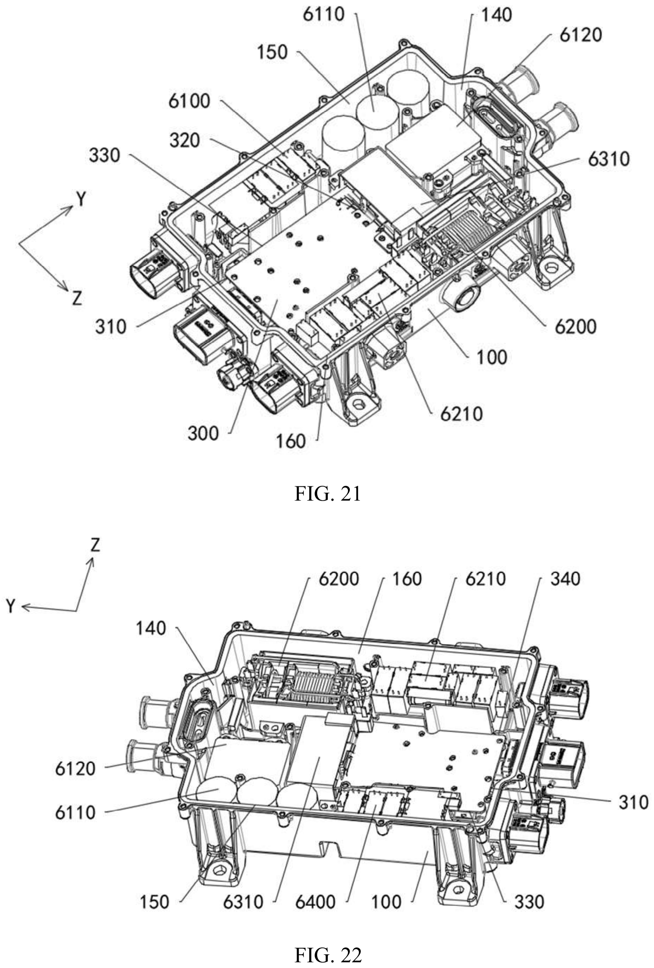

FIG. 21 is a diagram of a structure of a bottom housing 100 and a power conversion circuit 600 according to an implementation of this application. FIG. 22 is a diagram of a structure of a bottom housing 100 and a power conversion circuit 600 according to an implementation of this application. In an implementation, a base plate 170, a front side wall 130, a rear side wall 140, a left side wall 150, and a right side wall 160 of the bottom housing 100 form a groove structure (as shown in FIG. 21 and FIG. 22), and the groove structure is configured to carry an AC filter 6100, an HVDC filter 6210, a PFC capacitor 6110, a PFC inductor 6120, and an LLC transformer 6200. The PFC capacitor 6110, the PFC inductor 6120, and the LLC transformer 6200 are sequentially tiled close to the rear side wall 140 of the vehicle-mounted power supply apparatus 10 (as shown in FIG. 21).

The PFC capacitor 6110 and the AC filter 6100 are sequentially tiled close to the left side wall 150 of the vehicle-mounted power supply apparatus 10 (as shown in FIG. 22). The HVDC filter 6210 and the LLC transformer 6200 are sequentially tiled close to the right side wall 160 of the vehicle-mounted power supply apparatus 10 (as shown in FIG. 21).

In an alternating current-to-direct current conversion circuit 610, the AC filter 6100 and the PFC capacitor 6110 are arranged along a front-rear direction Y of the vehicle-mounted power supply apparatus 10, the AC filter 6100 is located between a lower-layer left side edge 330 of a lower-layer PCB board 300 and the left side wall 150, the PFC capacitor 6110 and the PFC inductor 6120 are arranged along a left-right direction Z of the vehicle-mounted power supply apparatus 10, and the PFC inductor 6120 is located between a lower-layer rear side edge 320 of the lower-layer PCB board 300 and the rear side wall 140.

In this implementation, the AC filter 6100 and the PFC capacitor 6110 are located in peripheral space of the lower-layer left side edge 330 of the lower-layer PCB board 300, and the PFC inductor 6120 is located in peripheral space of the lower-layer rear side edge 320 of the lower-layer PCB board 300, so that mounting space between an upper-layer PCB board 200 and the lower-layer PCB board 300 is flexibly utilized. This helps reduce a size occupied by the power conversion circuit 600 in the vehicle-mounted power supply apparatus 10.

In an implementation, the AC filter 6100 is disposed close to the front side wall 130 of the vehicle-mounted power supply apparatus 10, so that the AC filter 6100 can be electrically connected to a power interface 1310 of electrical interfaces 1300 on an outer side of the vehicle-mounted power supply apparatus 10.

In a high-voltage direct current conversion circuit 620, the HVDC filter 6210 and the LLC transformer 6200 are arranged along the front-rear direction Y of the vehicle-mounted power supply apparatus 10, the HVDC filter 6210 and the AC filter 6100 are located on two sides of the lower-layer PCB board 300 along the left-right direction Z of the vehicle-mounted power supply apparatus 10, and the PFC capacitor 6110, the PFC inductor 6120, and the LLC transformer 6200 are sequentially arranged along the left-right direction Z of the vehicle-mounted power supply apparatus 10.

In this implementation, the HVDC filter 6210 is located between a lower-layer right side edge 340 of the lower-layer PCB board 300 and the right side wall 160 (as shown in FIG. 22), the LLC transformer 6200 is located in peripheral space of the lower-layer right side edge 340 and the lower-layer rear side edge 320 of the lower-layer PCB board 300, and the PFC capacitor 6110, the PFC inductor 6120, and the LLC transformer 6200 are all disposed close to the rear side wall 140, so that mounting space between the upper-layer PCB board 200 and the lower-layer PCB board 300 is flexibly utilized. This helps reduce a size occupied by the power conversion circuit 600 in the vehicle-mounted power supply apparatus 10.

In an implementation, the HVDC filter 6210 is disposed close to the front side wall 130 of the vehicle-mounted power supply apparatus 10, so that the HVDC filter 6210 can be electrically connected to a second direct current interface 1330 of the electrical interfaces 1300 on the outer side the vehicle-mounted power supply apparatus 10.

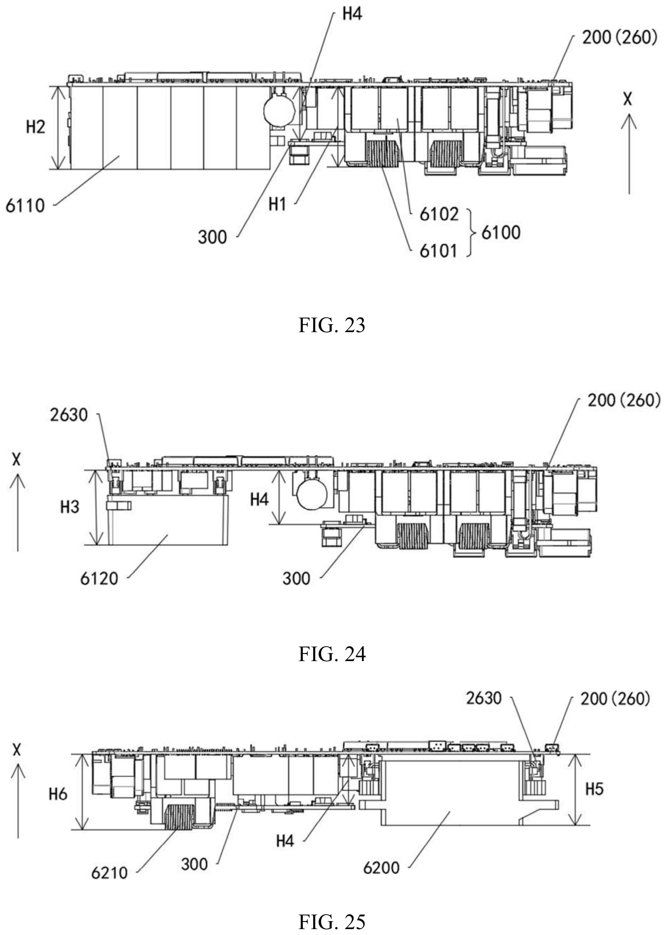

FIG. 23 is a diagram of a structure of an upper-layer PCB board 200, a lower-layer PCB board 300, and a part of a power conversion circuit 600 according to an implementation of this application. FIG. 24 is a diagram of a structure of an upper-layer PCB board 200, a lower-layer PCB board 300, and a part of a power conversion circuit 600 according to an implementation of this application. In an implementation, lengths of an AC filter 6100, a PFC capacitor 6110, and a PFC inductor 6120 along a height direction X of the vehicle-mounted power supply apparatus 10 are all greater than a spacing between the upper-layer PCB board 200 and the lower-layer PCB board 300 along the height direction X of the vehicle-mounted power supply apparatus 10 (as shown in FIG. 23 and FIG. 24).

In this implementation, the lengths of the AC filter 6100, the PFC capacitor 6110, and the PFC inductor 6120 along the height direction X of the vehicle-mounted power supply apparatus 10 are H1, H2, and H3 respectively, and the spacing between the upper-layer PCB board 200 and the lower-layer PCB board 300 along the height direction X of the vehicle-mounted power supply apparatus 10 is H4. In this solution, H1 is set to be greater than H4, H2 is set to be greater than H4, and H3 is set to be greater than H4. In one aspect, the lengths of the AC filter 6100, the PFC capacitor 6110, and the PFC inductor 6120 along the height direction X of the vehicle-mounted power supply apparatus 10 are all large. Therefore, these components are disposed between the lower-layer PCB board 300 and a base plate. Compared with an implementation in which the AC filter 6100, the PFC capacitor 6110, and the PFC inductor 6120 are disposed between the upper-layer PCB board 200 and the lower-layer PCB board 300, this solution better helps reduce an overall height of the vehicle-mounted power supply apparatus 10. In another aspect, the upper-layer PCB board 200, the lower-layer PCB board 300, and a bottom housing 100 are stacked, and the AC filter 6100, the PFC capacitor 6110, and the PFC inductor 6120 are disposed on peripheries of side edges of the lower-layer PCB board 300, so that these components can be directly fastened to the bottom housing 100. This reduces mounting difficulty and costs of the vehicle-mounted power supply apparatus 10.

In an implementation, the AC filter 6100 includes an AC filter inductor 6101 and an AC filter capacitor 6102. The AC filter inductor 6101 and the AC filter capacitor 6102 are stacked along the height direction X of the vehicle-mounted power supply apparatus 10, and the AC filter inductor 6101 is located on a side, away from the upper-layer PCB board 200, of the AC filter capacitor 6102. In this solution, the AC filter inductor 6101 and the AC filter capacitor 6102 are stacked. This helps reduce an area occupied by the AC filter 6100 on the upper-layer PCB board 200. FIG. 25 is a diagram of a structure of an upper-layer PCB board 200, a lower-layer PCB board 300, and a part of a power conversion circuit 600 according to an implementation of this application. In an implementation, lengths of an LLC transformer 6200 and an HVDC filter 6210 along a height direction X of the vehicle-mounted power supply apparatus 10 are both greater than a spacing between the upper-layer PCB board 200 and the lower-layer PCB board 300 along the height direction X of the vehicle-mounted power supply apparatus 10.

In this implementation, the lengths of the LLC transformer 6200 and the HVDC filter 6210 along the height direction X of the vehicle-mounted power supply apparatus 10 are H5 and H6 respectively, and the spacing between the upper-layer PCB board 200 and the lower-layer PCB board 300 along the height direction X of the vehicle-mounted power supply apparatus is H4. In this solution, H5 is set to be greater than H4, and H6 is set to be greater than H4. In one aspect, the lengths of the LLC transformer 6200 and the HVDC filter 6210 along the height direction X of the vehicle-mounted power supply apparatus 10 are both large. Therefore, these components are disposed between the lower-layer PCB board 300 and a base plate. Compared with an implementation in which the LLC transformer 6200 and the HVDC filter 6210 are disposed between the upper-layer PCB board 200 and the lower-layer PCB board 300, this solution better helps reduce an overall height of the vehicle-mounted power supply apparatus 10. In another aspect, the upper-layer PCB board 200, the lower-layer PCB board 300, and a bottom housing 100 are stacked, and the LLC transformer 6200 and the HVDC filter 6210 are disposed on peripheries of side edges of the lower-layer PCB board 300, so that these components can be directly fastened to the bottom housing 100. This reduces mounting difficulty and costs of the vehicle-mounted power supply apparatus 10.

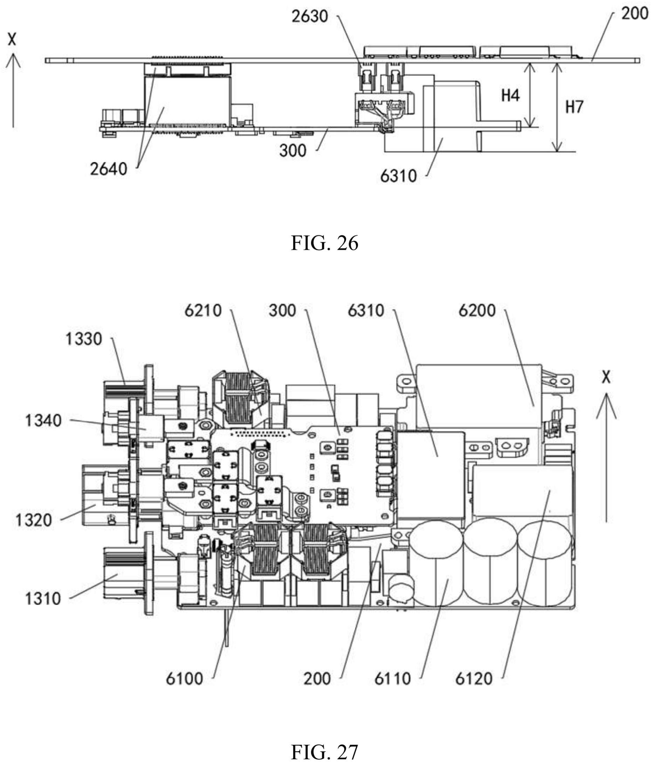

FIG. 26 is a diagram of a structure of an upper-layer PCB board 200, a lower-layer PCB board 300, and a part of a power conversion circuit 600 according to an implementation of this application. In an implementation, a length of a low-voltage transformer 6310 along a height direction X of the vehicle-mounted power supply apparatus 10 is greater than a spacing between the upper-layer PCB board 200 and the lower-layer PCB board 300 along the height direction X of the vehicle-mounted power supply apparatus 10.

In this implementation, the length of the low-voltage transformer 6310 along the height direction X of the vehicle-mounted power supply apparatus 10 is H7, and the spacing between the upper-layer PCB board 200 and the lower-layer PCB board 300 along the height direction X of the vehicle-mounted power supply apparatus 10 is H4. In this solution, H7 is set to be greater than H4. In one aspect, the length of the low-voltage transformer 6310 along the height direction X of the vehicle-mounted power supply apparatus 10 is large. Therefore, the low-voltage transformer 6310 is disposed between the lower-layer PCB board 300 and a base plate. Compared with an implementation in which the low-voltage transformer 6310 is disposed between the upper-layer PCB board 200 and the lower-layer PCB board 300, this solution better helps reduce an overall height of the vehicle-mounted power supply apparatus 10. In another aspect, the upper-layer PCB board 200, the lower-layer PCB board 300, and a bottom housing 100 are stacked, and a part of the low-voltage transformer 6310 is disposed on a periphery of a side edge of the lower-layer PCB board 300, so that the low-voltage transformer 6310 can be directly fastened to the bottom housing 100. This reduces mounting difficulty and costs of the vehicle-mounted power supply apparatus 10.

FIG. 27 is a diagram of a partial structure of a vehicle-mounted power supply apparatus 10 according to an implementation of this application. In an implementation, an AC filter 6100, a PFC capacitor 6110, and a PFC inductor 6120 are electrically connected to an upper-layer PCB board 200. An HVDC filter 6210 and an LLC transformer 6200 are electrically connected to the upper-layer PCB board 200. A low-voltage transformer 6310 is electrically connected to the upper-layer PCB board 200 and a lower-layer PCB board 300.

The AC filter 6100, the PFC capacitor 6110, and the PFC inductor 6120 are electronic components in an alternating current-to-direct current conversion circuit 610. The AC filter 6100 is configured to receive an alternating current and filter out harmonics in the alternating current. The alternating current-to-direct current conversion circuit 610 is electrically connected to an output end of the AC filter 6100 and converts an alternating current output by the AC filter 6100 into a direct current. In this implementation, the AC filter 6100, the PFC capacitor 6110, and the PFC inductor 6120 are electrically connected through the upper-layer PCB board 200, so that the vehicle-mounted power supply apparatus 10 can implement a function of converting a power source into the direct current. This provides a basis for subsequently converting the direct current into a first direct current and a second direct current.

The HVDC filter 6210 and the LLC transformer 6200 are electronic components in a high-voltage direct current conversion circuit 620. An input end of the LLC transformer 6200 is electrically connected to the alternating current-to-direct current conversion circuit 610 and converts the direct current output by the alternating current-to-direct current conversion circuit 610 into the second direct current. An output end of the LLC transformer 6200 is electrically connected to the HVDC filter 6210, and the HVDC filter 6210 is configured to filter out harmonics in the second direct current output by the LLC transformer 6200 and transmit an obtained direct current to a battery. In this implementation, the HVDC filter 6210 and the LLC transformer 6200 are electrically connected through the upper-layer PCB board 200, so that the vehicle-mounted power supply apparatus 10 can implement a function of converting the direct current into the second direct current to meet a charging requirement of the battery.

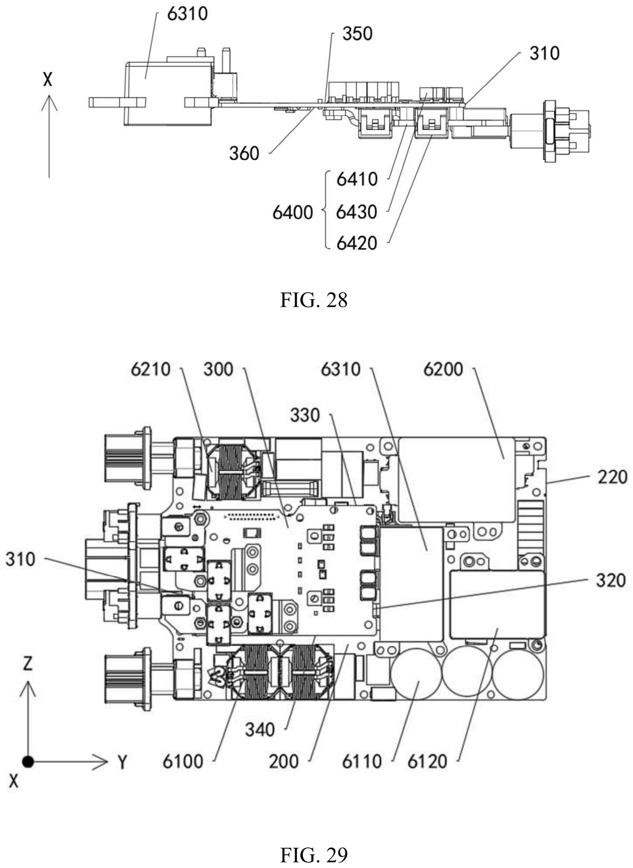

The low-voltage transformer 6310 is an electronic component in a low-voltage direct current conversion circuit 630. The low-voltage transformer 6310 is electrically connected to the upper-layer PCB board 200 through a primary-side circuit 6300. The low-voltage transformer 6310 is electrically connected to the lower-layer PCB board 300 through a secondary-side circuit 6320. The low-voltage transformer 6310 receives at least one of the direct current transmitted by the alternating current-to-direct current conversion circuit 610 and the second direct current transmitted by the high-voltage direct current conversion circuit 620, and inputs the first direct current to a first-type load. In an implementation, a power conversion circuit 600 further includes an LVDC filter 6400, and the LVDC filter 6400 and the low-voltage transformer 6310 are electrically connected to the lower-layer PCB board 300. In this implementation, the LVDC filter 6400 is a filter in the low-voltage direct current conversion circuit 630, and the LVDC filter 6400 may also be referred to as a low-voltage filter. An output end of the low-voltage transformer 6310 is electrically connected to the LVDC filter 6400, and the LVDC filter 6400 is configured to filter out harmonics in the first direct current output by the low-voltage transformer 6310. In this solution, the low-voltage transformer 6310 and the LVDC filter 6400 are electrically connected through the lower-layer PCB board 300, so that the vehicle-mounted power supply apparatus 10 can implement a function of outputting the first direct current to meet a power requirement of the first-type load. FIG. 28 is a diagram of a structure of a lower-layer PCB board 300 and a part of a power conversion circuit 600 according to an implementation of this application. In an implementation, a low-voltage direct current conversion circuit 630 further includes an LVDC filter 6400. The LVDC filter 6400 includes an LVDC filter copper bar assembly 6410, an LVDC filter magnetic ring 6420, and an LVDC filter capacitor 6430. The LVDC filter copper bar assembly 6410 and the LVDC filter magnetic ring 6420 are fastened to a lower surface 360 of the lower-layer PCB board 300. The LVDC filter capacitor 6430 is plug-connected to an upper surface 350 of the lower-layer PCB board 300.

The LVDC filter copper bar assembly 6410 is configured to electrically connect the LVDC filter magnetic ring 6420 to the LVDC filter capacitor 6430. The LVDC filter magnetic ring 6420 functions as a filter inductor, and the LVDC filter magnetic ring 6420 and the LVDC filter capacitor 6430 jointly implement a filtering function for a first direct current.

In this implementation, the LVDC filter copper bar assembly 6410 is fastened to the lower-layer PCB board 300 by using a screw, and the LVDC filter magnetic ring 6420 is electrically connected to the lower-layer PCB board 300 and the LVDC filter capacitor 6430 through the LVDC filter copper bar assembly 6410. The LVDC filter capacitor 6430 is provided with a pin, and the LVDC filter capacitor 6430 is fastened to the lower-layer PCB board 300 through the pin.

In this implementation, the LVDC filter copper bar assembly 6410 and the LVDC filter magnetic ring 6420, and the LVDC filter capacitor 6430 are located on the lower surface 360 and the upper surface 350 of the lower-layer PCB board 300 respectively. Compared with an implementation in which the LVDC filter copper bar assembly 6410, the LVDC filter magnetic ring 6420, and the LVDC filter capacitor 6430 are all disposed on the upper surface 350 or the lower surface 360 of the lower-layer PCB board 300, this solution helps reduce a mounting area occupied by the LVDC filter 6400 on a same surface of the lower-layer PCB board 300, and helps provide space for mounting other components on the upper surface 350 or the lower surface 360 of the lower-layer PCB board 300.

In this implementation, the LVDC filter capacitor 6430 is disposed close to a lower-layer front side edge 310 of the lower-layer PCB board 300, and the LVDC filter capacitor 6430 and the low-voltage transformer 6310 are spaced away. This helps provide space for mounting other components between the LVDC filter capacitor 6430 and the low-voltage transformer 6310. FIG. 29 is a diagram of a partial structure of a vehicle-mounted power supply apparatus 10 according to an implementation of this application. In an implementation, an upper-layer PCB board 200 is stacked above an AC filter 6100, a PFC capacitor 6110, a PFC inductor 6120, an HVDC filter 6210, an LLC transformer 6200, a low-voltage transformer 6310, and a lower-layer PCB board 300. The PFC capacitor 6110, the PFC inductor 6120, and the LLC transformer 6200 are arranged along a left-right direction Z of the vehicle-mounted power supply apparatus 10. The AC filter 6100 and the PFC capacitor 6110 are arranged along a front-rear direction Y of the vehicle-mounted power supply apparatus 10. The lower-layer PCB board 300, the low-voltage transformer 6310, and the PFC inductor 6120 are arranged along the front-rear direction Y of the vehicle-mounted power supply apparatus 10. The AC filter 6100, the lower-layer PCB board 300, and the HVDC filter 6210 are arranged along the left-right direction Z of the vehicle-mounted power supply apparatus 10.

In this implementation, the AC filter 6100, the PFC capacitor 6110, the PFC inductor 6120, the HVDC filter 6210, the LLC transformer 6200, and the low-voltage transformer 6310 are disposed around side edges of the lower-layer PCB board 300 and are arranged close to each other. In an alternating current-to-direct current conversion circuit 610, the AC filter 6100 and the PFC capacitor 6110 are arranged along the front-rear direction Y of the vehicle-mounted power supply apparatus 10 and are disposed close to a lower-layer left side edge 330 of the lower-layer PCB board 300, and the PFC capacitor 6110 and the PFC inductor 6120 are arranged along the left-right direction Z of the vehicle-mounted power supply apparatus 10 and are disposed close to an upper-layer rear side edge 220 of the upper-layer PCB board 200. In a high-voltage direct current conversion circuit 620, the LLC transformer 6200 and the HVDC filter 6210 are arranged along the front-rear direction Y of the vehicle-mounted power supply apparatus 10 and are disposed close to a lower-layer right side edge 340 of the lower-layer PCB board 300. Along the front-rear direction Y of the vehicle-mounted power supply apparatus 10, the low-voltage transformer 6310 is located between the lower-layer PCB board 300 and the PFC inductor 6120, and the low-voltage transformer 6310 is disposed close to a lower-layer rear side edge 320 of the lower-layer PCB board 300. In this solution, components in the power conversion circuit 600 are properly arranged. This helps improve utilization of internal space of the vehicle-mounted power supply apparatus 10.

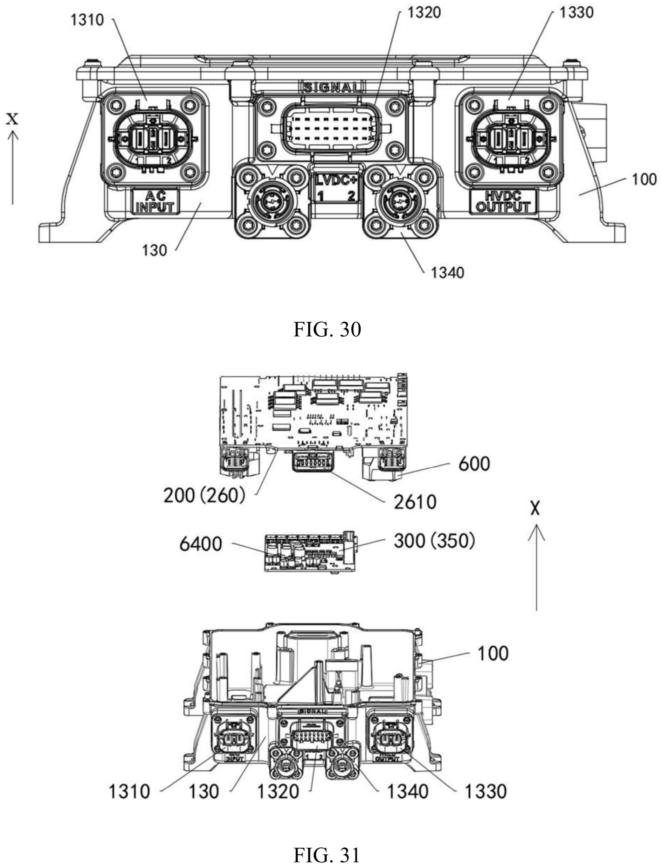

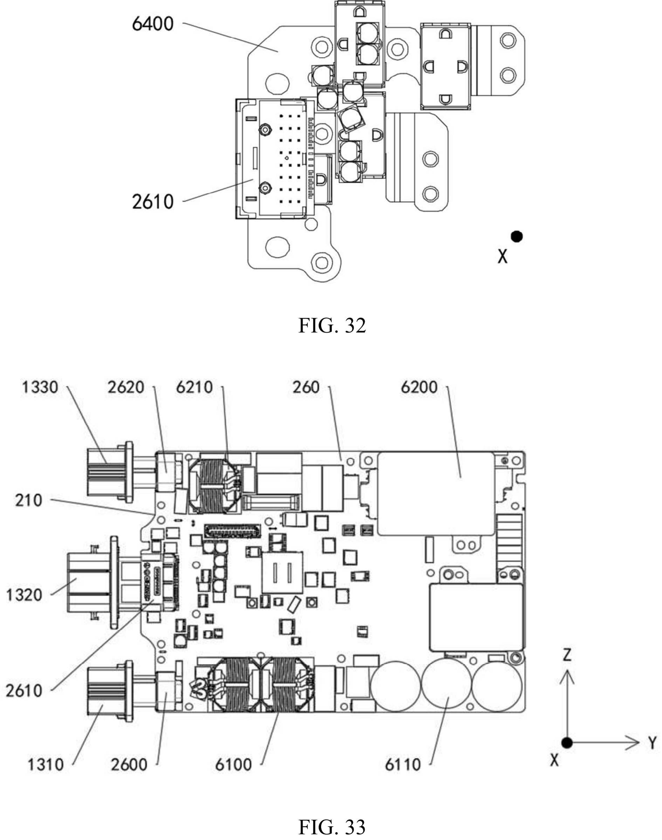

FIG. 30 is a diagram of a structure of a bottom housing and electrical interfaces of a vehicle-mounted power supply apparatus 10 according to an implementation of this application. FIG. 31 is a partial exploded view of a vehicle-mounted power supply apparatus 10 according to an implementation of this application. FIG. 32 is a diagram of a structure of a control signal connector 2610 and a low-voltage filter circuit 6400 in a vehicle-mounted power supply apparatus 10 according to an implementation of this application. In an implementation, a front side wall 130 includes a control signal interface 1320, a power interface 1310, and a first direct current interface 1340 (as shown in FIG. 32), a lower surface 260 of an upper-layer PCB board 200 includes the control signal connector 2610 (as shown in FIG. 32), and an upper surface 350 of a lower-layer PCB board 300 includes a part of the low-voltage filter circuit 6400 (as shown in FIG. 32). The control signal connector 2610 is configured to electrically connect the control signal interface 1320 to the upper-layer PCB board 200 (as shown in FIG. 31). The low-voltage filter circuit 6400 is configured to electrically connect the first direct current interface 1340 to the lower-layer PCB board 300 (as shown in FIG. 31). Orthographic projections of the control signal connector 2610 and the low-voltage filter circuit 6400 partially overlap (as shown in FIG. 32).

In this implementation, the control signal connector 2610 is disposed on the lower surface 260 of the upper-layer PCB board 200, and the part of the low-voltage filter circuit 6400 is disposed on the upper surface 350 of the lower-layer PCB board 300, so that space between the upper-layer PCB board 200 and the lower-layer PCB board 300 can be fully utilized. In an implementation, the low-voltage filter circuit 6400 includes a capacitor, an inductor, and a copper bar. The capacitor may be disposed on the upper surface 350 of the lower-layer PCB board 300, and the inductor and the copper bar may be disposed on the lower surface 360 of the lower-layer PCB board 300. In another implementation, another arrangement may alternatively be used according to an actual requirement.

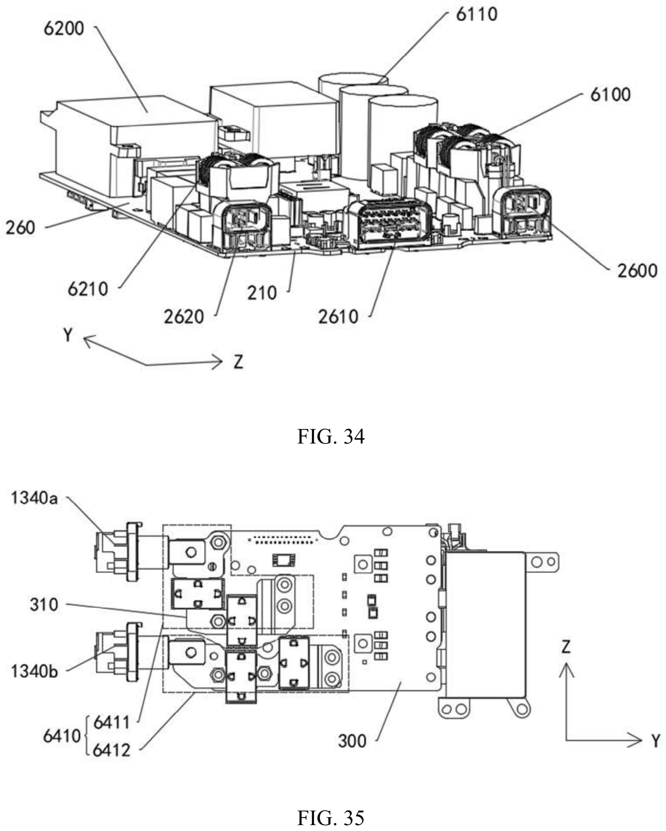

In this implementation, a projection of the control signal connector 2610 along a height direction X of the vehicle-mounted power supply apparatus 10 partially overlaps with a projection of the low-voltage filter circuit 6400 along the height direction X of the vehicle-mounted power supply apparatus 10, so that a shared shield can is able to be disposed between the control signal connector 2610 and the low-voltage filter circuit 6400. In this way, the shield structure can reduce electrical interference between the control signal connector 2610 and the low-voltage filter circuit 6400. FIG. 33 is a diagram of a structure of an upper-layer PCB board 200 and a part of a power conversion circuit 600 according to an implementation of this application. FIG. 34 is a diagram of a structure of an upper-layer PCB board 200 and a part of a power conversion circuit 600 according to an implementation of this application.

In an implementation, a power connector 2600, a control signal connector 2610, and a second direct current connector 2620 are fastened to a lower surface 260 of the upper-layer PCB board 200. The power connector 2600 is configured to plug-connect to a power interface 1310 (as shown in FIG. 33 and FIG. 34). The control signal connector 2610 is configured to plug-connect to a control signal interface 1320 (as shown in FIG. 33 and FIG. 34). The second direct current connector 2620 is configured to plug-connect to a second direct current interface 1330 (as shown in FIG. 33 and FIG. 34). The power connector 2600, the control signal connector 2610, and the second direct current connector 2620 are sequentially arranged along a left-right direction Z of the vehicle-mounted power supply apparatus 10 and are fastened to an upper-layer front side edge 210 of the upper-layer PCB board 200 (as shown in FIG. 33). The power connector 2600 is located on a side, away from a PFC capacitor 6110, of an AC filter 6100, and is electrically connected to an input end of the AC filter 6100 (as shown in FIG. 33). The second direct current connector 2620 is located on a side, away from an LLC transformer 6200, of an HVDC filter 6210, and is electrically connected to an output end of the HVDC filter 6210 (as shown in FIG. 33).

In an implementation, the power connector 2600, the control signal connector 2610, and the second direct current connector 2620 are plug-in connectors, and are all fastened to the upper-layer PCB board 200 and located on the upper-layer front side edge 210 of the upper-layer PCB board 200. The upper-layer front side edge 210 of the upper-layer PCB board 200 is arranged close to a front side wall 130 of the vehicle-mounted power supply apparatus 10. In an implementation, the power interface 1310, the control signal interface 1320, and the second direct current interface 1330 are disposed on a side surface, opposite to the front side wall 130, on an outer side of the vehicle-mounted power supply apparatus 10. The power interface 1310, the control signal interface 1320, and the second direct current interface 1330 can be electrically connected to the power conversion circuit 600 through plug-connection to the three connectors respectively. This helps reduce assembly difficulty of electrical connections.

In an implementation, the power connector 2600 is located between a lower-layer left side edge 330 of a lower-layer PCB board 300 and a left side wall 150 of the vehicle-mounted power supply apparatus 10, and the power connector 2600, the AC filter 6100, and the PFC capacitor 6110 are sequentially arranged along a front-rear direction Y of the vehicle-mounted power supply apparatus 10. The power connector 2600 is electrically connected to the input end of the AC filter 6100, so that an external power source 13 is transmitted to the PFC capacitor 6110 and the PFC inductor 6120 through the power interface 1310, the power connector 2600, and the AC filter 6100 sequentially. In this way, the external power source 13 is converted into a direct current.

In an implementation, the second direct current connector 2620 is located between a lower-layer right side edge 340 of the lower-layer PCB board 300 and a right side wall 160 of the vehicle-mounted power supply apparatus 10, and the second direct current connector 2620, the HVDC filter 6210, and the LLC transformer 6200 are sequentially arranged along the front-rear direction Y of the vehicle-mounted power supply apparatus 10. The second direct current connector 2620 is electrically connected to the output end of the HVDC filter 6210, so that the direct current is transmitted to the second direct current interface 1330 through the LLC transformer 6200, the HVDC filter 6210, and the second direct current connector 2620 sequentially. In this way, the direct current is converted into a second direct current to supply power to a second-type load. FIG. 35 is a diagram of a structure of a lower-layer PCB board 300 and a part of a power conversion circuit 600 according to an implementation of this application. In an implementation, the vehicle-mounted power supply apparatus 10 further includes two first direct current interfaces 1340, and an LVDC filter copper bar assembly 6410 includes a first LVDC filter copper bar 6411 and a second LVDC filter copper bar 6412. The first LVDC filter copper bar 6411 and the second LVDC filter copper bar 6412 are fastened to the lower-layer PCB board 300 and extend to an outer side of a lower-layer front side edge 310 of the lower-layer PCB board 300. A part of the first LVDC filter copper bar 6411 and a part of the second LVDC filter copper bar 6412 that are located on the outer side of the lower-layer front side edge 310 of the lower-layer PCB board 300 are fastened and electrically connected to the two first direct current interfaces 1340 respectively.

In this implementation, the first LVDC filter copper bar 6411 is arranged in an "L" shape, a part of the first LVDC filter copper bar 6411 that is located on an inner side of the lower-layer front side edge 310 of the lower-layer PCB board 300 is arranged along a left-right direction Z of the vehicle-mounted power supply apparatus 10, a part of the first LVDC filter copper bar 6411 that is located on the outer side of the lower-layer front side edge 310 of the lower-layer PCB board 300 is arranged along a front-rear direction Y of the vehicle-mounted power supply apparatus 10, the second LVDC filter copper bar 6412 extends along the front-rear direction Y of the vehicle-mounted power supply apparatus 10, and the two first direct current interfaces 1340 are arranged along the left-right direction Z of the vehicle-mounted power supply apparatus 10. The first LVDC filter copper bar 6411 and the second LVDC filter copper bar 6412 are fastened to the two first direct current interfaces 1340 respectively by using screws.

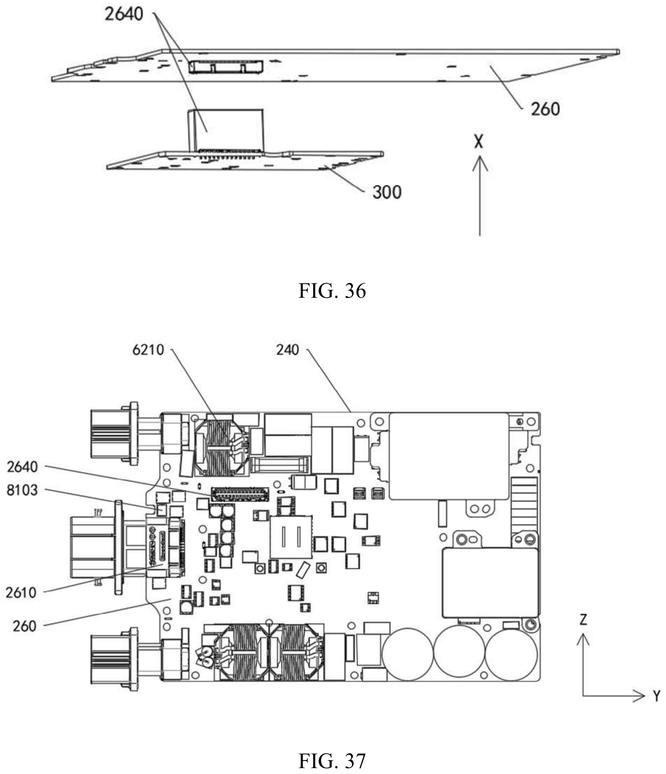

Refer to FIG. 23 to FIG. 26 and FIG. 36. FIG. 36 is a diagram of a partial structure of a vehicle-mounted power supply apparatus 10 according to an implementation of this application. In an implementation, a lower surface 260 of the upper-layer PCB board 200 includes a flat cable connector 2640 and a plurality of plug connectors 2630. The plurality of plug connectors 2630 are configured to electrically connect to the AC filter 6100, the HVDC filter 6210, the PFC capacitor 6110, the PFC inductor 6120, the low-voltage transformer 6310, and the LLC transformer 6200 respectively (as shown in FIG. 23 to FIG. 26). The flat cable connector 2640 is configured to electrically connect the upper-layer PCB board 200 to the lower-layer PCB board 300 (as shown in FIG. 26 and FIG. 36).

In an implementation, the AC filter 6100, the HVDC filter 6210, the PFC capacitor 6110, the PFC inductor 6120, the low-voltage transformer 6310, and the LLC transformer 6200 are all provided with plug terminals, and the plug terminals are inserted into the plug connectors 2630, so that the AC filter 6100, the HVDC filter 6210, the PFC capacitor 6110, the PFC inductor 6120, the low-voltage transformer 6310, and the LLC transformer 6200 are fastened to the lower surface 260 of the upper-layer PCB board 200 and are electrically connected to the upper-layer PCB board 200. In some other implementations, the AC filter 6100, the HVDC filter 6210, the PFC capacitor 6110, the PFC inductor 6120, the low-voltage transformer 6310, and the LLC transformer 6200 may alternatively be fastened to the upper-layer PCB board 200 in another manner, for example, may be fastened through pins, screws, or welding.

FIG. 37 is a diagram of a partial structure of a vehicle-mounted power supply apparatus 10 according to an implementation of this application. In this implementation, a flat cable connector 2640 may also be referred to as a board-to-board connector. A flat cable connector 2640 of an upper-layer PCB board 200 is located on a side, away from an upper-layer right side edge 240, of an HVDC filter 6210. The upper-layer PCB board 200 is fastened to a lower-layer PCB board 300, so that overall structural stability of the vehicle-mounted power supply apparatus 10 can be ensured. In addition, the flat cable connector 2640 is disposed in gap regions between different components on the upper-layer PCB board 200, without increasing an area of a board surface of the upper-layer PCB board 200. This helps reduce a size of the vehicle-mounted power supply apparatus 10.

Further, refer to FIG. 23 to FIG. 26 and FIG. 36. In an implementation, an upper surface of the lower-layer PCB includes a flat cable connector 2640 and a plug connector 2630 (as shown in FIG. 23 to FIG. 26). The flat cable connector 2640 is configured to electrically connect to the upper-layer PCB. The plug connector 2630 is configured to electrically connect to the low-voltage transformer 6310 (as shown in FIG. 26 and FIG. 36).

In this implementation, the upper-layer PCB board 200 and the lower-layer PCB board 300 are fastened and electrically connected through plug-in of the flat cable connectors 2640. The flat cable connector 2640 of the lower-layer PCB board 300 is disposed close to a lower-layer right side edge 340. The flat cable connector 2640 is disposed in gap regions between different components on the lower-layer PCB board 300, without increasing an area of a board surface of the lower-layer PCB board 300. This helps reduce a size of the vehicle-mounted power supply apparatus 10.

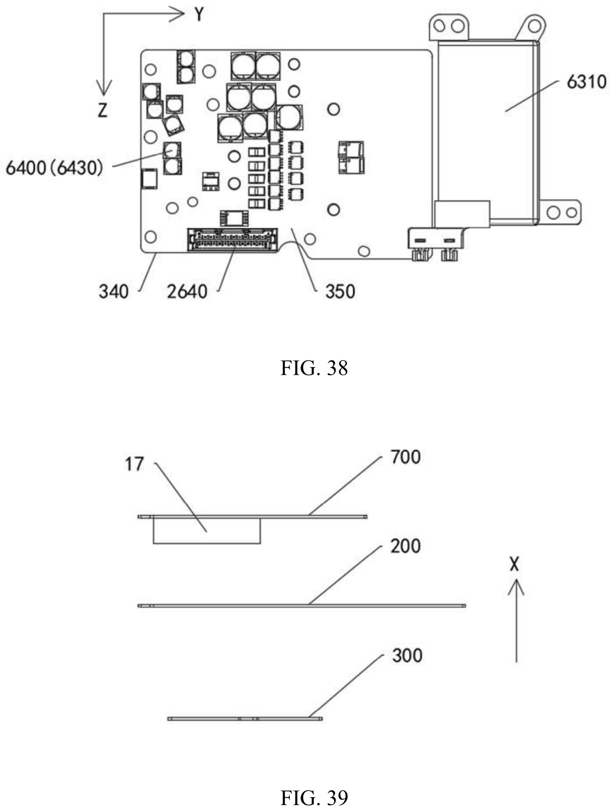

FIG. 38 is a diagram of a partial structure of a vehicle-mounted power supply apparatus 10 according to an implementation of this application. In this implementation, a low-voltage transformer 6310 is provided with a plug terminal (not shown in the figure), and the plug terminal is inserted into a plug connector 2630, so that the low-voltage transformer 6310 is fastened to an upper surface 350 of a lower-layer PCB board 300 and is electrically connected to the lower-layer PCB board 300. In some other implementations, the low-voltage transformer 6310 may alternatively be fastened to the lower-layer PCB board 300 in another manner, for example, may be fastened through a pin, a screw, or welding.

FIG. 39 is a diagram of a partial structure of a vehicle-mounted power supply apparatus 10 according to an implementation of this application. In an implementation, the vehicle-mounted power supply apparatus 10 further includes a top-layer PCB board 700. The top-layer PCB board 700 is used for disposing a power distribution unit 17. The top-layer PCB board 700, an upper-layer PCB board 200, and a lower-layer PCB board 300 are arranged along a height direction X of the vehicle-mounted power supply apparatus 10. The top-layer PCB board 700 is fastened to the upper-layer PCB board 200. The power distribution unit 17 is configured to distribute power of an external power source 13 to various components and power transistors that need power supply.

In this implementation, the power distribution unit 17 is disposed on the top-layer PCB board 700. This helps improve integration of the vehicle-mounted power supply apparatus 10 and enhance functions and practicability of the vehicle-mounted power supply apparatus 10. In addition, the top-layer PCB board 700, the upper-layer PCB board 200, and the lower-layer PCB board 300 are stacked and are disposed in parallel. This can reduce mounting difficulty.

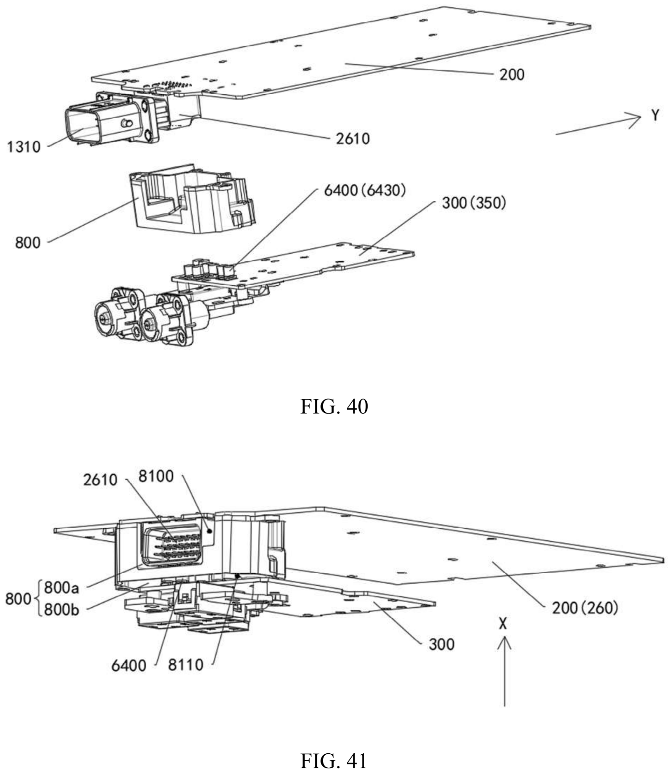

FIG. 40 is a diagram of a partial structure of a vehicle-mounted power supply apparatus 10 according to an implementation of this application. FIG. 41 is a diagram of a partial structure of a vehicle-mounted power supply apparatus 10 according to an implementation of this application. In an implementation, a shield can 800 is disposed between an upper-layer PCB board 200 and a lower-layer PCB board 300 (as shown in FIG. 40). The shield can 800 is configured to form a control signal shield cavity 800a together with a lower surface 260 of the upper-layer PCB board 200 (as shown in FIG. 41), and the control signal shield cavity 800a is configured to accommodate a control signal connector 2610. The shield can 800 is further configured to form a low-voltage filter shield cavity 800b together with an upper surface 350 of the lower-layer PCB board 300, and the low-voltage filter shield cavity 800b is configured to accommodate at least a part of a low-voltage filter circuit (as shown in FIG. 41).

In this implementation, space between the upper-layer PCB board 200 and the lower-layer PCB board 300 is used for placing the shield can 800, so that the space between the two PCB boards can be fully utilized. In addition, a shield wall may be formed between the shield can 800 and the two PCB boards to shield electrical components on the two PCB boards.

In this implementation, the shield can 800 shields and isolates the control signal connector 2610 from at least a part of the low-voltage filter circuit 6400, to prevent the low-voltage filter circuit 6400 from interfering with a signal transmitted in the control signal connector 2610. This improves signal transmission quality.

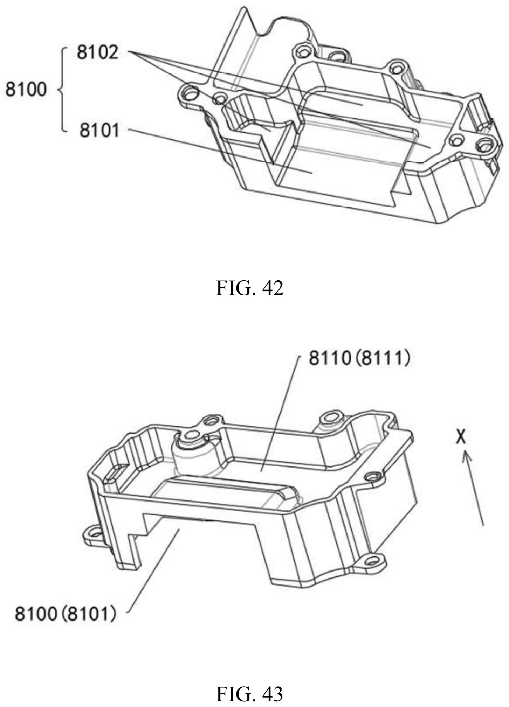

Refer to FIG. 41, FIG. 42, and FIG. 43. FIG. 42 is a diagram of a structure of a shield can 800 according to an implementation of this application. FIG. 43 is a diagram of a structure of a shield can 800 according to an implementation of this application. In an implementation, the shield can 800 includes a first shield can 8100 (as shown in FIG. 42) and a second shield can 8110 (as shown in FIG. 43) that are disposed back to back along a height direction X of the vehicle-mounted power supply apparatus 10. The first shield can 8100 and the lower surface 260 of the upper-layer PCB board 200 form the control signal shield cavity 800a, and the control signal shield cavity 800a is configured to reduce electrical interference to the control signal connector 2610. The second shield can 8110 and the upper surface 350 of the lower-layer PCB board 300 form the low-voltage filter shield cavity 800b, and the low-voltage filter shield cavity 800b is configured to reduce electrical interference to the low-voltage filter circuit 6400.

In this implementation, the control signal shield cavity 800a may also be referred to as a first shield cavity, and the low-voltage filter shield cavity 800b may also be referred to as a second shield cavity. The first shield can 8100 and the second shield can 8110 shield and isolate the control signal connector 2610 from at least a part of the low-voltage filter circuit 6400, to prevent the low-voltage filter circuit 6400 from interfering with a signal transmitted in the control signal connector 2610. This improves signal transmission quality.

Further, refer to FIG. 40. In an implementation, the shield can 800 may also be referred to as an LVDC shield can, and the shield can 800 is configured to shield the control signal connector 2610 located below the upper-layer PCB board 200 from the low-voltage filter circuit 6400 located on the lower-layer PCB board 300. The control signal connector 2610 is configured to plug-connect to a control signal interface 1320 on an outer side of a bottom housing 100.

In this implementation, the low-voltage filter circuit 6400 is also referred to as an LVDC filter 6400, and the LVDC filter 6400 is configured to filter out harmonics in a first direct current. The shield can 800 is located between the upper-layer PCB board 200 and the lower-layer PCB board 300 along the height direction X of the vehicle-mounted power supply apparatus 10.

In this implementation, a part of the LVDC filter 6400 is fastened to the upper surface 350 of the lower-layer PCB board 300, a part of the shield can 800 is located on a side close to the upper surface 350 of the lower-layer PCB board 300, and the part of the shield can 800 is configured to shield the part of the LVDC filter 6400 that is located on the upper surface 350 of the lower-layer PCB board 300.

In this implementation, a part of the shield can 800 is located on a side close to the lower surface 260 of the upper-layer PCB board 200, and the part of the shield can 800 is configured to shield the control signal connector 2610.

Further, refer to FIG. 41, FIG. 42, and FIG. 43. In this implementation, the first shield can 8100 is concave along a direction away from the lower surface 260 of the upper-layer PCB board 200 (as shown in FIG. 41 and FIG. 42), and the first shield can 8100 covers an outer side of the control signal connector 2610 along the height direction X of the vehicle-mounted power supply apparatus 10. The second shield can 8110 is concave along a direction away from the upper surface 350 of the lower-layer PCB board 300 (as shown in FIG. 41 and FIG. 43), and the second shield can 8110 covers an outer side of a part of the LVDC filter 6400 along the height direction X of the vehicle-mounted power supply apparatus 10. The shield can 800 shields the control signal connector 2610 and the part of the LVDC filter 6400 separately, so that space between the upper-layer PCB board 200 and the lower-layer PCB board 300 is fully utilized, and a size occupied by the vehicle-mounted power supply apparatus 10 along the height direction X is not increased due to the disposing of the shield can 800. This facilitates a miniaturization design of the vehicle-mounted power supply apparatus 10.

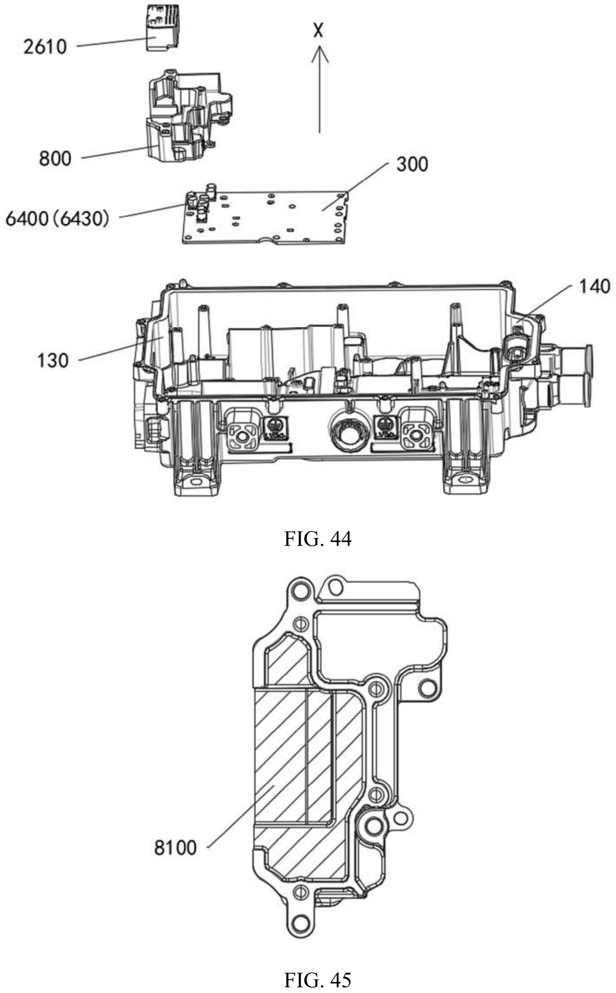

FIG. 44 is a partial exploded view of a vehicle-mounted power supply apparatus 10 according to an implementation of this application. In an implementation, an LVDC filter 6400 includes an LVDC filter capacitor 6430, and the LVDC filter capacitor 6430 is located in a second shield can 8110.

In this implementation, the LVDC filter capacitor 6430 is located on an upper surface 350 of a lower-layer PCB board 300, and the second shield can 8110 covers an outer side of the LVDC filter capacitor 6430 along a height direction X of the vehicle-mounted power supply apparatus 10. In an implementation, the LVDC filter 6400 further includes an LVDC filter magnetic ring 6420. The LVDC filter capacitor 6430 and the LVDC filter magnetic ring 6420 form an LC circuit to filter a first direct current.

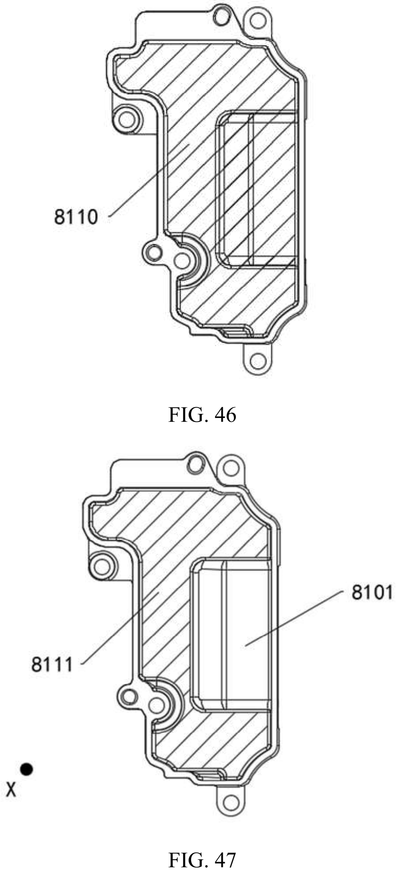

FIG. 45 is a diagram of a structure of a first shield can 8100 in a shield can 800 according to an implementation of this application. FIG. 46 is a diagram of a structure of a second shield can 8110 in a shield can 800 according to an implementation of this application. In an implementation, a projection area of the first shield can 8100 on an upper-layer PCB board 200 along a height direction X of the vehicle-mounted power supply apparatus 10 is less than a projection area of the second shield can 8110 on the upper-layer PCB board 200 along the height direction X of the vehicle-mounted power supply apparatus 10 (as shown in FIG. 45 and FIG. 46).

Further, refer to FIG. 44. In this implementation, the vehicle-mounted power supply apparatus 10 includes a front side wall 130 and a rear side wall 140 that are arranged opposite to each other along a front-rear direction Y. The first shield can 8100 is configured to shield a control signal connector 2610, and the second shield can 8110 is configured to shield a part of the LVDC filter 6400. The part of the LVDC filter 6400 is located on a side, away from the front side wall 130 along the front-rear direction Y, of the control signal connector 2610. In addition, distribution of the part of the LVDC filter 6400 on the lower-layer PCB board 300 is scattered. Therefore, the projection area of the second shield can 8110 along the height direction X of the vehicle-mounted power supply apparatus 10 needs to be set to be greater than the projection area of the first shield can 8100 along the height direction X of the vehicle-mounted power supply apparatus 10, so that the shield can 800 shields both the control signal connector 2610 and the LVDC filter 6400.

Refer to FIG. 42 and FIG. 44. FIG. 42 is a diagram of a structure of a first shield can 8100 in a shield can 800 according to an implementation of this application. In an implementation, the first shield can 8100 includes a connector accommodation groove 8101 and a signal filter accommodation groove 8102 (as shown in FIG. 42). The signal filter accommodation groove 8102 is located on a periphery of the connector accommodation groove 8101. The control signal connector 2610 is located in the connector accommodation groove 8101 (as shown in FIG. 42 and FIG. 44). The signal filter accommodation groove 8102 is used for disposing a signal filter component 8103 (as shown in FIG. 37).

In this implementation, the signal filter component 8103 is configured to filter an input signal. The signal filter component 8103 is fastened to the lower surface 260 of the upper-layer PCB board 200 and is located on a periphery of the control signal connector 2610.

In this implementation, a length of the signal filter component 8103 along the height direction X of the vehicle-mounted power supply apparatus 10 is less than a length of the control signal connector 2610 along the height direction X of the vehicle-mounted power supply apparatus 10. Therefore, the signal filter accommodation groove 8102 is arranged in a stepped shape. A groove bottom of the signal filter accommodation groove 8102 is located on a side, away from the second shield can 8110 along the height direction X, of the connector accommodation groove 8101.

In this solution, the connector accommodation groove 8101 and the signal filter accommodation groove 8102 are provided in the first shield can 8100, so that the first shield can 8100 can shield more components. This helps enhance electromagnetic compatibility of the power conversion circuit 600.

Refer to FIG. 43 and FIG. 47. FIG. 47 is a diagram of a structure of a shield can 800 according to an implementation of this application. In an implementation, the second shield can 8110 includes a filter accommodation groove 8111 (as shown in FIG. 43). A projection of the filter accommodation groove 8111 on the upper-layer PCB board 200 along the height direction X of the vehicle-mounted power supply apparatus 10 does not overlap with a projection of a connector accommodation groove 8101 on the upper-layer PCB board 200 along the height direction X of the vehicle-mounted power supply apparatus 10 (as shown in FIG. 47). A direction along which the filter accommodation groove 8111 is concave is opposite to a direction along which the connector accommodation groove 8101 is concave (as shown in FIG. 43). The filter accommodation groove 8111 is configured to accommodate a part of the LVDC filter 6400.

In this implementation, both the filter accommodation groove 8111 and the connector accommodation groove 8101 need to occupy specific space along the height direction X of the vehicle-mounted power supply apparatus 10, and the direction along which the filter accommodation groove 8111 is concave is opposite to the direction along which the connector accommodation groove 8101 is concave. Therefore, the filter accommodation groove 8111 and the connector accommodation groove 8101 are distributed in a staggered manner along the height direction X of the vehicle-mounted power supply apparatus 10. This improves utilization of space between the upper-layer PCB board 200 and the lower-layer PCB board 300.

In an implementation, the LVDC filter 6400 is also referred to as a low-voltage filter circuit 6400, and the filter accommodation groove 8111 is configured to accommodate an LVDC filter capacitor 6430 in the LVDC filter 6400 (as shown in FIG. 38 or FIG. 40).

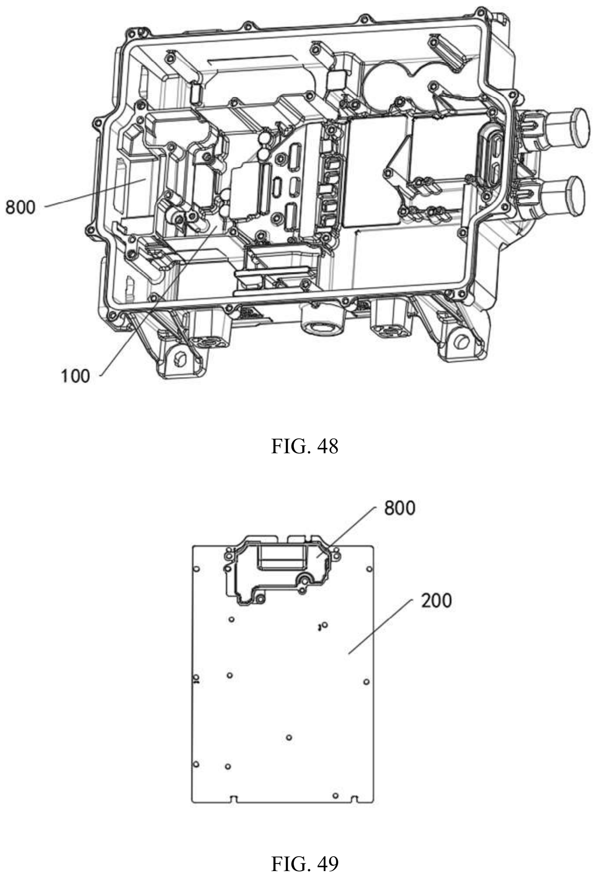

FIG. 48 is a diagram of a structure of a shield can 800 and a bottom housing 100 according to an implementation of this application. In an implementation, the shield can 800 is fastened to the bottom housing 100 by using a screw.

In this implementation, the shield can 800 is fastened to the bottom housing 100 by using a screw, so that the shield can 800 is fastened more tightly in the vehicle-mounted power supply apparatus 10. This helps the shield can 800 stably perform a shielding function.

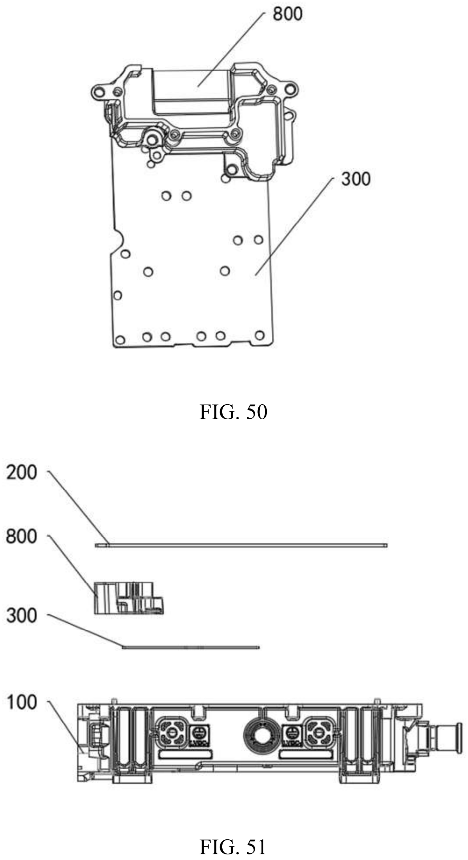

FIG. 49 is a diagram of a structure of a shield can 800 and an upper-layer PCB board 200. FIG. 50 is a diagram of a structure of a shield can 800 and a lower-layer PCB board 300. FIG. 51 is a partial exploded view of a vehicle-mounted power supply apparatus 10 according to an implementation of this application. In an implementation, the shield can 800 is fastened to both the upper-layer PCB board 200 and the lower-layer PCB board 300 by using screws (as shown in FIG. 49 and FIG. 50). The upper-layer PCB board 200, the shield can 800, the lower-layer PCB board 300, and a bottom housing 100 are stacked along a height direction X of the vehicle-mounted power supply apparatus 10 (as shown in FIG. 51).

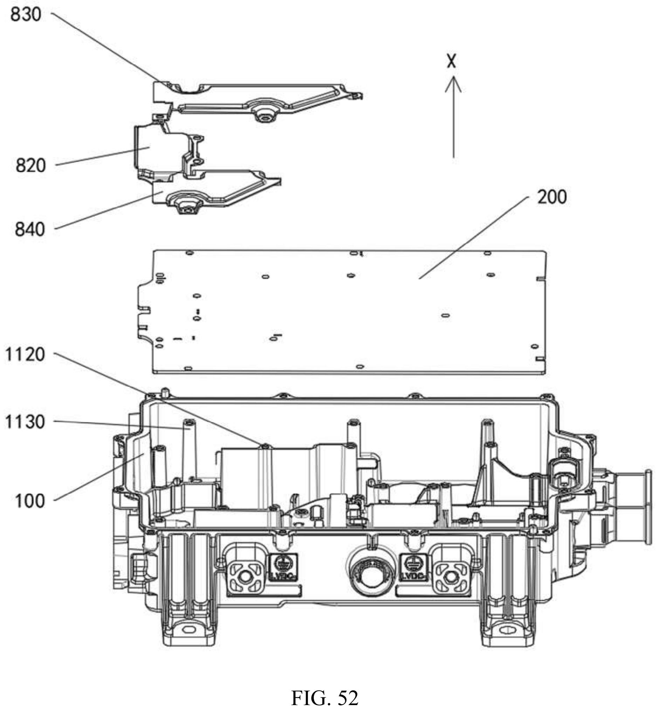

FIG. 52 is a diagram of a partial structure of a vehicle-mounted power supply apparatus 10 according to an implementation of this application. In an implementation, the vehicle-mounted power supply apparatus 10 further includes a signal filter shield can 820, an AC filter shield can 830, and an HVDC filter shield can 840 that are located above an upper-layer PCB board 200. The AC filter shield can 830 is configured to shield an alternating current filter circuit of a power conversion circuit 600. The HVDC filter shield can 840 is configured to shield a high-voltage filter circuit of the power conversion circuit 600. The signal filter shield can 820, the AC filter shield can 830, and the HVDC filter shield can 840 are fastened to a fastening protrusion 1130 and a shield protrusion 1120 of the bottom housing 100 through the upper-layer PCB board 200.

The alternating current filter circuit includes an AC filter 6100, and the AC filter 6100 is configured to filter out harmonics in an alternating current. The high-voltage filter circuit includes an HVDC filter 6210, and the HVDC filter 6210 is configured to filter out harmonics in a second direct current.

In this implementation, the signal filter shield can 820, the AC filter shield can 830, and the HVDC filter shield can 840 are configured to enhance shielding effect for a signal transmission circuit, the alternating current filter circuit, and the high-voltage filter circuit respectively. This helps improve signal transmission quality and reduce electrical interference to the power conversion circuit 600.

In this implementation, the signal filter shield can 820, the AC filter shield can 830, and the HVDC filter shield can 840 are all fastened to the bottom housing 100 through the upper-layer PCB board 200. For example, the AC filter shield can 830 is fastened by using screws. The screws sequentially pass through the AC filter shield can 830, the upper-layer PCB board 200, and the bottom housing 100 along a height direction X of the vehicle-mounted power supply apparatus 10, and are finally fastened to the fastening protrusion 1130 and the shield protrusion 1120.

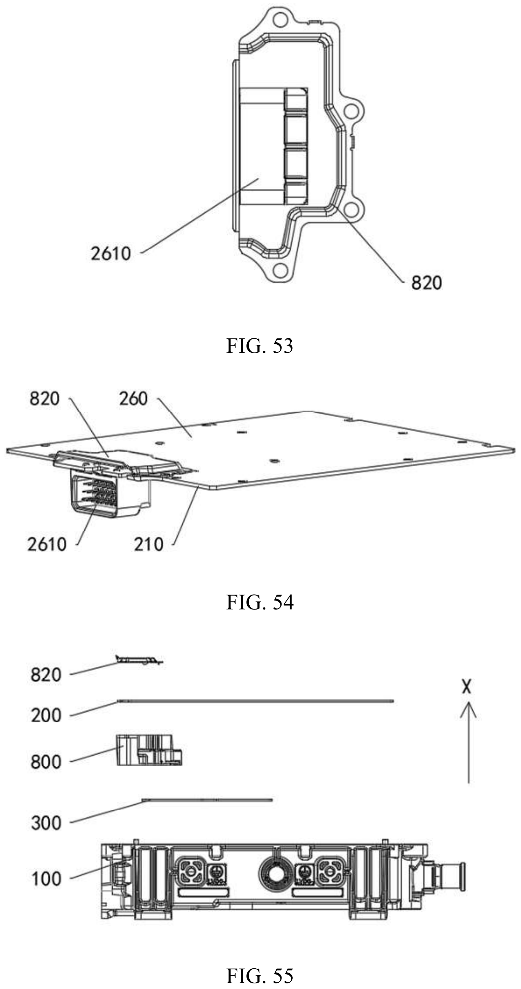

FIG. 53 is a diagram of a structure of a signal filter shield can 820 and a control signal connector 2610 according to an implementation of this application. In an implementation, an orthographic projection of the signal filter shield can 820 on an upper-layer PCB board 200 at least partially overlaps with an orthographic projection of the control signal connector 2610 on the upper-layer PCB board 200, so that the signal filter shield can 820 can effectively shield external electromagnetic interference.

FIG. 54 is a diagram of a partial structure of a vehicle-mounted power supply apparatus 10 according to an implementation of this application. FIG. 55 is a partial exploded view of a vehicle-mounted power supply apparatus 10 according to an implementation of this application. In this implementation, a signal filter shield can 820 is disposed close to an upper-layer front side edge 210 of an upper-layer PCB board 200, and the signal filter shield can 820 covers at least a part of a control signal connector 2610 along a height direction X. The signal filter shield can 820 and a shield can 800 are located on two sides of the control signal connector 2610 along the height direction X, and are configured to shield impact of different components on the control signal connector 2610. The signal filter shield can 820 is mainly configured to shield electrical interference caused by other components on the upper-layer PCB board 200. The shield can 800 is mainly configured to shield electrical interference caused by an LVDC filter 6400 on a lower-layer PCB board 300.

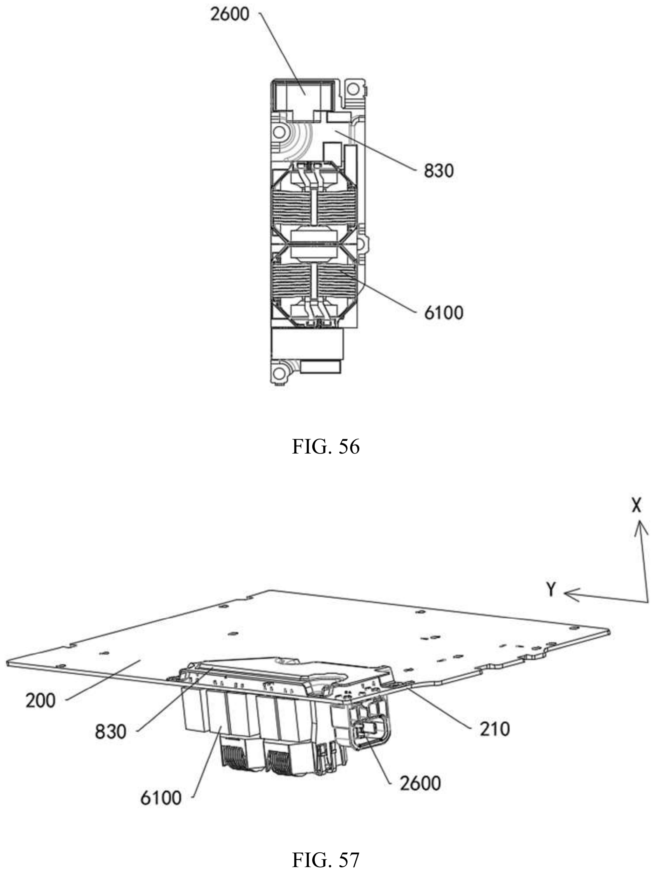

FIG. 56 is a diagram of a partial structure of a vehicle-mounted power supply apparatus 10 according to an implementation of this application. In an implementation, an orthographic projection of an AC filter shield can 830 on an upper-layer PCB board 200 at least partially overlaps with an orthographic projection of an AC filter 6100 on the upper-layer PCB board 200. In this implementation, the vehicle-mounted power supply apparatus 10 further includes a power connector 2600. The power connector 2600 is configured to plug-connect to a power interface 1310. The power connector 2600 is fastened to an upper-layer front side edge 210 of the upper-layer PCB board 200, and the power connector 2600 and the AC filter 6100 are sequentially arranged along a front-rear direction Y of the vehicle-mounted power supply apparatus 10. The power connector 2600 is electrically connected to an input end of the AC filter 6100. The AC filter shield can 830 covers at least a part of the power connector 2600 along a height direction X. In this solution, the AC filter shield can 830 is disposed to shield the AC filter 6100 and the power connector 2600, so that a shielding range that can be covered by the AC filter shield can 830 is expanded. This helps improve electromagnetic compatibility of a power conversion circuit 600 in the vehicle-mounted power supply apparatus 10.

The AC filter 6100 is an alternating current filter circuit of the power conversion circuit.

FIG. 57 is a diagram of a partial structure of a vehicle-mounted power supply apparatus 10 according to an implementation of this application. In this implementation, an AC filter shield can 830 is disposed close to an upper-layer front side edge 210 of an upper-layer PCB board 200, and the AC filter shield can 830 covers at least a part of an AC filter 6100 along a height direction X, to improve shielding effect of the AC filter shield can 830 for the AC filter 6100, and further improve electromagnetic compatibility of a power conversion circuit 600 in the vehicle-mounted power supply apparatus 10.

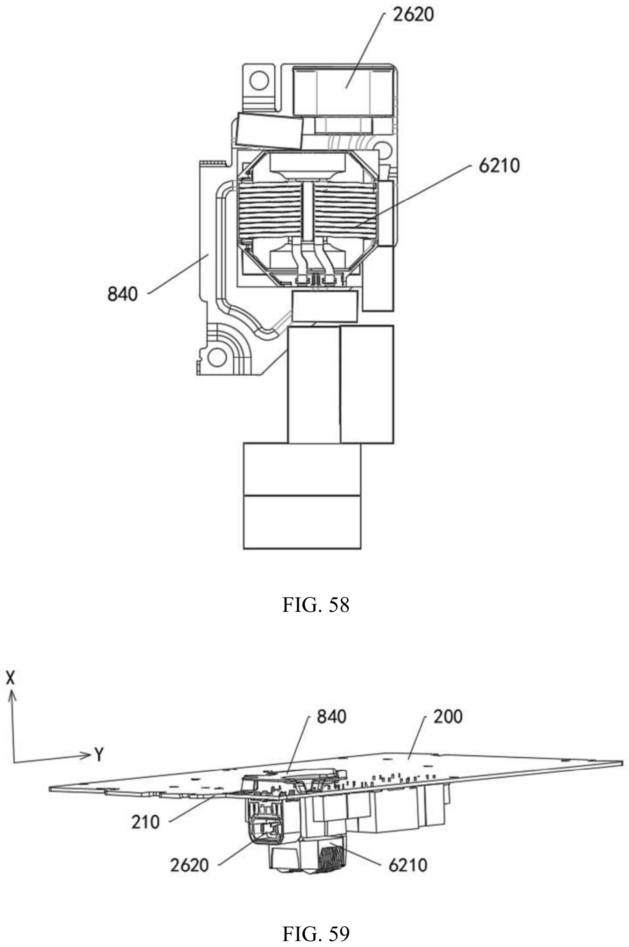

FIG. 58 is a diagram of a partial structure of a vehicle-mounted power supply apparatus 10 according to an implementation of this application. In an implementation, an orthographic projection of an HVDC filter shield can 840 on an upper-layer PCB board 200 at least partially overlaps with an orthographic projection of an HVDC filter 6210 on the upper-layer PCB board 200.

In this implementation, the vehicle-mounted power supply apparatus 10 further includes a second direct current connector 2620. The second direct current connector 2620 is configured to plug-connect to a second direct current interface 1330. The second direct current connector 2620 is fastened to an upper-layer front side edge 210 of the upper-layer PCB board 200, and the second direct current connector 2620 and the HVDC filter 6210 are sequentially arranged along a front-rear direction Y of the vehicle-mounted power supply apparatus 10. The second direct current connector 2620 is electrically connected to an input end of the HVDC filter 6210. The HVDC filter shield can 840 covers at least a part of the second direct current connector 2620 along a height direction X. In this solution, the HVDC filter shield can 840 is disposed to shield the HVDC filter 6210 and the second direct current connector 2620, so that a shielding range that can be covered by the HVDC filter shield can 840 is expanded. This helps improve electromagnetic compatibility of a power conversion circuit 600 in the vehicle-mounted power supply apparatus 10.

The HVDC filter 6210 is a high-voltage filter circuit of the power conversion circuit.

FIG. 59 is a diagram of a partial structure of a vehicle-mounted power supply apparatus 10 according to an implementation of this application. In this implementation, an HVDC filter shield can 840 is disposed close to an upper-layer front side edge 210 of an upper-layer PCB board 200, and the HVDC filter shield can 840 covers at least a part of an HVDC filter 6210 along a height direction X, to improve shielding effect of the HVDC filter shield can 840 for the HVDC filter 6210, and further improve electromagnetic compatibility of a power conversion circuit 600 in the vehicle-mounted power supply apparatus 10.

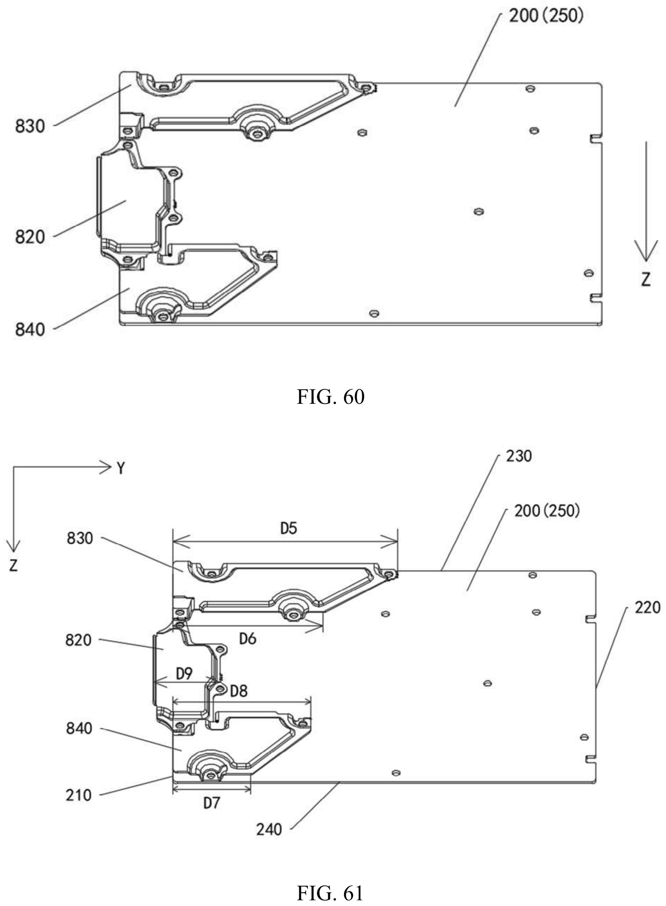

FIG. 60 is a diagram of a partial structure of a vehicle-mounted power supply apparatus 10 according to an implementation of this application. In an implementation, an AC filter shield can 830, a signal filter shield can 820, and an HVDC filter shield can 840 are arranged along a left-right direction Z of the vehicle-mounted power supply apparatus 10. Orthographic projections of the AC filter shield can 830 and the HVDC filter shield can 840 on an upper-layer PCB board 200 at least partially do not overlap with an orthographic projection of a lower-layer PCB board 300 on the upper-layer PCB board 200.

In this implementation, a manner in which the AC filter shield can 830, the signal filter shield can 820, and the HVDC filter shield can 840 are arranged on an upper surface 250 of the upper-layer PCB board 200 corresponds to a manner in which an AC filter 6100, a control signal connector 2610, and an HVDC filter 6210 are arranged on a lower surface 260 of the upper-layer PCB board 200, so that the AC filter shield can 830, the signal filter shield can 820, and the HVDC filter shield can 840 perform a shielding function.

In an implementation, orthographic projections of the AC filter shield can 830 and the HVDC filter shield can 840 on the upper-layer PCB board 200 completely do not overlap with an orthographic projection of the lower-layer PCB board 300 on the upper-layer PCB board 200, to improve shielding effect of the AC filter shield can 830 and the HVDC filter shield can 840 for the AC filter 6100 and the HVDC filter, and further improve electromagnetic compatibility of a power conversion circuit 600 in the vehicle-mounted power supply apparatus 10.

FIG. 61 is a diagram of a partial structure of a vehicle-mounted power supply apparatus 10 according to an implementation of this application. In an implementation, an AC filter shield can 830 is close to an upper-layer left side edge 230 along a left-right direction Z and is close to an upper-layer front side edge 210 along a front-rear direction Y. A length, along the front-rear direction Y, of an end of the AC filter shield can 830 that is close to the upper-layer left side edge 230 is greater than a length, along the front-rear direction Y, of an end of the AC filter shield can 830 that is away from the upper-layer left side edge 230.

In this implementation, the length, along the front-rear direction Y, of the end of the AC filter shield can 830 that is close to the upper-layer left side edge 230 is D5, and the length, along the front-rear direction Y, of the end of the AC filter shield can 830 that is away from the upper-layer left side edge 230 is D6. In this solution, D5 is set to be greater than D6. In this way, in one aspect, the end of the AC filter shield can 830 that is close to the upper-layer left side edge 230 can cover a large part of an AC filter 6100. This helps reduce costs of the AC filter shield can 830. In another aspect, because the AC filter shield can 830 needs to be fastened to a bottom housing 100 through an upper-layer PCB board 200, D5 and D6 need to be set to ensure that a position at which the AC filter shield can 830 is fastened to the upper-layer PCB board 200 is not blocked by other components or a lower-layer PCB board 300. If D5 is set to be equal to D6, there is insufficient space on the upper-layer PCB board 200 for fastening the end of the AC filter shield can 830 that is away from the upper-layer left side edge 230. Therefore, in this solution, D5 is set to be greater than D6. This helps reduce mounting difficulty of the AC filter shield can 830.

Further, refer to FIG. 61. In an implementation, an HVDC filter shield can 840 is close to an upper-layer right side edge 240 along a left-right direction Z of the vehicle-mounted power supply apparatus 10 and is close to the upper-layer front side edge 210 along the front-rear direction Y. A length, along the front-rear direction Y, of an end of the HVDC filter shield can 840 that is close to the upper-layer right side edge 240 is less than a length, along the front-rear direction Y, of an end of the HVDC filter shield can 840 that is away from the upper-layer right side edge 240.

In this implementation, the length, along the front-rear direction Y, of the end of the HVDC filter shield can 840 that is close to the upper-layer right side edge 240 is D7, and the length, along the front-rear direction Y, of the end of the HVDC filter shield can 840 that is away from the upper-layer right side edge 240 is D8. In this solution, D7 is set to be less than D8. In this way, in one aspect, the end of the HVDC filter shield can 840 that is away from the upper-layer right side edge 240 can cover a large part of an HVDC filter 6210. This helps reduce costs of the HVDC filter shield can 840. In another aspect, because the HVDC filter shield can 840 needs to be fastened to the bottom housing 100 through the upper-layer PCB board 200, D7 and D8 need to be set to ensure that a position at which the HVDC filter shield can 840 is fastened to the upper-layer PCB board 200 is not blocked by other components or the lower-layer PCB board 300. If D3 is set to be equal to D4, there is insufficient space on the upper-layer PCB board 200 for fastening the end of the HVDC filter shield can 840 that is close to the upper-layer right side edge 240. Therefore, in this solution, D7 is set to be greater than D8. This helps reduce mounting difficulty of the HVDC filter shield can 840.

Further, refer to FIG. 61. In an implementation, a length of a signal filter shield can 820 along the front-rear direction Y of the vehicle-mounted power supply apparatus 10 is less than the length, along the front-rear direction Y, of the end of the AC filter shield can 830 that is away from the upper-layer left side edge 230; or the length of the signal filter shield can 820 along the front-rear direction Y is less than the length, along the front-rear direction Y, of the end of the HVDC filter shield can 840 that is close to the upper-layer right side edge 240.

In this implementation, the length of the signal filter shield can 820 along the front-rear direction Y is D9. D6 is set to be less than D9, or D7 is set to be less than D9. This reduces manufacturing costs of the signal filter shield can 820 and a mounting area occupied by the signal filter shield can 820 on the upper-layer PCB board 200 while ensuring that the signal filter shield can 820 can perform a shielding function for a control signal connector 2610. This facilitates a miniaturization design of the vehicle-mounted power supply apparatus 10.

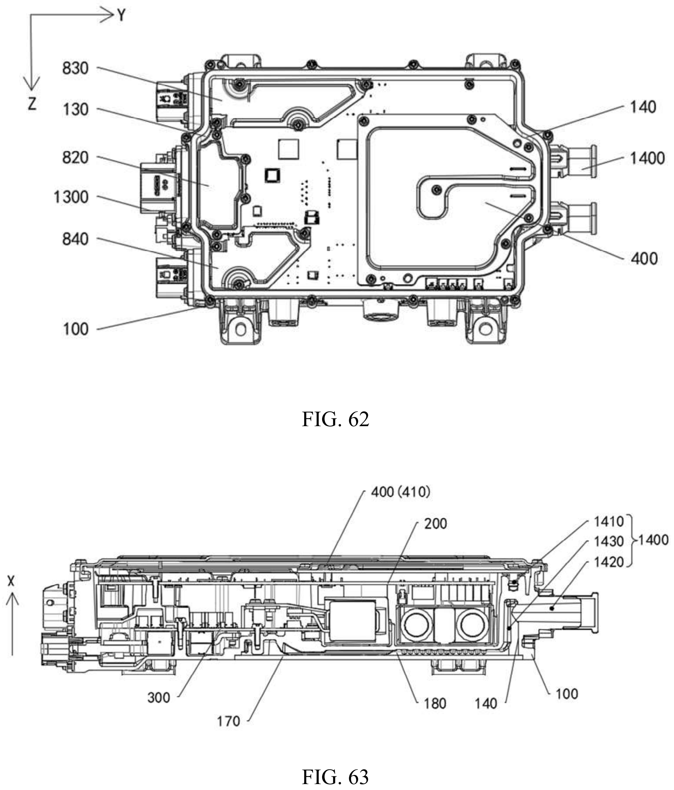

FIG. 62 is a diagram of a partial structure of a vehicle-mounted power supply apparatus 10 according to an implementation of this application. In an implementation, an AC filter shield can 830, a signal filter shield can 820, and an HVDC filter shield can 840 are aligned with a side wall that is in a bottom housing 100 and on which an electrical interface 1300 is disposed, a heat dissipator 400 communicates with a cooling channel interface 1400 of the bottom housing 100, and the side wall on which the electrical interface 1300 is located is arranged opposite to a side wall on which the cooling channel interface 1400 is located.

In this implementation, the electrical interface 1300 is disposed on a front side wall 130 of the vehicle-mounted power supply apparatus 10, and the AC filter shield can 830, the signal filter shield can 820, and the HVDC filter shield can 840 are all disposed close to the front side wall 130 along a front-rear direction Y. This facilitates electrical shielding for a part of a power conversion circuit 600 that is electrically connected to the electrical interface 1300. The cooling channel interface 1400 is disposed on a rear side wall 140 of the vehicle-mounted power supply apparatus 10, and the heat dissipator 400 is disposed close to the rear side wall 140 along the front-rear direction Y. This helps shorten a distance at which a coolant enters the heat dissipator 400 from an external cooling system, and improve cooling effect of the coolant in the vehicle-mounted power supply apparatus 10. The electrical interface 1300 is disposed opposite to the cooling channel interface 1400. Because the electrical interface 1300 and the cooling channel interface 1400 are isolated in physical space, the coolant can be prevented from leaking from the cooling channel interface 1400 and affecting electrical performance of the electrical interface 1300. This helps improve safety performance of the vehicle-mounted power supply apparatus 10.

In some other implementations, the electrical interface 1300 may be disposed on another side wall of the bottom housing 100, provided that it is ensured that the electrical interface 1300 and the cooling channel interface 1400 are disposed on different side walls.

Refer to FIG. 13 and FIG. 63. FIG. 63 is a cross-sectional view of a vehicle-mounted power supply apparatus 10 according to an implementation of this application. In an implementation, the bottom housing 100 includes the base plate 170 and four side walls, the lower-layer PCB board 300 and the plurality of transformers 650 are fastened to the base plate 170, and the heat dissipator 400 and the upper-layer PCB board 200 are sequentially stacked above the lower-layer PCB board 300 and the plurality of transformers 650 (as shown in FIG. 13). The heat dissipator 400 includes an upper-layer cooling channel 410 (as shown in FIG. 63). The bottom housing 100 includes a lower-layer cooling channel 180. The upper-layer cooling channel 410 communicates with the lower-layer cooling channel 180 of the bottom housing 100 through a side wall.

In this implementation, power switching transistors 660 and the transformers 650 are heat generating components in a power conversion circuit 600. The power switching transistors 660 are distributed on an upper surface 250 of the upper-layer PCB board 200 and an upper surface 350 of the lower-layer PCB board 300. The plurality of transformers 650 are fastened between a lower surface 260 of the upper-layer PCB board 200 and the bottom housing 100. The upper-layer cooling channel 410 of the heat dissipator 400 is arranged close to the upper surface 250 of the upper-layer PCB board 200. The lower-layer cooling channel 180 of the bottom housing 100 is arranged close to the lower-layer PCB board 300 and the plurality of transformers 650. When the vehicle-mounted power supply apparatus 10 communicates with an external cooling system, a coolant enters the upper-layer cooling channel 410 and the lower-layer cooling channel 180. Heat generated by components at different positions in the vehicle-mounted power supply apparatus 10 can be taken away by the coolant. The upper-layer cooling channel 410 and the lower-layer cooling channel 180 cooperate with each other. This helps improve cooling effect.

In this implementation, the bottom housing 100 includes four side walls: a front side wall 130, a rear side wall 140, a left side wall 150, and a right side wall 160. The rear side wall 140 is located between the upper-layer cooling channel 410 and the lower-layer cooling channel 180 along a height direction X of the vehicle-mounted power supply apparatus 10, and both the upper-layer cooling channel 410 and the lower-layer cooling channel 180 are arranged close to the rear side wall 140 of the bottom housing 100. There is no blocking between the upper-layer cooling channel 410 and the lower-layer cooling channel 180. Therefore, when the coolant flows in the vehicle-mounted power supply apparatus 10, resistance is small, a flow rate is high, and a flow volume is large. This can accelerate heat dissipation for heat generating components, and helps improve cooling effect of the coolant for the vehicle-mounted power supply apparatus 10. In some other implementations, the upper-layer cooling channel 410 and the lower-layer cooling channel 180 may alternatively communicate with each other through another side wall of the bottom housing 100.

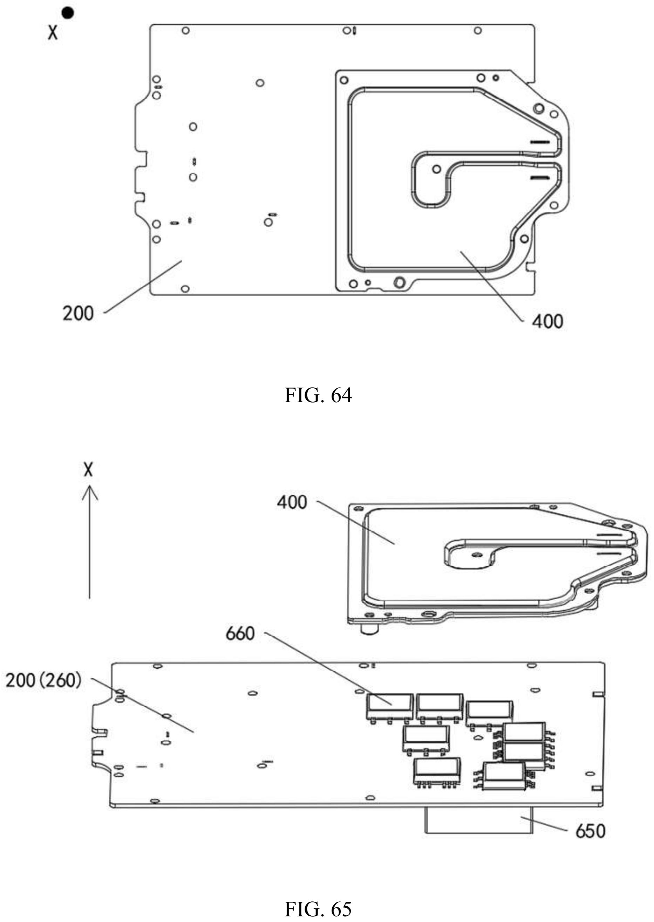

FIG. 64 is a diagram of a structure of an upper-layer PCB board 200 and a heat dissipator 400 according to an implementation of this application. FIG. 65 is a diagram of a partial structure of a vehicle-mounted power supply apparatus 10 according to an implementation of this application. In an implementation, an area of an orthographic projection of the heat dissipator 400 on the upper-layer PCB board 200 is less than an area of the upper-layer PCB board 200 (as shown in FIG. 64). The orthographic projection of the heat dissipator 400 covers a plurality of transformers 650 and a plurality of power switching transistors 660 carried on the upper-layer PCB board 200 (as shown in FIG. 65).

In this implementation, both a cross section of the heat dissipator 400 and a board surface of the upper-layer PCB board 200 are perpendicular to a height direction X of the vehicle-mounted power supply apparatus 10. The heat dissipator 400 does not occupy a large area on the upper-layer PCB board 200. In this way, in one aspect, an upper surface 250 of the upper-layer PCB board 200 has more space for mounting other components, so that utilization of internal space of the vehicle-mounted power supply apparatus 10 is improved. In another aspect, the heat dissipator 400 can be flexibly arranged on the upper-layer PCB board 200 based on positions of heat generating components, to effectively dissipate heat for the heat generating components. This improves local heat dissipation effect, and helps reduce manufacturing costs of the heat dissipator 400.

In this implementation, the power switching transistors 660 are one of main heat sources of a power conversion circuit 600. The heat dissipator 400 covers an outer side of the power switching transistors 660 along the height direction X of the vehicle-mounted power supply apparatus 10. When a coolant enters the heat dissipator 400, the coolant can take away heat generated by the power switching transistors 660. This lowers temperature of the power switching transistors 660 in a stable operating state, and implements temperature control on the vehicle-mounted power supply apparatus 10.

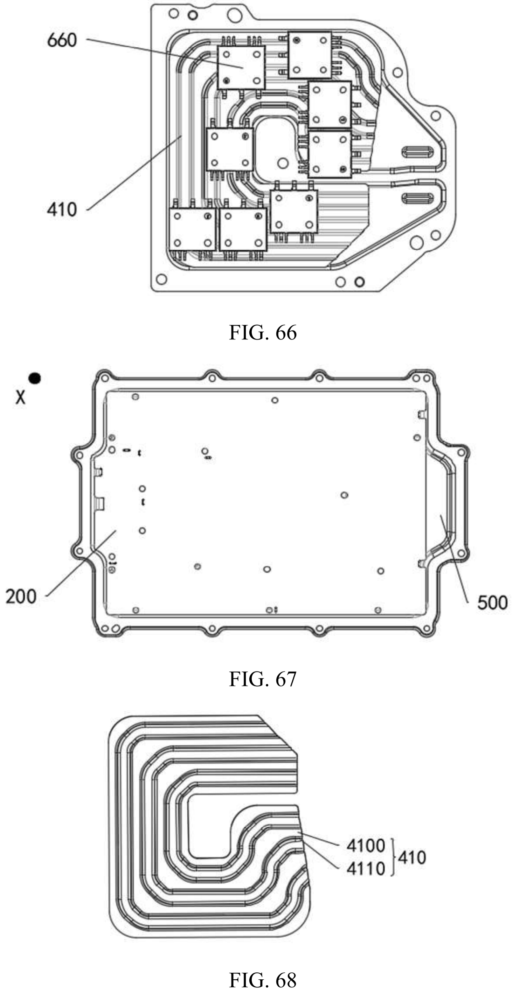

FIG. 66 is a diagram of a structure of an upper-layer cooling channel 410 and power switching transistors 660 according to an implementation of this application. In an implementation, an orthographic projection of the upper-layer cooling channel 410 of a heat dissipator 400 on an upper-layer PCB board 200 covers the plurality of power switching transistors 660.

In this implementation, the heat dissipator 400 mainly implements cooling effect through the upper-layer cooling channel 410 in the heat dissipator 400. Both the upper-layer cooling channel 410 and the power switching transistors 660 are located on an upper surface 250 of the upper-layer PCB board 200, and the orthographic projection of the upper-layer cooling channel 410 on the upper-layer PCB board 200 covers all of the power switching transistors 660. In this way, a coolant can cool and dissipate heat for all of the power switching transistors 660 when flowing through the upper-layer cooling channel 410. This improves cooling efficiency for the heat dissipator 400. Refer to FIG. 3 and FIG. 67. FIG. 67 is a diagram of a structure of a cover 500 and an upper-layer PCB board 200 according to an implementation of this application. In an implementation, the vehicle-mounted power supply apparatus 10 includes the cover 500 (as shown in FIG. 3). An area of the cover 500 is greater than an area of the upper-layer PCB board 200 (as shown in FIG. 67). A gap between the cover 500 and the upper-layer PCB board 200 is used to accommodate the heat dissipator 400 (as shown in FIG. 3).

The area of the cover 500 is an area of a surface, facing the upper-layer PCB board 200, of the cover 500. The area of the upper-layer PCB board 200 is an area of a board surface of the upper-layer PCB board 200 and is an area of one surface of the board surface of the upper-layer PCB board 200, for example, an upper surface or a lower surface of the board surface of the upper-layer PCB board 200. The area of the board surface of the lower-layer PCB board 300 in the foregoing descriptions is an area of an upper surface or a lower surface of the board surface of the lower-layer PCB board 300. An area of the upper surface is usually the same as an area of the lower surface.

In this implementation, the cover 500 is located on a side, away from the bottom housing 100 along the height direction X of the vehicle-mounted power supply apparatus 10, of the upper-layer PCB board 200. The cover 500 can completely cover the upper-layer PCB board 200, so that the cover 500 can be fastened to the bottom housing 100 on an outer side of the upper-layer PCB board 200, to form an accommodation cavity and protect the power conversion circuit 600 from being affected by an external environment. The heat dissipator 400 is located in a gap between the cover 500 and the upper-layer PCB board 200. Even if a coolant leaks from the heat dissipator 400, the leaked coolant does not flow out of the vehicle-mounted power supply apparatus 10 due to blocking by the cover 500. This reduces impact of the coolant leakage on the entire vehicle. FIG. 68 is a diagram of a structure of an upper-layer cooling channel 410 according to an implementation of this application. In an implementation, the upper-layer cooling channel 410 includes an upper-layer cooling channel body 4100 and an upper-layer flow disturbing member 4110. The upper-layer flow disturbing member 4110 is fastened in the upper-layer cooling channel body 4100 to disturb a cooling medium in the upper-layer cooling channel body 4100.

In this implementation, the upper-layer flow disturbing member 4110 performs a flow disturbing function for a coolant that enters the upper-layer cooling channel body 4100. This helps enhance convective heat exchange. In addition, the upper-layer flow disturbing member 4110 can further buffer impact of the coolant toward a specific direction to improve heat dissipation effect. In this implementation, a largest surface of the upper-layer flow disturbing member 4110 is perpendicular to a surface of the upper-layer cooling channel body 4100. In some other implementations, an included angle between the largest surface of the upper-layer flow disturbing member 4110 and the surface of the upper-layer cooling channel body 4100 may be less than 90°.

In an implementation, the upper-layer flow disturbing member 4110 and the upper-layer cooling channel body 4100 are an integrated structure. In this implementation, the upper-layer cooling channel 410 is formed through die casting on a sheet metal part. A convex part is the upper-layer flow disturbing member 4110, and a concave part is the upper-layer cooling channel body 4100.

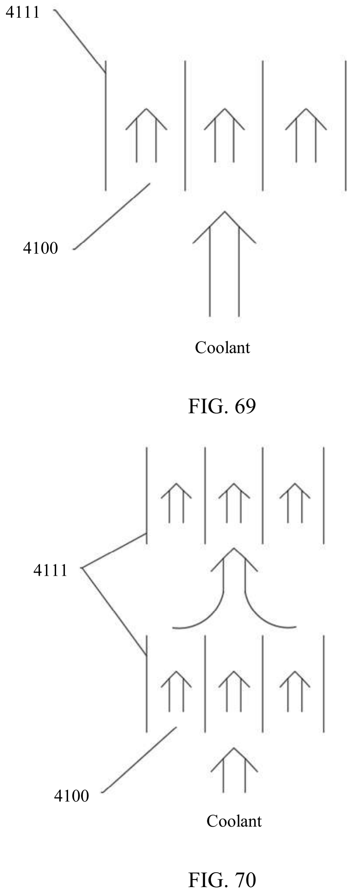

FIG. 69 is a diagram of a structure of an upper-layer cooling channel 410 according to an implementation of this application. In an implementation, an upper-layer flow disturbing member 4110 includes a plurality of flow disturbing sections 4111, and at least some of the plurality of flow disturbing sections 4111 are disposed side by side at spacings.

In this implementation, the flow disturbing sections 4111 are spaced away, and gaps between every two side-by-side flow disturbing sections 4111 form flow channels that are independent of each other. A coolant entering the upper-layer cooling channel 410 is divided into a plurality of tributaries by the flow disturbing sections 4111. The plurality of tributaries flow in the flow channels that are independent of each other, and exchange heat with a plurality of power switching transistors 660. In this solution, the flow disturbing sections 4111 are arranged in the upper-layer flow disturbing member 4110, so that an area of contact between the coolant and the upper-layer cooling channel 410 increases.

FIG. 70 is a diagram of a structure of an upper-layer cooling channel 410 according to an implementation of this application. In an implementation, an upper-layer flow disturbing member 4110 includes a plurality of flow disturbing sections 4111, and at least some of the plurality of flow disturbing sections 4111 are spaced away along an extension direction of the flow disturbing sections 4111.

In this implementation, some flow disturbing sections 4111 are spaced away along an extension direction of the flow disturbing sections 4111 and are arranged side by side with other flow disturbing sections 4111 at spacings. Gaps along the extension direction of the flow disturbing sections 4111 divide the upper-layer cooling channel 410 into flow channels that communicate with each other. Gaps between side-by-side flow disturbing sections 4111 divide the upper-layer cooling channel 410 into flow channels that are independent of each other. A coolant entering the flow channels that are independent of each other is divided into a plurality of tributaries. The plurality of tributaries converge into a coolant when flowing through the gaps along the extension direction of the flow disturbing sections 4111, and then the coolant enters the flow channels that are independent of each other again. In this case, when flowing through gaps between flow disturbing sections 4111, the coolant may flow to a gap between any two adjacent flow disturbing sections 4111, so that flow channels of the coolant in the upper-layer cooling channel 410 communicate with each other. This helps reduce flow resistance of the coolant and improve heat dissipation efficiency.

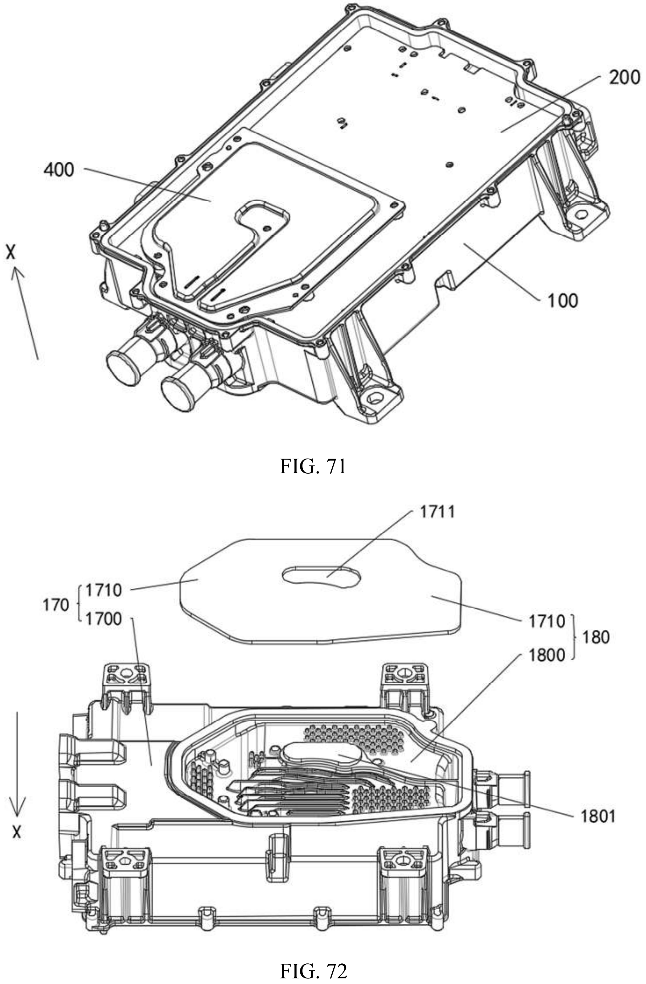

FIG. 71 is a diagram of a partial structure of a vehicle-mounted power supply apparatus 10 according to an implementation of this application. In an implementation, an upper-layer PCB board 200 is fastened to a heat dissipator 400, and the heat dissipator 400 is fastened to a bottom housing 100 through the upper-layer PCB board 200.

In this implementation, the heat dissipator 400, the upper-layer PCB board 200, and the bottom housing 100 are sequentially arranged along a height direction X of the vehicle-mounted power supply apparatus 10, and the heat dissipator 400, the upper-layer PCB board 200, and the bottom housing 100 are fastened by using screws, so that the heat dissipator 400 is not easily subject to interference from an external force when cooling and dissipating heat for power switching transistors 660. This improves overall stability of the vehicle-mounted power supply apparatus 10. FIG. 72 is a diagram of a partial structure of a vehicle-mounted power supply apparatus 10 according to an implementation of this application. In an implementation, a base plate 170 includes a base plate body 1700 and a sealing plate 1710 located on an outer side of the base plate body 1700. A lower-layer cooling channel body 1800 is disposed on the outer side of the base plate body 1700. The sealing plate 1710 and the lower-layer cooling channel body 1800 are in a sealed connection and jointly form a lower-layer cooling channel 180.

In this implementation, the lower-layer cooling channel body 1800 and the base plate body 1700 are disposed back to back, and the outer side of the base plate body 1700 is a side away from a lower-layer PCB board 300 and an upper-layer PCB board 200 along a height direction X of the vehicle-mounted power supply apparatus 10. In this solution, the sealing plate 1710 is disposed in the base plate 170. In one aspect, the sealing plate 1710 is configured to form the lower-layer cooling channel 180 together with the lower-layer cooling channel body 1800. In another aspect, the sealing plate 1710 can prevent coolant leakage, so that a coolant entering the lower-layer cooling channel body 1800 can cool and dissipate heat for a heat generating component disposed close to the base plate body 1700 without affecting normal operation of the heat generating component.

In an implementation, the lower-layer cooling channel body 1800 includes a sealing plate mounting portion 1801, the sealing plate 1710 is provided with a sealing plate mounting hole 1711 that penetrates two end faces along the height direction X of the vehicle-mounted power supply apparatus 10, and an edge shape of the sealing plate 1710 matches an edge shape of the lower-layer cooling channel body 1800. When the sealing plate mounting portion 1801 passes through the sealing plate mounting hole 1711, the sealed connection between the sealing plate 1710 and the lower-layer cooling channel body 1800 is implemented.

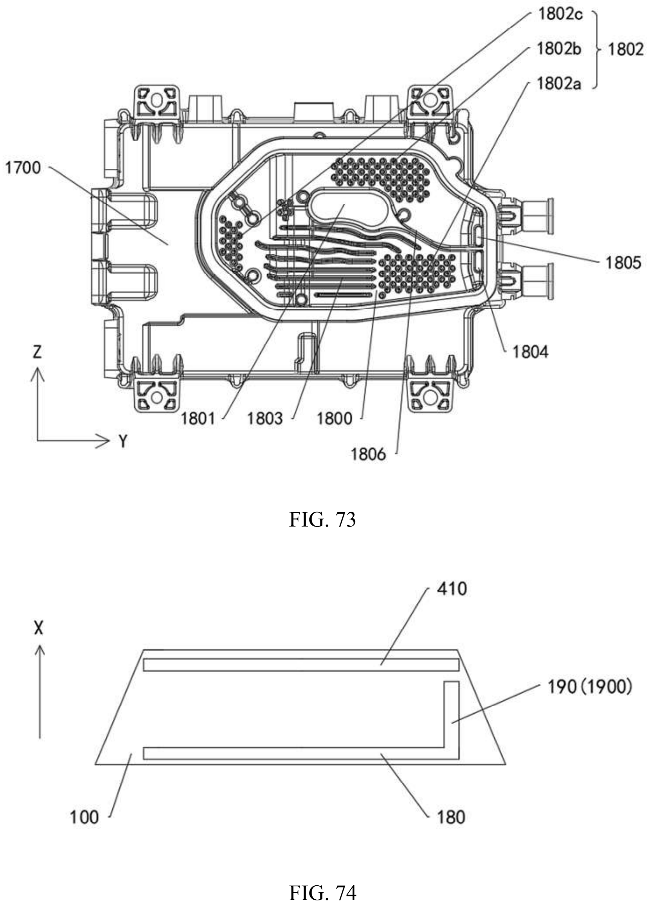

FIG. 73 is a diagram of a partial structure of a vehicle-mounted power supply apparatus 10 according to an implementation of this application. In an implementation, at least one group of flow disturbing teeth 1802 and at least one group of flow disturbing plates 1803 are disposed in a lower-layer cooling channel body 1800. Each group of flow disturbing teeth 1802 includes a plurality of flow disturbing teeth 1802 that are spaced away. Each group of flow disturbing plates 1803 includes a plurality of flow disturbing plates 1803 that are disposed side by side at spacings. In this implementation, when a coolant enters the lower-layer cooling channel body 1800, outer surfaces of the flow disturbing teeth 1802 and the flow disturbing plates 1803 are in contact with the coolant. In this solution, the flow disturbing teeth 1802 and the flow disturbing plates 1803 are disposed, to increase an area of contact between the coolant and the lower-layer cooling channel body 1800 and enhance turbulence of the coolant. Gaps between the plurality of flow disturbing plates 1803 form flow channels, gaps between the plurality of flow disturbing teeth 1802 form flow channels, and the coolant may flow to a gap between any two adjacent flow disturbing teeth 1802 when flowing through the gaps between the plurality of flow disturbing teeth 1802. This helps reduce flow resistance of the coolant and improve heat dissipation efficiency.

In an implementation, the lower-layer cooling channel body 1800 includes a lower-layer channel inlet 1804 and a lower-layer channel outlet 1805. The lower-layer channel inlet 1804 and the lower-layer channel outlet 1805 are arranged along a left-right direction Z of the vehicle-mounted power supply apparatus 10. The lower-layer cooling channel body 1800 includes three groups of flow disturbing teeth 1802 and one group of flow disturbing plates 1803. The three groups of flow disturbing teeth 1802 are denoted as flow disturbing teeth 1802a, flow disturbing teeth 1802b, and flow disturbing teeth 1802c respectively. The flow disturbing teeth 1802a and the flow disturbing teeth 1802b are disposed close to the lower-layer channel inlet 1804 and the lower-layer channel outlet 1805 respectively and are arranged along the left-right direction Z of the vehicle-mounted power supply apparatus 10. The flow disturbing teeth 1802c are located on a side, away from the lower-layer channel inlet 1804, of the lower-layer cooling channel body 1800. The flow disturbing teeth 1802c, the group of flow disturbing plates 1803, and the flow disturbing teeth 1802a are arranged along a front-rear direction Y of the vehicle-mounted power supply apparatus 10. In this implementation, the coolant enters the lower-layer cooling channel body 1800 from the lower-layer channel inlet 1804 and flows out from the lower-layer channel outlet 1805. When entering and flowing out of the lower-layer cooling channel body 1800, the coolant is in contact with the plurality of flow disturbing teeth 1802 and the plurality of flow disturbing plates 1803. When heat is transferred from a heat generating component to the lower-layer cooling channel body 1800, a cooling medium between the plurality of flow disturbing teeth 1802 and a cooling medium between the plurality of flow disturbing plates 1803 exchange heat with the heat generating component, so that a power conversion circuit 600 can operate within a proper temperature range. In an implementation, both the flow disturbing teeth 1802 and the flow disturbing plates 1803 are integrated with a base plate 170. When the flow disturbing teeth 1802 and the flow disturbing plates 1803 are subject to an external force (for example, a force applied by the coolant), positions of the flow disturbing teeth 1802 and the flow disturbing plates 1803 do not change. This solution helps enhance structural strength of the flow disturbing teeth 1802 and the flow disturbing plates 1803.

In an implementation, the lower-layer cooling channel body 1800 further includes a flow isolation section 1806. The flow isolation section 1806 is configured to isolate a part of a lower-layer cooling channel 180 that is close to the lower-layer channel inlet 1804 from a part of the lower-layer cooling channel 180 that is close to the lower-layer channel outlet 1805. One end of the flow isolation section 1806 is located between the lower-layer channel inlet 1804 and the lower-layer channel outlet 1805, and the other end of the flow isolation section 1806 is integrated with a sealing plate mounting portion 1801. The flow disturbing teeth 1802a and flow disturbing sections 4111, and the flow disturbing teeth 1802b are respectively located on two sides of the flow isolation section 1806 along the left-right direction Z of the vehicle-mounted power supply apparatus 10. It can be understood that temperature of a coolant that is to flow out of the lower-layer cooling channel body 1800 is higher than temperature of a coolant that enters the lower-layer cooling channel body 1800 from the lower-layer channel inlet 1804. In this solution, the flow isolation section 1806 is disposed in the lower-layer cooling channel body 1800. This helps improve heat dissipation efficiency of the coolant in the lower-layer cooling channel 180.

In an implementation, the lower-layer cooling channel body 1800 and a base plate body 1700 are an integrated structure.

In this implementation, the lower-layer cooling channel body 1800 remains fastened to the base plate body 1700, so that the lower-layer cooling channel body 1800 also remains fastened relative to components fastened to a bottom housing 100. When the lower-layer cooling channel 180 is subject to an external force (for example, a force applied by the coolant), a position of the lower-layer cooling channel 180 can remain unchanged. This solution helps enhance structural strength of the lower-layer cooling channel body 1800, enables the lower-layer cooling channel body 1800 to stably cool and dissipate heat for heat generating components, and avoids impact of an external environment on the lower-layer cooling channel body 1800.

Refer to FIG. 63 and FIG. 72. In an implementation, an area of a cross section of the lower-layer cooling channel 180 is less than an area of a plate surface of the base plate 170 (as shown in FIG. 72), and both the cross section of the lower-layer cooling channel 180 and the plate surface of the base plate 170 are perpendicular to the height direction X of the vehicle-mounted power supply apparatus 10 (as shown in FIG. 63).

In this implementation, the plate surface of the base plate 170, the upper-layer cooling channel 410, and the cross section of the lower-layer cooling channel 180 are all perpendicular to the height direction X of the vehicle-mounted power supply apparatus 10. The lower-layer cooling channel 180 does not occupy a large area on the base plate 170. The lower-layer cooling channel 180 may be flexibly arranged on the lower-layer PCB board 300 based on positions of heat generating components, to effectively dissipate heat for the heat generating components. This improves local heat dissipation effect, and helps reduce manufacturing costs of the lower-layer cooling channel 180.

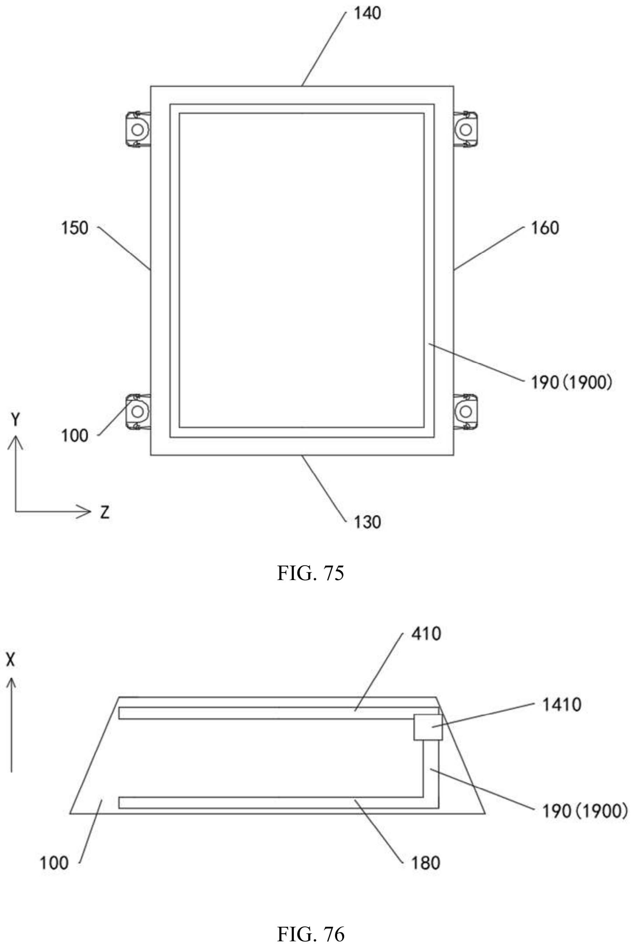

FIG. 74 is a diagram of a partial structure of a vehicle-mounted power supply apparatus 10 according to an implementation of this application. FIG. 75 is a diagram of a partial structure of a vehicle-mounted power supply apparatus 10 according to an implementation of this application. In an implementation, a bottom housing 100 further includes a side frame 190 surrounding a periphery of a base plate 170 (as shown in FIG. 74), and a side cooling channel 1900 is provided in the side frame 190 (as shown in FIG. 74).

In this implementation, the side frame 190 is integrally ring-shaped and has two openings along a height direction X of the vehicle-mounted power supply apparatus 10, an edge of one of the openings is fastened to an upper surface of the base plate 170, and the side frame 190 and the base plate 170 are groove-shaped. A left side wall 150, a right side wall 160, a front side wall 130, and a rear side wall 140 of the vehicle-mounted power supply apparatus 10 form the side frame 190. The side cooling channel 1900 is provided in the side frame 190. The side cooling channel 1900 is located on any one, two, three, or four of the left side wall 150, the right side wall 160, the front side wall 130, and the rear side wall 140 (as shown in FIG. 75). The side cooling channel 1900 surrounds some or all of peripheries of a power conversion circuit 600. A coolant flowing into the side cooling channel 1900 can cool and dissipate heat for heat generating components in the power conversion circuit 600 along a front-rear direction Y and a left-right direction Z of the vehicle-mounted power supply apparatus 10.

In an implementation, the side frame 190 and the base plate 170 are an integrated structure. The side frame 190 remains fastened to the base plate 170, so that the side cooling channel 1900 in the side frame 190 also remains fastened relative to the power conversion circuit 600. When a lower-layer cooling channel 180 is subject to an external force (for example, a force applied by the coolant), a position of the lower-layer cooling channel 180 can remain unchanged, and the side cooling channel 1900 can stably dissipate heat for the heat generating components. This avoids impact of an external environment on the side cooling channel 1900.

In an implementation, the side cooling channel 1900 includes at least one of a side flow disturbing plate and a side flow disturbing tooth. In this solution, the side flow disturbing plate and the side flow disturbing tooth are disposed. This helps increase an area of contact between the coolant and the side cooling channel 1900 and improve cooling efficiency.

In an implementation, a part of the side frame 190 is in a sealed connection to the base plate 170, and the side cooling channel 1900 in the side frame 190 communicates with the lower-layer cooling channel 180. This solution helps form a three-dimensional water channel in the vehicle-mounted power supply apparatus 10, so that the coolant can dissipate heat for different parts of a heat generating component.

Refer to FIG. 27 and FIG. 63. In an implementation, the power conversion circuit 600 includes the PFC inductor 6120, the PFC capacitor 6110, and two transformers (as shown in FIG. 27), the lower-layer cooling channel 180 and the bottom housing 100 are an integrated structure, and the PFC inductor 6120, the PFC capacitor 6110, and the two transformers are in contact with the bottom of the bottom housing 100 through a thermally conductive material and are tiled above the lower-layer cooling channel 180 and below the upper-layer PCB board 200 (as shown in FIG. 27 and FIG. 63).

The two transformers are the LLC transformer 6200 and the low-voltage transformer 6310. The capacitor, the inductor, and the transformers in the power conversion circuit 600 generate heat in an operating state. A cooling channel needs to be provided for the heat generating components. In this implementation, one end of each of the PFC inductor 6120, the PFC capacitor 6110, the LLC transformer 6200, and the low-voltage transformer 6310 is arranged back to back with the upper-layer cooling channel 410. When cooling power switching transistors, the upper-layer cooling channel 410 also provides specific heat dissipation effect for the heat generating components. The other end of each of the PFC inductor 6120, the PFC capacitor 6110, the LLC transformer 6200, and the low-voltage transformer 6310 is in contact with the lower-layer cooling channel 180 through a thermally conductive material. A part of heat generated by the heat generating components is transferred to a coolant in the lower-layer cooling channel 180 through the thermally conductive material. The upper-layer cooling channel 410 and the lower-layer cooling channel 180 cool the heat generating components from two sides along the height direction X of the vehicle-mounted power supply apparatus 10. This helps enhance heat dissipation effect. The thermally conductive material includes but is not limited to thermally conductive silicone grease, a thermal silicone sheet, thermal gel, and the like.

Further, refer to FIG. 63. The heat dissipator 400 includes the upper-layer cooling channel 410, the bottom housing 100 includes the lower-layer cooling channel 180, and the rear side wall 140 includes the cooling channel interface 1400. The cooling channel interface 1400 is used for the external cooling system to communicate with the lower-layer cooling channel 180 and the upper-layer cooling channel 410. The external cooling system is configured to exchange cooling media with the lower-layer cooling channel 180 and the upper-layer cooling channel 410 through the cooling channel interface 1400.

In this implementation, the upper-layer cooling channel 410 may be configured to cool and dissipate heat for power switching transistor 660 of the upper-layer PCB board 200, and the lower-layer cooling channel 180 may cool and dissipate heat for components, such as the plurality of transformers, the inductor, and the capacitor, that are fastened to the bottom housing 100. In addition, the two layers of cooling channels communicate with each other through the cooling channel interface 1400, so that a coolant can circulate between the two layers of cooling channels. This improves even cooling effect for the vehicle-mounted power supply apparatus 10, and improves temperature uniformity of the vehicle-mounted power supply apparatus 10.

Further, refer to FIG. 27. In an implementation, the front side wall 130 includes a power interface 1310, a second direct current interface 1330, and two first direct current interfaces 1340. The power interface 1310 and the second direct current interface 1330 are electrically connected to the upper-layer PCB board 200. The two first direct current interfaces 1340 are electrically connected to the lower-layer PCB board 300.

In this implementation, the power interface 1310, the second direct current interface 1330, and the two first direct current interfaces 1340 are electrical interfaces and are all used for electrical transmission for the vehicle-mounted power supply apparatus 10. The electrical interfaces are disposed on the front side wall 130, and the cooling channel interface is disposed on the rear side wall 140 opposite to the front side wall 130, so that the electrical interfaces and the cooling channel interface are spaced far away, and electrical transmission and coolant transmission do not affect each other. This helps improve operation efficiency and safety performance of the vehicle-mounted power supply apparatus 10.

In this implementation, the power interface 1310 and the second direct current interface 1330 are electrically connected to a part of the power conversion circuit 600 on the upper-layer PCB board 200, and the first direct current interface 1340 is electrically connected to a part of the power conversion circuit 600 on the lower-layer PCB board 300, so that the upper-layer PCB board 200 and lower-layer PCB board 300 perform different electrical transmission.

Further, refer to FIG. 63. In an implementation, the cooling channel interface 1400 includes two heat dissipator interfaces 1410, the heat dissipator interfaces 1410 are disposed on an upper surface of the rear side wall 140, and the two heat dissipator interfaces 1410 are configured to communicate with an inlet and an outlet of an upper-layer cooling water channel respectively. In this implementation, the external cooling system communicates with the upper-layer cooling channel 410 through the heat dissipator interfaces 1410. This performs a coolant guiding function. In an implementation, the cooling channel interface 1400 further includes two external cooling system interfaces 1420. The external cooling system interfaces 1420 are disposed on a side surface, away from the upper-layer PCB board 200, of the rear side wall 140. The two external cooling system interfaces 1420 are configured to communicate with an outlet and an inlet of the external cooling system respectively. A coolant enters a cooling channel in the vehicle-mounted power supply apparatus 10 through the external cooling system interface 1420.

In an implementation, the cooling channel interface 1400 further includes two bottom housing connection interfaces 1430. The two bottom housing connection interfaces 1430 are configured to communicate with an inlet and an outlet of a lower-layer cooling water channel respectively. The external cooling system communicates with the lower-layer cooling channel 180 through the bottom housing connection interfaces 1430. This performs a coolant guiding function. The external cooling system interface 1420 communicates with the heat dissipator interface 1410 and the bottom housing connection interface 1430. A coolant enters the upper-layer cooling channel 410 and the lower-layer cooling channel 180 through the external cooling system interface 1420, flows through the upper-layer cooling channel 410 and the lower-layer cooling channel 180, and then flows out from the external cooling system interface 1420. In an implementation, the heat dissipator interface 1410 communicates with the bottom housing connection interface 1430, so that the upper-layer cooling channel 410 communicates with the lower-layer cooling channel 180. This helps increase an area of contact between the coolant and the vehicle-mounted power supply apparatus 10.

FIG. 76 is a diagram of a partial structure of a vehicle-mounted power supply apparatus 10 according to an implementation of this application. In an implementation, a heat dissipator interface 1410 is disposed on a side frame 190, and the heat dissipator interface 1410 communicates with both an upper-layer cooling channel 410 and a lower-layer cooling channel 180. The heat dissipator interface 1410 is configured to communicate with an external cooling system. A coolant enters the upper-layer cooling channel 410 and the lower-layer cooling channel 180 through the heat dissipator interface 1410, flows through the upper-layer cooling channel 410 and the lower-layer cooling channel 180, and then flows out from the heat dissipator interface 1410.

In this implementation, the side frame 190 and the heat dissipator interface 1410 are located between the upper-layer cooling channel 410 and the lower-layer cooling channel 180 along a height direction X of the vehicle-mounted power supply apparatus 10, and orthographic projections of the upper-layer cooling channel 410 and the lower-layer cooling channel 180 along the height direction X cover at least a part of an orthographic projection of the heat dissipator interface 1410 along the height direction X. In this solution, the heat dissipator interface 1410 is disposed, so that the upper-layer cooling channel 410 communicates with the lower-layer cooling channel 180. This helps increase an area of contact between the coolant and the vehicle-mounted power supply apparatus 10.

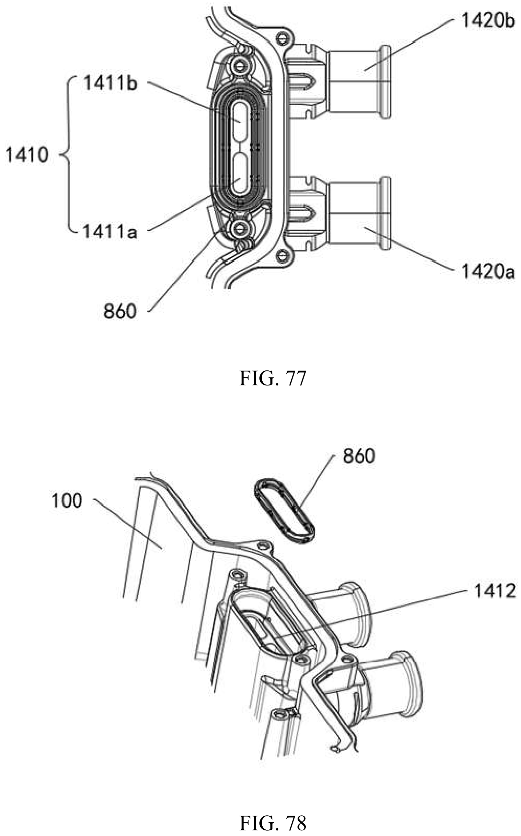

FIG. 77 is a partial enlarged view of a vehicle-mounted power supply apparatus 10 according to an implementation of this application. In an implementation, a heat dissipator interface 1410 includes a first transfer channel 1411a and a second transfer channel 1411b that are spaced away along a left-right direction Z of the vehicle-mounted power supply apparatus 10. Both the first transfer channel 1411a and the second transfer channel 1411b are runway-shaped. Two external cooling system interfaces 1420a and 1420b are disposed on an outer side of a bottom housing 100. One end of the external cooling system interface 1420a communicates with one end of the external cooling system interface 1420b through the first transfer channel 1411a, an upper-layer cooling channel 410, the second transfer channel 1411b, and a lower-layer cooling channel 180. The other end of the external cooling system interface 1420a and the other end of the external cooling system interface 1420b are configured to connect to a cooling apparatus. In this solution, composition of the heat dissipator interface 1410 and a path of a coolant in the vehicle-mounted power supply apparatus 10 are specifically described. The first transfer channel 1411a and the second transfer channel 1411b are spaced away. This helps avoid mutual interference between coolants at different temperature, to avoid adverse impact on heat dissipation effect of the coolants.

Refer to FIG. 77 and FIG. 78. FIG. 78 is a partial enlarged view of a vehicle-mounted power supply apparatus 10 according to an implementation of this application. In an implementation, the vehicle-mounted power supply apparatus 10 further includes a sealing ring 860. The sealing ring 860 is configured to seal the first transfer channel 1411a and the second transfer channel 1411b along a height direction X of the vehicle-mounted power supply apparatus 10. A sealing groove 1412 is provided on an outer periphery of the first transfer channel 1411a and the second transfer channel 1411b. The sealing ring 860 is located in the sealing groove 1412. In this solution, the sealing ring 860 is disposed, so that a coolant can be prevented from leaking from the first transfer channel 1411a and the second transfer channel 1411b or even getting in direct contact with a power conversion circuit 600. In this way, heat is effectively dissipated for heat generating components without affecting normal operation of the vehicle-mounted power supply apparatus 10.

In an implementation, the heat dissipator interface 1410, a bottom housing connection interface 1430, and the bottom housing 100 are an integrated structure.

In this implementation, the heat dissipator interface 1410 and the bottom housing connection interface 1430 remain fastened to the bottom housing 100. When the heat dissipator interface 1410 and the bottom housing connection interface 1430 are subject to an external force (for example, a force applied by the coolant), positions of the heat dissipator interface 1410 and the bottom housing connection interface 1430 can remain unchanged, and the heat dissipator interface 1410 and the bottom housing connection interface 1430 can stably transmit the coolant to the upper-layer cooling channel 410 and the lower-layer cooling channel 180. This avoids impact of an external environment on the coolant.

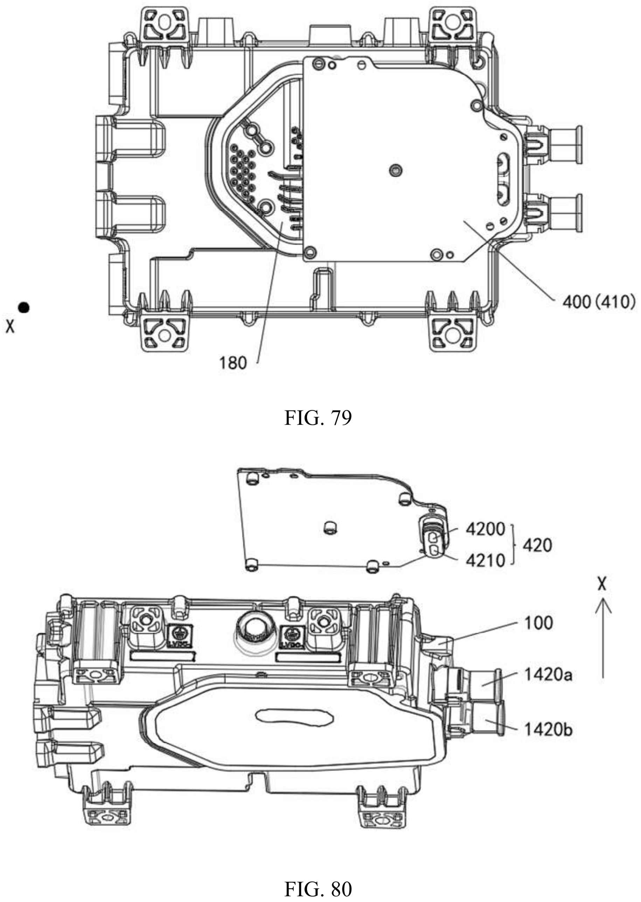

FIG. 79 is a diagram of a partial structure of a vehicle-mounted power supply apparatus 10 according to an implementation of this application. In an implementation, projections of a heat dissipator 400 and a lower-layer cooling channel 180 on a base plate 170 along a height direction X of the vehicle-mounted power supply apparatus 10 at least partially overlap.

In this implementation, because an upper-layer cooling channel 410 and the lower-layer cooling channel 180 in the heat dissipator 400 need to communicate with each other through a heat dissipator interface 1410, projections of the upper-layer cooling channel 410 and the lower-layer cooling channel 180 on the base plate 170 along the height direction X are set to at least partially overlap, so that a coolant flows between the upper-layer cooling channel 410 and the lower-layer cooling channel 180 through a short path and is subject to small flow resistance. In addition, a projection of a part of a power conversion circuit 600 on the base plate 170 along the height direction X is located in an overlapping part of the projections of the upper-layer cooling channel 410 and the lower-layer cooling channel 180, so that the upper-layer cooling channel 410 and the lower-layer cooling channel 180 cool a heat generating component in the part of the power conversion circuit 600 along different directions.

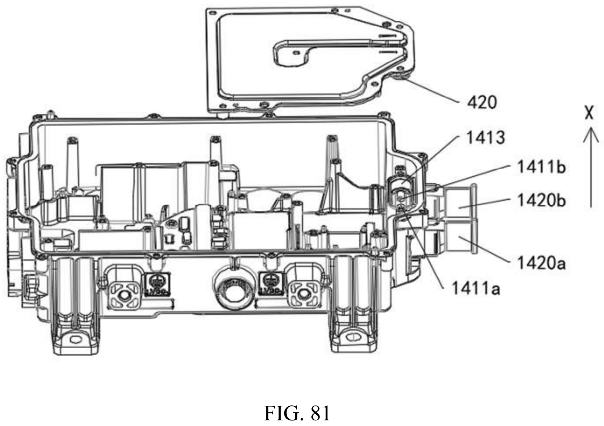

FIG. 80 is a partial exploded view of a vehicle-mounted power supply apparatus 10 according to an implementation of this application. FIG. 81 is a partial exploded view of a vehicle-mounted power supply apparatus 10 according to an implementation of this application.

In an implementation, a lower surface of a heat dissipator 400 has a heat dissipator communication portion 420 protruding toward a bottom housing 100 (as shown in FIG. 80), a communication groove 1413 is provided in a heat dissipator interface 1410 (as shown in FIG. 81), and the heat dissipator communication portion 420 is located in the communication groove 1413 and communicates with the heat dissipator interface 1410.

In this implementation, the communication groove 1413 is concave toward a side away from the heat dissipator 400 along a height direction X of the vehicle-mounted power supply apparatus 10, a first transfer channel 1411a and a second transfer channel 1411b are located at the bottom of the communication groove 1413, and the heat dissipator communication portion 420 is fastened to the communication groove 1413 through plug-connection, so that the first transfer channel 1411a and the second transfer channel 1411b communicate with the heat dissipator communication portion 420.

To facilitate a mechanical connection operation, two external cooling system interfaces 1420a and 1420b are usually disposed in a center region on a side surface of the vehicle-mounted power supply apparatus 10. In this case, a position of a heat dissipation structure in the height direction X of the vehicle-mounted power supply apparatus 10 also needs to be arranged close to the two external cooling system interfaces 1420a and 1420b, to meet a condition for fitting and communication between the heat dissipation structure and the two external cooling system interfaces 1420a and 1420b. Therefore, the heat dissipation structure has a specific spacing from an upper-layer cooling channel 410 along the height direction X. In this solution, the heat dissipator communication portion 420 is disposed in the heat dissipator 400, to compensate for a spacing between the upper-layer cooling channel 410 and each of the first transfer channel 1411a and the second transfer channel 1411b along the height direction X, and guide a coolant that enters the heat dissipator interface 1410. In addition, the heat dissipator interface 1410 is integrated with the bottom housing 100, the heat dissipator interface 1410 directly communicates with a lower-layer cooling channel 180, and a coolant does not need to resist the action of gravity when entering the lower-layer cooling channel 180 through the heat dissipator interface 1410. Therefore, no additional communication portion is disposed in the lower-layer cooling channel 180.

In an implementation, the heat dissipator communication portion 420 includes a first communication hole 4200 and a second communication hole 4210 that are spaced away along a left-right direction Z of the vehicle-mounted power supply apparatus 10 (as shown in FIG. 80). The first communication hole 4200 is provided in correspondence with the first transfer channel 1411a along the height direction X of the vehicle-mounted power supply apparatus 10. The second communication hole 4210 is provided in correspondence with the second transfer channel 1411b along the height direction X of the vehicle-mounted power supply apparatus 10. The first transfer channel 1411a communicates with the upper-layer cooling channel 410 through the first communication hole 4200. The second transfer channel 1411b communicates with the upper-layer cooling channel 410 through the second communication hole 4210.

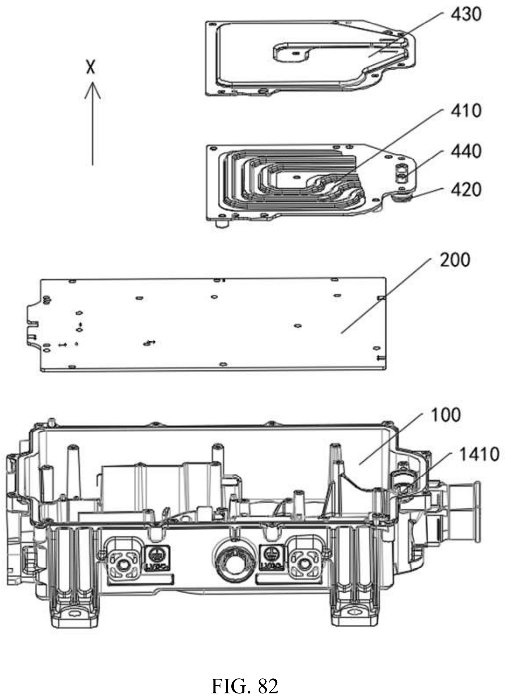

FIG. 82 is a partial exploded view of a vehicle-mounted power supply apparatus 10 according to an implementation of this application. In an implementation, a heat dissipator 400 includes two stacked sheet metal parts and two sealing interfaces 440 located at a same end of the sheet metal part. Edges of the two sheet metal parts are sealed through braze welding to form an upper-layer cooling channel 410. The upper-layer cooling channel 410 communicates with two heat dissipator interfaces 1410 through the two sealing interfaces 440. A thickness of the sheet metal part is less than a thickness of a bottom housing.

In this implementation, the heat dissipator 400 is made of a sheet metal material, and the two sheet metal parts in the heat dissipator 400 are a channel cover 430 and an upper-layer cooling channel body 4100 of the upper-layer cooling channel 410 respectively. The channel cover 430 is located on a side, away from an upper-layer PCB board 200 along a height direction X of the vehicle-mounted power supply apparatus 10, of the upper-layer cooling channel 410. The channel cover 430 covers an outer side of the upper-layer cooling channel 410. An orthographic projection of the channel cover 430 on the upper-layer PCB board 200 covers an orthographic projection of the upper-layer cooling channel 410 on the upper-layer PCB board 200. The channel cover 430 is configured to prevent a coolant from leaking from the upper-layer cooling channel 410. The channel cover 430 is fastened to the bottom housing 100 through the upper-layer PCB board 200, for example, is fastened by using a screw. The upper-layer cooling channel 410 remains fastened to the bottom housing 100, so that the upper-layer cooling channel 410 is not affected by an external force (for example, a force applied by the coolant), and a position of the upper-layer cooling channel 410 remains unchanged.

In this implementation, the sealing interfaces 440 are disposed opposite to a heat dissipator communication portion 420 along the height direction X, and the sealing interfaces 440 communicate with the heat dissipator interfaces 1410 through the heat dissipator communication portion 420.

The thickness of the sheet metal part is less than the thickness of the bottom housing 100, so that the heat dissipator 400 has a lighter weight and faster heat conduction effect, and heat of power switching transistors below the heat dissipator 400 can be transmitted and absorbed. This improves heat dissipation effect for the vehicle-mounted power supply apparatus.

Further, refer to FIG. 15. In an implementation, the bottom housing 100 includes a plurality of protrusions 110, and the plurality of protrusions 110 are configured to support at least one of the upper-layer PCB board 200, the lower-layer PCB board 300, or the heat dissipator 400.

In this implementation, the upper-layer PCB board 200, the lower-layer PCB board 300, and the heat dissipator 400 are all spaced away from a base plate 170 of the bottom housing 100. Therefore, if at least one of the upper-layer PCB board 200, the lower-layer PCB board 300, and the heat dissipator 400 is to be fastened to the bottom housing 100, the plurality of protrusions 110 needs to be arranged on the base plate 170 to compensate for a spacing along the height direction X. The plurality of protrusions 110 support at least one of the upper-layer PCB board 200, the lower-layer PCB board 300, and the heat dissipator 400, and the upper-layer PCB board 200 and the lower-layer PCB board 300 are fastened to the bottom housing 100. In this way, a power conversion circuit 600 mounted on the upper-layer PCB board 200 and the lower-layer PCB board 300 also remains fastened relative to the bottom housing 100. This helps enhance anti-interference performance of the vehicle-mounted power supply apparatus against an external force.

In an implementation, the plurality of protrusions 110 are configured to support each of the upper-layer PCB board 200, the lower-layer PCB board 300, or the heat dissipator 400.

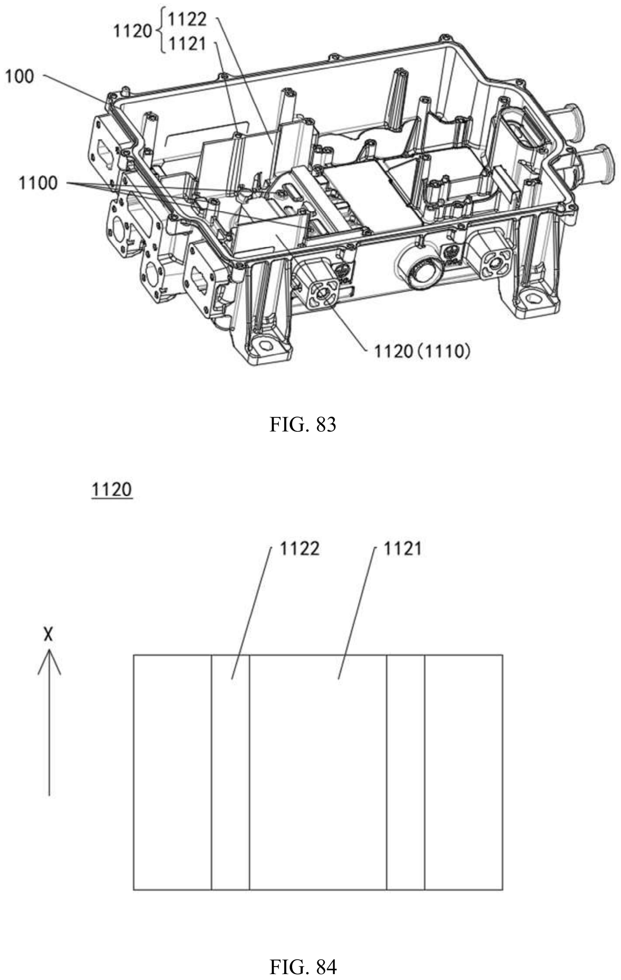

FIG. 83 is a diagram of a structure of a bottom housing 100 in a vehicle-mounted power supply apparatus 10 according to an implementation of this application. In an implementation, a plurality of protrusions 110 of the bottom housing 100 include a first protrusion 1100 and a second protrusion 1110. The first protrusion 1100 is configured to fasten a lower-layer PCB board 300. The second protrusion 1110 is configured to fasten an upper-layer PCB board 200 and a heat dissipator 400. A height of the second protrusion 1110 is greater than a height of the first protrusion 1100 along a height direction X of the vehicle-mounted power supply apparatus 10.

In this implementation, a part of a power conversion circuit 600 is disposed on each of the upper-layer PCB board 200 and the lower-layer PCB board 300, and the upper-layer PCB board 200 and the lower-layer PCB board 300 are fastened to the bottom housing 100 through the second protrusion 1110 and the first protrusion 1100 respectively. In this way, the power conversion circuit 600 on the upper-layer PCB board 200 and the lower-layer PCB board 300 also remains fastened relative to the bottom housing 100. When the vehicle-mounted power supply apparatus 10 is affected by an external environment, a position of the power conversion circuit 600 can remain unchanged, so that the power conversion circuit 600 stably performs a power conversion function. In this implementation, a part of the power conversion circuit 600 that is mounted on the upper-layer PCB board 200 needs to occupy a specific size along the height direction X of the vehicle-mounted power supply apparatus 10, and the upper-layer PCB board 200 is fastened to a base plate 170 through the second protrusion 1110. Therefore, the height of the second protrusion 1110 is set to be greater than the height of the first protrusion 1100. This is equivalent to that a distance between the upper-layer PCB board 200 and the base plate 170 is greater than a distance between the lower-layer PCB board 300 and the base plate 170 along the height direction X, so that mounting space is provided for a component with a large size in the power conversion circuit 600. In this implementation, a magnitude relationship between the heights of the first protrusion 1100 and the second protrusion 1110 is set, so that the upper-layer PCB board 200 is disposed close to an upper-layer cooling channel 410 of the heat dissipator 400 and the lower-layer PCB board 300 is disposed close to a lower-layer cooling channel 180 of the bottom housing 100. The upper-layer cooling channel 410 and the lower-layer cooling channel 180 form a three-dimensional channel, to dissipate heat for components at different positions in the vehicle-mounted power supply apparatus 10, and improve cooling efficiency of a coolant.

Further, refer to FIG. 5. In this implementation, the upper-layer PCB board 200, the lower-layer PCB board 300, and the bottom housing 100 are sequentially arranged along the height direction X of the vehicle-mounted power supply apparatus 10. Therefore, a distance between the upper-layer PCB board 200 and an inner surface of the bottom housing 100 is greater than a distance between the lower-layer PCB board 300 and the inner surface of the bottom housing 100. In addition, the second protrusion 1110 and the first protrusion 1100 are configured to connect to the upper-layer PCB board 200 and the lower-layer PCB board 300 respectively. Therefore, the height of the second protrusion 1110 needs to be set to be greater than the height of the first protrusion 1100, to reduce operation difficulty of fastening the upper-layer PCB board 200 to the bottom housing 100. A difference in the heights of the second protrusion 1110 and the first protrusion 1100 also helps distinguish between the second protrusion 1110 and the first protrusion 1100 in appearance. During an actual operation, the upper-layer PCB board 200 and the lower-layer PCB board 300 can be quickly fastened to the bottom housing 100.

Further, refer to FIG. 83. In an implementation, the plurality of protrusions 110 include a plurality of shield protrusions 1120, and the upper-layer PCB board 200 and the heat dissipator 400 are sequentially stacked and fastened to the plurality of shield protrusions 1120. Two shield protrusions 1120 together form a shield region, or one shield protrusion and one side wall together form another shield region, and an orthographic projection of the upper-layer PCB board 200 covers the shield region and the another shield region.

In this implementation, the upper-layer PCB board 200 and the heat dissipator 400 are fastened to the bottom housing through the shield protrusions 1120. When the vehicle-mounted power supply apparatus 10 is subject to a force applied by an external environment, the heat dissipator 400 is not prone to displacement relative to the bottom housing 100. This helps improve overall structural stability of the vehicle-mounted power supply apparatus 10.

In this implementation, the orthographic projection of the upper-layer PCB board 200 along the height direction X of the vehicle-mounted power supply apparatus 10 covers a plurality of shield regions. In this way, the part of the power conversion circuit 600 that is fastened to the upper-layer PCB board 200 can extend into the shield regions, to improve electrical shielding effect. Further, refer to FIG. 83. In an implementation, at least one shield protrusion 1120 of the plurality of protrusions 110 includes a fastening post 1122 and a shield wall 1121 that are connected to each other. The fastening post 1122 is configured to fasten at least one of the upper-layer PCB board 200 and the heat dissipator 400. The shield wall 1121 is arranged along a left-right direction Z or a front-rear direction Y of the vehicle-mounted power supply apparatus 10.

In this implementation, the shield protrusion 1120 is the second protrusion 1110. Therefore, along the height direction X of the vehicle-mounted power supply apparatus 10, a height of the fastening post 1122 of the shield protrusion 1120 is greater than the height of the first protrusion 1100, so that the upper-layer PCB board 200 and the heat dissipator 400 that are fastened to the fastening post 1122 are also higher than the lower-layer PCB fastened to the first protrusion 1100, to provide sufficient mounting space for the power conversion circuit 600. In addition, a height of the shield wall 1121 of the shield protrusion 1120 is greater than the height of the first protrusion 1100, so that components located on different sides of the shield wall 1121 are shielded and isolated by the shield wall 1121. The shield wall 1121 extends along the left-right direction Z or the front-rear direction Y in the vehicle-mounted power supply apparatus 10, so that the shield wall 1121 divides the bottom housing 100 into a plurality of shield regions while providing shielding effect. Further, refer to FIG. 13. In an implementation, at least one shield protrusion 1120 is configured to sequentially fasten the upper-layer PCB board 200 and the heat dissipator 400, the heat dissipator 400 and the upper-layer PCB board 200 are sequentially stacked on the at least one shield protrusion 1120, and a gap between the at least one shield protrusion 1120 and the upper-layer PCB board 200 is filled with conductive adhesive.

In this implementation, the shield protrusion 1120 simultaneously performs an electrical shielding function, a support function, and a fastening function. The heat dissipator 400 and the upper-layer PCB board are fastened to the bottom housing 100 by using screws. The screws sequentially pass through the heat dissipator 400, the upper-layer PCB board 200, and the fastening post 1122 of the shield protrusion 1120 along the height direction X.

FIG. 84 is a diagram of a structure of a shield protrusion 1120 according to an implementation of this application. In this implementation, when heights of a fastening post 1122 and a shield wall 1121 along a height direction X of the vehicle-mounted power supply apparatus 10 are the same, an upper-layer PCB board 200 is in direct contact with the shield wall 1121. In this case, an area of contact between the upper-layer PCB board 200 and a second protrusion 1110 is large, so that the upper-layer PCB board 200 is fastened to a bottom housing 100 more tightly through the second protrusion 1110.

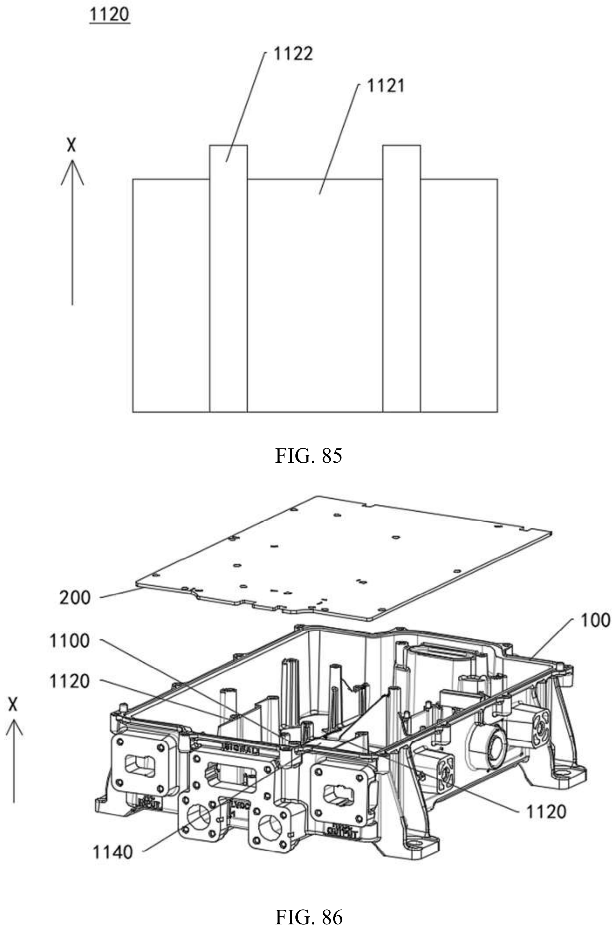

It should be noted that, due to impact of an assembly tolerance, a design tolerance, structural flatness, and other factors, in this implementation, the heights of the fastening post 1122 and the shield wall 1121 along the height direction X of the vehicle-mounted power supply apparatus 10 are very likely to be different. Persons skilled in the art should understand that such deviation is inevitable and acceptable. FIG. 85 is a diagram of a structure of a shield protrusion 1120 according to an implementation of this application. In this implementation, when a height of a fastening post 1122 along a height direction X of the vehicle-mounted power supply apparatus 10 is greater than a height of a shield wall 1121 along the height direction X of the vehicle-mounted power supply apparatus 10, an upper-layer PCB board 200 is in contact only with the fastening post 1122, and there is a gap between the shield wall 1121 and the upper-layer PCB board 200. In this case, the gap may be filled with conductive adhesive. This can compensate for a difference in the heights of the fastening post 1122 and the shield wall 1121, so that connection between the upper-layer PCB board 200 and a second protrusion 1110 is more stable. In addition, because the conductive adhesive has electrical conductivity, a conductive path is formed between the upper-layer PCB board 200 and the shield wall 1121, so that shielding effect of the shield wall 1121 for a power conversion circuit 600 can be improved.

Refer to FIG. 83 and FIG. 86. FIG. 86 is a diagram of a structure of a bottom housing 100 and an upper-layer PCB board 200 according to an implementation of this application. In an implementation, the bottom housing 100 includes a plurality of first protrusions 1100 and two shield protrusions 1120 (as shown in FIG. 83). The plurality of first protrusions 1100 are distributed in a region of the bottom housing 100 between the two shield protrusions 1120 (as shown in FIG. 83). Heights of the plurality of first protrusions 1100 are less than heights of the two shield protrusions 1120 along the height direction X of the vehicle-mounted power supply apparatus 10 (as shown in FIG. 83 and FIG. 86). The plurality of first protrusions 1100 are configured to fasten the lower-layer PCB board 300. The two shield protrusions 1120 are configured to fasten the upper-layer PCB board 200. The two shield protrusions 1120 and the upper-layer PCB board 200 form a lower-layer PCB board shield region 1140. The lower-layer PCB board shield region 1140 is configured to reduce electrical interference to the lower-layer PCB board 300 (as shown in FIG. 83).

In this implementation, the lower-layer PCB board 300 is located in the lower-layer PCB board shield region 1140 between the two shield protrusions 1120, the lower-layer PCB board 300 with a lower height is fastened to the bottom housing 100 through the first protrusions 1100 with lower heights, and the upper-layer PCB board 200 with a higher height is fastened through the shield protrusions 1120 with higher heights, so that the upper-layer PCB board and the lower-layer PCB board 300 can be sequentially stacked and fastened to the bottom housing 100. This can improve overall structural strength of the vehicle-mounted power supply apparatus 10 and reduce a size. In addition, the upper-layer PCB board can be further reused to form the lower-layer PCB board shield region 1140 together with the shield protrusions 1120, to ensure shielding effect of the shield protrusions 1120 for the lower-layer PCB board 300. In this way, mutual electrical interference between the lower-layer PCB board 300 and a component located on the other side of the shield protrusions 1120 is small. In this implementation, the shield protrusions 1120 can simultaneously perform a support function, a fastening function, and a shielding function.

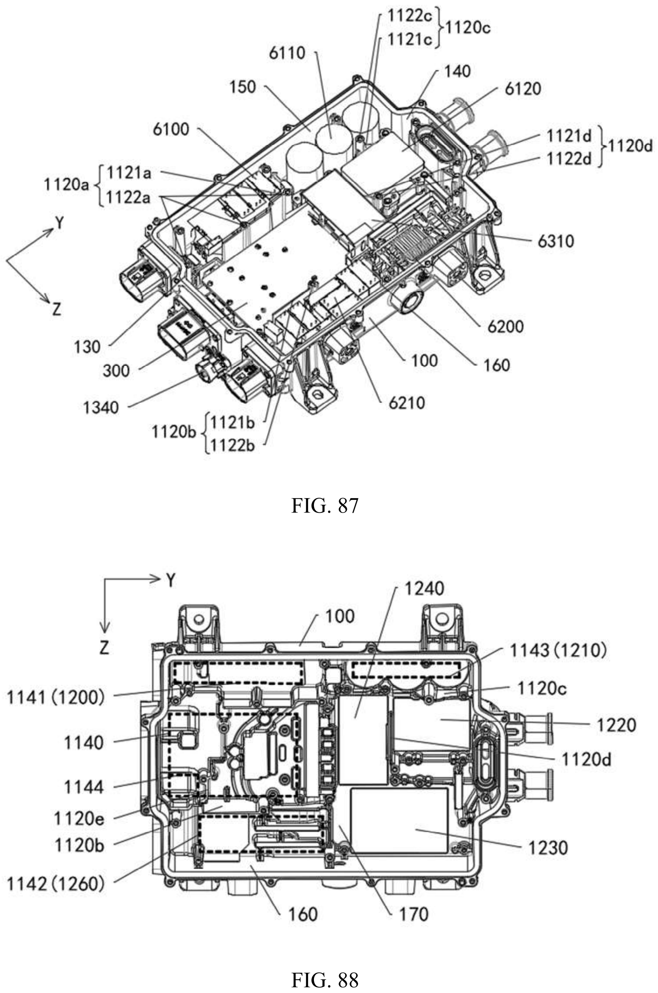

FIG. 87 is a diagram of a structure of a bottom housing 100 and a power conversion circuit 600 according to an implementation of this application. In an implementation, the power conversion circuit 600 includes an AC filter 6100 and an HVDC filter 6210. One of two shield protrusions 1120 is configured to reduce electrical interference caused by the AC filter 6100 of the power conversion circuit 600 to a lower-layer PCB board 300. The other of the two shield protrusions 1120 is configured to reduce electrical interference caused by the HVDC filter 6210 of the power conversion circuit 600 to the lower-layer PCB board 300.

In this implementation, the two shield protrusions 1120 are denoted as a first shield protrusion 1120a and a second shield protrusion 1120b respectively. The first shield protrusion 1120a, the lower-layer PCB board 300, and the second shield protrusion 1120b are arranged along a left-right direction Z of the vehicle-mounted power supply apparatus 10. The lower-layer PCB board 300 is located between the first shield protrusion 1120a and the second shield protrusion 1120b. The AC filter 6100 is located between a left side wall 150 and the first shield protrusion 1120a. The HVDC filter is located between a right side wall 160 and the second shield protrusion 1120b. A part of the power conversion circuit 600 is mounted on the lower-layer PCB board 300 and is electrically connected to the lower-layer PCB board 300. Therefore, along the left-right direction Z of the vehicle-mounted power supply apparatus 10, the first shield protrusion 1120a can perform electrical shielding for the AC filter 6100 and the lower-layer PCB board 300 on two sides, and the second shield protrusion 1120b can perform electrical shielding for the HVDC filter 6210 and the lower-layer PCB board 300 on two sides. Both the first shield protrusion 1120a and the second shield protrusion 1120b provide shielding effect for the lower-layer PCB board 300.

Further, refer to FIG. 87. In an implementation, the bottom housing 100 includes at least one of a first shield protrusion 1120a, a second shield protrusion 1120b, a third shield protrusion 1120c, and a fourth shield protrusion 1120d. The first shield protrusion 1120a is configured to reduce electrical interference between an AC filter 6100 and a lower-layer PCB board 300. The second shield protrusion 1120b is configured to reduce electrical interference between an HVDC filter 6210 and the lower-layer PCB board 300. The third shield protrusion 1120c is configured to reduce electrical interference between a PFC capacitor 6110 and a PFC inductor 6120 and electrical interference between the PFC capacitor 6110 and a low-voltage transformer 6310. The fourth shield protrusion 1120d is configured to reduce electrical interference between the PFC inductor 6120 and the low-voltage transformer 6310.

Further, refer to FIG. 87. In an implementation, the power conversion circuit 600 includes an AC filter 6100, the bottom housing 100 includes a first shield protrusion 1120a, and the first shield protrusion 1120a includes a first fastening post 1122a and a first shield wall 1121a that are connected to each other. The first fastening post 1122a is configured to fasten an upper-layer PCB board 200 and an AC filter shield can 830. The first shield wall 1121a is arranged along a front-rear direction Y of the vehicle-mounted power supply apparatus 10. The first shield wall 1121a, a left side wall 150 of the bottom housing 100, and the AC filter shield can 830 form an AC filter shield region 1141. The AC filter shield region 1141 is configured to accommodate the AC filter 6100 of the power conversion circuit 600.

In this implementation, the AC filter 6100 is configured to receive an alternating current from an external power source and filter out harmonics in the alternating current, and the AC filter shield region 1141 is configured to reduce electrical interference between the AC filter 6100 and an electrical component on an outer side of the AC filter shield region 1141. In an implementation, in view of a design tolerance, an assembly tolerance, a requirement for mounting space, and other factors, the AC filter shield region 1141 may not be a completely enclosed region.

In this implementation, the first shield wall 1121a and the left side wall 150 are spaced away, a part of the first shield protrusion 1120a extends along the front-rear direction Y of the vehicle-mounted power supply apparatus 10, and a part of the first shield protrusion 1120a extends along a left-right direction Z of the vehicle-mounted power supply apparatus 10. The first shield wall 1121a extending along the front-rear direction Y performs electrical shielding between the AC filter 6100 and a component located on the other side of the first shield wall 1121a along the left-right direction Z. The first shield wall 1121a extending along the left-right direction Z performs electrical shielding between the AC filter 6100 and a component located on the other side of the first shield wall 1121a along the front-rear direction Y.

In this implementation, the AC filter 6100 is disposed opposite to the AC filter 6100 shield region along a height direction X of the vehicle-mounted power supply apparatus 10, so that the bottom housing 100 can accommodate the AC filter 6100. The AC filter 6100 shield region includes a total of six side surfaces. In some other implementations, the AC filter 6100 shield region may include five side surfaces, provided that electrical shielding effect is not affected.

Further, refer to FIG. 87. In an implementation, the power conversion circuit 600 includes an HVDC filter 6210, the bottom housing 100 includes a second shield protrusion 1120b, and the second shield protrusion 1120b includes a second fastening post 1122b and a second shield wall 1121b that are connected to each other. The second fastening post 1122b is configured to fasten an upper-layer PCB board 200 and an HVDC filter shield can 840. The second shield wall 1121b is arranged along a front-rear direction Y of the vehicle-mounted power supply apparatus 10. The second shield wall 1121b, a right side wall 160 of the bottom housing 100, and the HVDC filter shield can 840 form an HVDC filter shield region 1142. The HVDC filter shield region 1142 is configured to accommodate the HVDC filter 6210 of the power conversion circuit 600.

In this implementation, the HVDC filter 6210 is configured to filter out harmonics in a second alternating current, and the HVDC filter shield region 1142 is configured to reduce electrical interference between the HVDC filter 6210 and an electrical component on an outer side of the HVDC filter shield region 1142. In an implementation, in view of a design tolerance, an assembly tolerance, a requirement for mounting space, and other factors, the HVDC filter shield region 1142 may not be a completely enclosed region.

In this implementation, the second shield wall 1121b and the right side wall 160 are spaced away, a part of the second shield protrusion 1120b extends along the front-rear direction Y of the vehicle-mounted power supply apparatus 10, and a part of the second shield protrusion 1120b extends along a left-right direction Z of the vehicle-mounted power supply apparatus 10. The second shield wall 1121b extending along the front-rear direction Y performs electrical shielding between the HVDC filter 6210 and a component located on the other side of the second shield wall 1121b along the left-right direction Z. The second shield wall 1121b extending along the left-right direction Z performs electrical shielding between the HVDC filter 6210 and a component located on the other side of the second shield wall 1121b along the front-rear direction Y.

In this implementation, the HVDC filter 6210 is disposed opposite to the HVDC filter shield region 1142 along a height direction X of the vehicle-mounted power supply apparatus 10, so that the bottom housing 100 can accommodate the HVDC filter 6210. The HVDC filter shield region 1142 includes a total of six side surfaces. In some other implementations, the HVDC filter 6210 shield region may include five side surfaces, provided that electrical shielding effect is not affected. Further, refer to FIG. 87. In an implementation, the power conversion circuit 600 includes an alternating current-to-direct current conversion circuit 610, the alternating current-to-direct current conversion circuit 610 includes a PFC capacitor 6110 and a PFC inductor 6120, the bottom housing 100 includes a third shield protrusion 1120c, and the third shield protrusion 1120c includes a third fastening post 1122c and a third shield wall 1121c that are connected to each other. The third fastening post 1122c is configured to fasten an upper-layer PCB board 200 and a heat dissipator 400. The third shield wall 1121c is arranged along a front-rear direction Y of the vehicle-mounted power supply apparatus 10 and is arranged side by side with a left side wall 150 of the bottom housing 100. The third shield wall 1121c is configured to form a PFC capacitor shield region 1143 together with the left side wall 150 of the bottom housing 100, a rear side wall 140 of the bottom housing 100, and the upper-layer PCB board 200. The PFC capacitor shield region 1143 is configured to accommodate the PFC capacitor 6110 of the alternating current-to-direct current conversion circuit 610. The third shield wall 1121c is configured to reduce electrical interference between the PFC capacitor 6110 and the PFC inductor 6120 of the alternating current-to-direct current conversion circuit 610.

In this implementation, the alternating current-to-direct current conversion circuit 610 is configured to convert an alternating current into a direct current, and the PFC capacitor 6110 and the PFC inductor 6120 are arranged along a left-right direction Z of the vehicle-mounted power supply apparatus 10. The PFC capacitor shield region 1143 is configured to reduce electrical interference between the PFC capacitor 6110 and an electrical component on an outer side of the PFC capacitor shield region 1143. In an implementation, in view of a design tolerance, an assembly tolerance, a requirement for mounting space, and other factors, the PFC capacitor shield region 1143 may not be a completely enclosed region.

In this implementation, the third shield protrusion 1120c and the left side wall 150 are spaced away, and the PFC capacitor 6110 is located between the left side wall 150 and the third shield wall 1121c. The third shield protrusion 1120c performs electrical isolation between the PFC capacitor 6110 and the PFC inductor 6120 that are located on two sides of the third shield wall 1121c along the left-right direction Z.

In an implementation, the third shield protrusion 1120c includes a fastening post and a supporting wall near the fastening post. The supporting wall is configured to improve machinability of the fastening post. A shape of the supporting wall is not limited. In this implementation, the shield wall in the third shield protrusion 1120c serves as the supporting wall for the fastening post.

In an implementation, the shield wall in the third shield protrusion 1120c may be configured to shield electrical interference and improve machinability of the fastening post.

Further, refer to FIG. 87. In an implementation, the power conversion circuit 600 includes a low-voltage transformer 6310, the bottom housing 100 includes a fourth shield protrusion 1120d, and the fourth shield protrusion 1120d includes a fourth fastening post 1122d and a fourth shield wall 1121d that are connected to each other. The fourth fastening post 1122d is configured to fasten an upper-layer PCB board 200 and a heat dissipator 400. The fourth shield wall 1121d is arranged along a left-right direction Z of the vehicle-mounted power supply apparatus 10 and is arranged side by side with a side wall, on which a cooling channel interface 1400 is disposed, of the bottom housing 100. The fourth shield wall 1121d is configured to reduce electrical interference between the low-voltage transformer 6310 of a low-voltage direct current conversion circuit 630 and a PFC inductor 6120.

In this implementation, the low-voltage direct current conversion circuit 630 is configured to convert a second direct current into a first direct current, and the low-voltage transformer 6310 is located between a lower-layer PCB board 300 and the PFC inductor 6120 along a front-rear direction Y of the vehicle-mounted power supply apparatus 10.

In this implementation, the low-voltage transformer 6310, the fourth shield protrusion 1120d, and the PFC inductor 6120 are arranged along the front-rear direction Y of the vehicle-mounted power supply apparatus 10. The fourth shield protrusion 1120d can perform electrical shielding between the low-voltage transformer 6310 and the PFC inductor 6120 on two sides of the fourth shield wall 1121d along the front-rear direction Y.

In an implementation, the fourth shield protrusion 1120d includes a fastening post and a supporting wall near the fastening post. The supporting wall is configured to improve machinability of the fastening post. A shape of the supporting wall is not limited. In this implementation, the shield wall in the third shield protrusion 1120c serves as the supporting wall for the fastening post.

In an implementation, the shield wall in the fourth shield protrusion 1120d may be configured to shield electrical interference and improve machinability of the fastening post.

Refer to FIG. 87 and FIG. 88. In an implementation, the bottom housing 100 includes the first shield protrusion 1120a, the second shield protrusion 1120b, the third shield protrusion 1120c, and the fourth shield protrusion 1120d (as shown in FIG. 88), and the power conversion circuit 600 includes the AC filter 6100, the HVDC filter 6210, the low-voltage transformer 6310, the PFC capacitor 6110, and the PFC inductor 6120 (as shown in FIG. 87). The first shield protrusion 1120a and the second shield protrusion 1120b are configured to fasten the upper-layer PCB board 200 and form a lower-layer PCB board shield region 1140 together with the upper-layer PCB board 200 (as shown in FIG. 24 and FIG. 87). The lower-layer PCB board shield region 1140 is configured to accommodate the lower-layer PCB board 300 and reduce electrical interference between the AC filter 6100 and the lower-layer PCB board 300 and between the HVDC filter 6210 and the lower-layer PCB board 300 (as shown in FIG. 87 and FIG. 88).

In this implementation, the AC filter 6100, the HVDC filter 6210, the low-voltage transformer 6310, the PFC capacitor 6110, and the PFC inductor 6120 are arranged around a periphery of the lower-layer PCB board. When the vehicle-mounted power supply apparatus 10 is in an operating state, a part of the power conversion circuit 600 that is mounted on the lower-layer PCB board interferes with a component on the periphery. Therefore, the lower-layer PCB board shield region 1140 is arranged, so that electrical interference between the lower-layer PCB board 300 and an electrical component on an outer side of the lower-layer PCB board shield region 1140 can be reduced. The first shield protrusion 1120a is configured to shield the lower-layer PCB board 300 from the AC filter 6100. The second shield protrusion 1120b is configured to shield the lower-layer PCB board 300 from the HVDC filter 6210. In an implementation, in view of a design tolerance, an assembly tolerance, a requirement for mounting space, and other factors, the lower-layer PCB board shield region 1140 may not be a completely enclosed region.

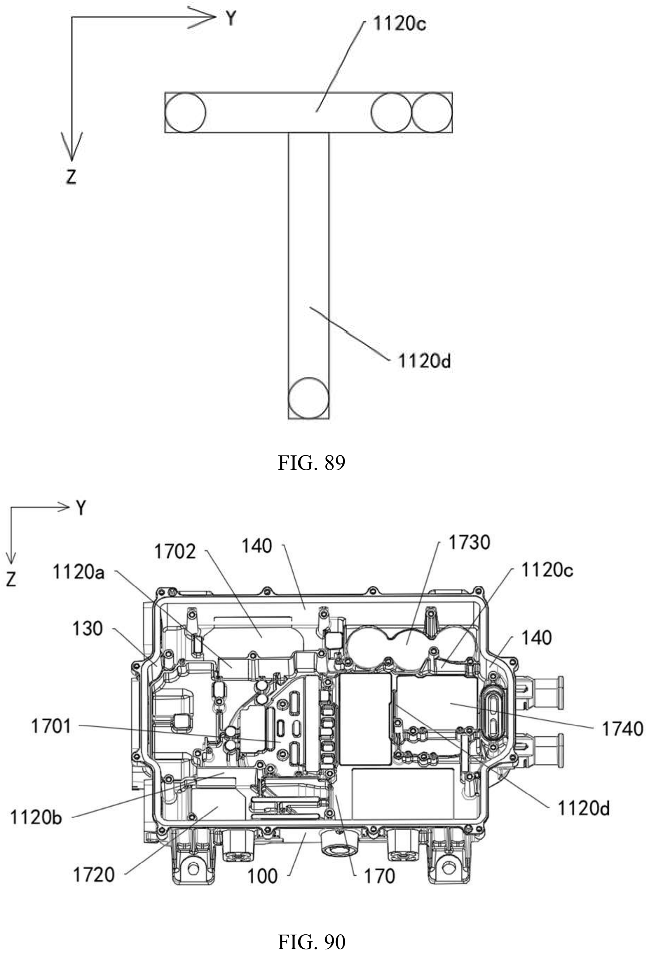

FIG. 89 is a diagram of a structure of a third shield protrusion 1120c and a fourth shield protrusion 1120d according to an implementation of this application. In an implementation, the third shield protrusion 1120c and the fourth shield protrusion 1120d form a T-shaped shield structure. The T-shaped shield structure is configured to reduce electrical interference between a low-voltage transformer 6310, a PFC capacitor 6110, and a PFC inductor 6120. In this implementation, in addition to performing electrical shielding between the PFC capacitor 6110 and the PFC inductor 6120, the third shield protrusion 1120c can further reduce electrical interference between the PFC inductor 6120 and the low-voltage transformer 6310, to further improve electromagnetic compatibility of the vehicle-mounted power supply apparatus 10.

In an implementation, a front end of the third shield protrusion 1120c is connected to a first shield protrusion 1120a, and a rear end of the third shield protrusion 1120c may be connected to a rear side wall 140, to enhance overall structural strength and further improve shielding effect.

In an implementation, a front end of the first shield protrusion 1120a is connected to a front side wall, to enhance overall structural strength and further improve shielding effect.

In an implementation, a left end of the fourth shield protrusion 1120d is connected to the third shield protrusion 1120c, to enhance overall structural strength and further improve shielding effect. Refer to FIG. 12 and FIG. 88. In an implementation, the bottom housing 100 includes a first shield protrusion 1120a, a second shield protrusion 1120b, and a fifth shield protrusion 1120e, and the power conversion circuit 600 includes a first direct current interface 1340 (as shown in FIG. 12). The first direct current interface 1340 is configured to transmit a first direct current output by the power conversion circuit 600. The first shield protrusion 1120a and the second shield protrusion 1120b are arranged along a front-rear direction Y of the vehicle-mounted power supply apparatus 10 (as shown in FIG. 88). The fifth shield protrusion 1120e is arranged along a left-right direction Z of the vehicle-mounted power supply apparatus 10 (as shown in FIG. 88). The first shield protrusion 1120a, the second shield protrusion 1120b, and the fifth shield protrusion 1120e together form a first direct current interface shield region 1144 (as shown in FIG. 88). The first direct current interface shield region 1144 is configured to accommodate a part of the first direct current interface 1340 (as shown in FIG. 12 and FIG. 88).

In this implementation, a low-voltage direct current conversion circuit 630 supplies power to a first-type load 15 through the first direct current interface 1340. The first direct current interface shield region 1144 is configured to reduce electrical interference between the first direct current interface 1340 and an electrical component on an outer side of the first direct current interface shield region 1144. In an implementation, in view of a design tolerance, an assembly tolerance, a requirement for mounting space, and other factors, the first direct current interface shield region 1144 may be a region that is not completely enclosed.

In this implementation, one end of the first direct current interface 1340 extends into the bottom housing 100 and is electrically connected to the lower-layer PCB board 300. Therefore, the first direct current interface shield region 1144 partially overlaps with a lower-layer PCB board shield region 1140. The fifth shield protrusion 1120e and the front side wall 130 are spaced away, and the first direct current interface 1340 is located between the first shield protrusion 1120a and the second shield protrusion 1120b. The first shield protrusion 1120a can shield electrical interference between the first direct current interface 1340 and the AC filter 6100. The second shield protrusion 1120b can shield electrical interference between the first direct current interface 1340 and the HVDC filter 6210. The fifth shield protrusion 1120e can shield electrical interference between the first direct current interface 1340 and the lower-layer PCB board 300.

Further, refer to FIG. 87. In an implementation, the first shield protrusion 1120a includes three first fastening posts 1122a and a first shield wall 1121a. The three first fastening posts 1122a are sequentially connected to the first shield wall 1121a along the front-rear direction Y of the vehicle-mounted power supply apparatus 10 and are configured to fasten a signal filter shield can 820, the upper-layer PCB board 200, and the heat dissipator 400 respectively.

In this implementation, an arrangement direction of the three first fastening posts 1122a corresponds to an arrangement direction of the signal filter shield can 820 and the heat dissipator 400. Among the three first fastening posts 1122a, a first fastening post 1122a close to the front side wall 130 is configured to be fastened to the signal filter shield can 820, a first fastening post 1122a close to the rear side wall 140 is configured to be fastened to the upper-layer PCB board 200 and the heat dissipator 400, and a first fastening post 1122a at a middle position is configured to be fastened to the upper-layer PCB board 200. The three first fastening posts 1122a of the first shield protrusion 1120a can shield three different components. This shows multifunctionality of shield protrusions in the vehicle-mounted power supply apparatus 10.

Further, refer to FIG. 12. In an implementation, the fifth shield protrusion 1120e includes two fifth fastening posts 1122e and a fifth shield wall 1121e. The two fifth fastening posts 1122e are sequentially connected to the fifth shield wall 1121e along the left-right direction Z of the vehicle-mounted power supply apparatus 10. The two fifth fastening posts 1122e are configured to fasten the lower-layer PCB board 300 and the shield can 800. Along a height direction Y of the vehicle-mounted power supply apparatus 10, heights of the two fifth fastening posts 1122e and a height of the fifth shield wall 1121e are less than a height of the first fastening post 1122a of the first shield protrusion 1120a and a height of the first shield wall 1121a.

In this implementation, the shield can 800 is configured to shield a low-voltage filter circuit 6400. The low-voltage filter circuit 6400 is electrically connected to the first direct current interface 1340, and the low-voltage filter circuit 6400 is configured to filter out harmonics in a first direct current. The shield can 800 is fastened to the bottom housing through the fifth fastening post 1122e, so that the shield can 800 can stably perform electrical isolation for the low-voltage filter circuit 6400. This enhances shielding effect against electromagnetic interference.

In this implementation, both the low-voltage filter circuit 6400 and the first direct current interface 1340 are electrically connected to the lower-layer PCB board 300, the lower-layer PCB board 300 is located on a side, away from the bottom housing 100 along the height direction X, of the upper-layer PCB board 200, and the first shield protrusion 1120a is fastened to the upper-layer PCB board. Therefore, the height of the fifth fastening post 1122e and the height of the fifth shield wall 1121e need to be set to be less than the height of the first fastening post 1122a of the first shield protrusion 1120a and the height of the first shield wall 1121a, to adapt to a height relationship between the upper-layer PCB board 200 and the lower-layer PCB board 300, and optimize an overall layout of the vehicle-mounted power supply apparatus 10.

Refer to FIG. 19, FIG. 88, and FIG. 90. FIG. 88 is a diagram of a structure of a bottom housing 100 in a vehicle-mounted power supply apparatus 10 according to an implementation of this application. FIG. 90 is a diagram of a structure of a bottom housing 100 in a vehicle-mounted power supply apparatus 10 according to an implementation of this application. In an implementation, a base plate 170 includes a first shield protrusion 1120a, a second shield protrusion 1120b, a third shield protrusion 1120c, and a fourth shield protrusion 1120d (as shown in FIG. 90). The first shield protrusion 1120a and the second shield protrusion 1120b form a lower-layer PCB board mounting region 1701 (as shown in FIG. 90), and the lower-layer PCB board mounting region 1701 is configured to accommodate the lower-layer PCB board 300 (as shown in FIG. 19). The first shield protrusion 1120a and the right side wall 160 form an AC filter mounting region 1702 (as shown in FIG. 90), and the AC filter mounting region 1702 is configured to accommodate the AC filter 6100 (as shown in FIG. 19). The second shield protrusion 1120b and the left side wall 150 form an HVDC filter mounting region 1720 (as shown in FIG. 90), and the HVDC filter mounting region 1720 is configured to accommodate the HVDC filter 6210 (as shown in FIG. 19). The third shield protrusion 1120c and the right side wall 160 form a PFC capacitor mounting region 1730 (as shown in FIG. 90), and the PFC capacitor mounting region 1730 is configured to accommodate the PFC capacitor 6110 (as shown in FIG. 19). The fourth shield protrusion 1120d and the rear side wall 140 form a PFC inductor mounting region 1740 (as shown in FIG. 90), and the PFC inductor mounting region 1740 is configured to accommodate the PFC inductor 6120 (as shown in FIG. 19).

In this implementation, the first shield protrusion 1120a, the second shield protrusion 1120b, the third shield protrusion 1120c, and the fourth shield protrusion 1120d divide the base plate 170 into a plurality of mounting regions, including the lower-layer PCB board mounting region 1701, the AC filter mounting region 1702, the HVDC filter mounting region 1720, the PFC capacitor mounting region 1730, and the PFC inductor mounting region 1740. The mounting regions are arranged, so that a mounting operation for the power conversion circuit 600 can be performed more easily, and components in the mounting regions can be protected to some extent.

In this implementation, the first shield protrusion 1120a and the left side wall 150 are spaced away, and the first shield protrusion 1120a is located between the AC filter 6100 and the lower-layer PCB board 300 along a left-right direction Z of the vehicle-mounted power supply apparatus 10. The second shield protrusion 1120b and the right side wall 160 are spaced away, and the second shield protrusion 1120b is located between the HVDC filter 6210 and the lower-layer PCB board 300 along the left-right direction Z of the vehicle-mounted power supply apparatus 10. The third shield protrusion 1120c and the left side wall 150 are spaced away, and the third shield protrusion 1120c is located between the PFC capacitor 6110 and the PFC inductor 6120 along the left-right direction Z of the vehicle-mounted power supply apparatus 10. The fourth shield protrusion 1120d and the rear side wall 140 are spaced away, and the fourth shield protrusion 1120d is located between the low-voltage transformer 6310 and the PFC inductor 6120 along a front-rear direction Y of the vehicle-mounted power supply apparatus 10. The first shield protrusion 1120a, the second shield protrusion 1120b, the third shield protrusion 1120c, and the fourth shield protrusion 1120d provide electrical shielding between different components in the power conversion circuit 600. This improves electromagnetic compatibility (Electromagnetic Compatibility, EMC) of the power conversion circuit 600.

In an implementation, the first shield protrusion 1120a, the second shield protrusion 1120b, the third shield protrusion 1120c, and the fourth shield protrusion 1120d are integrated with the bottom housing 100, so that the first shield protrusion 1120a, the second shield protrusion 1120b, the third shield protrusion 1120c, and the fourth shield protrusion 1120d can stably perform electrical isolation between components on two sides. This enhances shielding effect against electromagnetic interference.

Further, refer to FIG. 88. In an implementation, the bottom housing 100 includes an AC filter position-limiting groove 1200. The AC filter position-limiting groove 1200 is configured to accommodate the AC filter 6100. The AC filter position-limiting groove 1200 is located between the lower-layer PCB board 300 and the left side wall 150, and is arranged closer to the front side wall 130 relative to the rear side wall 140.

In this implementation, the AC filter position-limiting groove 1200 is located in an AC filter shield region 1141, so that existing mounting space of the bottom housing 100 is flexibly utilized, and a size of the vehicle-mounted power supply apparatus 10 does not need to be additionally increased. Further, refer to FIG. 88. In an implementation, the bottom housing 100 includes a PFC capacitor position-limiting groove 1210 and a PFC inductor position-limiting groove 1220. The PFC capacitor position-limiting groove 1210 is configured to accommodate the PFC capacitor 6110. The PFC inductor position-limiting groove 1220 is configured to accommodate the PFC inductor 6120.

In this implementation, the PFC capacitor position-limiting groove 1210 is located in a PFC capacitor shield region 1143, so that existing mounting space of the bottom housing 100 is flexibly utilized, and a size of the vehicle-mounted power supply apparatus 10 does not need to be additionally increased.

Further, refer to FIG. 88. In an implementation, the bottom housing 100 includes an LLC transformer position-limiting groove 1230. The LLC transformer position-limiting groove 1230 is configured to accommodate the LLC transformer 6200. The PFC capacitor position-limiting groove 1210, the PFC inductor position-limiting groove 1220, and the LLC transformer position-limiting groove 1230 are arranged along the left-right direction Z of the vehicle-mounted power supply apparatus 10.

In this implementation, the LLC transformer position-limiting groove 1230 is in a rectangular shape, and the shape matches a shape of an end face on a side, facing the LLC transformer position-limiting groove 1230, of the LLC transformer 6200.

Further, refer to FIG. 88. In an implementation, the bottom housing 100 includes a low-voltage transformer position-limiting groove 1240. The low-voltage transformer position-limiting groove 1240 is configured to accommodate the low-voltage transformer 6310.

In this implementation, the low-voltage transformer position-limiting groove 1240 is located in a region between the PFC capacitor position-limiting groove 1210 and the LLC transformer position-limiting groove 1230, and is located in a region between peripheral space of the lower-layer PCB board 300 and the PFC inductor position-limiting groove 1220, so that existing mounting space of the bottom housing 100 is flexibly utilized, and a size of the vehicle-mounted power supply apparatus 10 does not need to be additionally increased.

Further, refer to FIG. 88. In an implementation, the bottom housing 100 includes an HVDC filter position-limiting groove 1260. The HVDC filter position-limiting groove 1260 is configured to accommodate the HVDC filter 6210.

In this implementation, the HVDC filter position-limiting groove 1260 is located in a PFC capacitor shield region 1143, so that existing mounting space of the bottom housing 100 is flexibly utilized, and a size of the vehicle-mounted power supply apparatus 10 does not need to be additionally increased.

Further, refer to FIG. 88. In an implementation, the AC filter position-limiting groove 1200, the PFC capacitor position-limiting groove 1210, the PFC inductor position-limiting groove 1220, the LLC transformer position-limiting groove 1230, the low-voltage transformer position-limiting groove 1240, and the HVDC filter position-limiting groove 1260 are arranged around a periphery of the lower-layer PCB board 300.

In this implementation, a plurality of position-limiting grooves surround the periphery of the lower-layer PCB board 300, and correspondingly, the AC filter 6100, the PFC capacitor 6110, the PFC inductor 6120, the low-voltage transformer 6310, the LLC transformer 6200, and the HVDC filter 6210 surround the periphery of the lower-layer PCB board 300. In this case, along the height direction X of the vehicle-mounted power supply apparatus 10, heights of the foregoing components are not limited by a spacing between the upper-layer PCB board 200 and the lower-layer PCB board 300. A component with a high height or a large space size may be disposed on the periphery of the lower-layer PCB board 300, to flexibly utilize a mounting region in the vehicle-mounted power supply apparatus 10 and improve space utilization. This facilitates a miniaturization design of the vehicle-mounted power supply apparatus 10. A shape of the position-limiting groove may be set based on a shape of a corresponding component.

The foregoing describes in detail the vehicle-mounted power supply apparatus and the vehicle provided in embodiments of this application. In this specification, principles and embodiments of this application are described by using specific examples. The descriptions of the foregoing embodiments are merely intended to help understand the methods of this application and the core ideas thereof. In addition, persons of ordinary skill in the art may modify the specific embodiments and the application scope based on the ideas of this application. To sum up, the content of this specification shall not be construed as a limitation on this application. In this specification, example descriptions of various implementations do not necessarily apply to a same embodiment or example, and the described specific features, structures, materials, or characteristics may be combined in a proper manner in any one or more embodiments or examples. In addition, persons skilled in the art may integrate or combine different embodiments or examples or characteristics of different embodiments or examples described in this specification, provided that they do not conflict with each other.

## Claims

1. A vehicle-mounted power supply apparatus, wherein the vehicle-mounted power supply apparatus comprises a power conversion circuit, an upper-layer PCB board, a lower-layer PCB board, a bottom housing, and a heat dissipator, and the lower-layer PCB board, the upper-layer PCB board, and the heat dissipator are sequentially stacked and fastened to the bottom housing;
the power conversion circuit comprises a plurality of power switching transistors and a plurality of transformers;
the upper-layer PCB board and the lower-layer PCB board are configured to carry the plurality of power switching transistors; and
the bottom housing is configured to support the upper-layer PCB board, the lower-layer PCB board, the heat dissipator, and the plurality of transformers.

2. The vehicle-mounted power supply apparatus according to claim 1, wherein the vehicle-mounted power supply apparatus comprises a cover, the cover is configured to form an accommodation cavity together with the bottom housing, and the accommodation cavity is configured to accommodate the lower-layer PCB board, the upper-layer PCB board, the heat dissipator, and the plurality of transformers; and
the lower-layer PCB board, the upper-layer PCB board, the heat dissipator, and the cover are sequentially stacked along a height direction of the vehicle-mounted power supply apparatus.

3. The vehicle-mounted power supply apparatus according to claim 1, wherein the power conversion circuit comprises an alternating current-to-direct current conversion circuit, a low-voltage direct current conversion circuit, and a high-voltage direct current conversion circuit;
the alternating current-to-direct current conversion circuit is configured to receive an alternating current and supply power to at least one of the high-voltage direct current conversion circuit or the low-voltage direct current conversion circuit;
the low-voltage direct current conversion circuit is configured to receive power supply from at least one of the alternating current-to-direct current conversion circuit or the high-voltage direct current conversion circuit and output a first direct current; and
the high-voltage direct current conversion circuit is configured to receive power supply from the alternating current-to-direct current conversion circuit and output a second direct current, wherein a voltage of the second direct current is higher than a voltage of the first direct current.

4. The vehicle-mounted power supply apparatus according to claim 3, wherein the low-voltage direct current conversion circuit comprises a low-voltage transformer, a primary-side circuit, and a secondary-side circuit, the primary-side circuit is configured to receive power supply from at least one of the alternating current-to-direct current conversion circuit or the high-voltage direct current conversion circuit, and the secondary-side circuit is configured to output the first direct current;
the upper-layer PCB board is configured to carry a plurality of power switching transistors of the primary-side circuit in the low-voltage direct current conversion circuit;
the lower-layer PCB board is configured to carry a plurality of power switching transistors of the secondary-side circuit in the low-voltage direct current conversion circuit; and
the bottom housing is configured to fasten the low-voltage transformer of the low-voltage direct current conversion circuit.

5. The vehicle-mounted power supply apparatus according to claim 1, wherein the bottom housing comprises a plurality of first protrusions and two shield protrusions, the plurality of first protrusions are distributed in a bottom housing region between the two shield protrusions, and heights of the plurality of first protrusions are less than heights of the two shield protrusions along a height direction of the vehicle-mounted power supply apparatus;
the plurality of first protrusions are configured to fasten the lower-layer PCB board;
the two shield protrusions are configured to fasten the upper-layer PCB board; and
the two shield protrusions and the upper-layer PCB board form a lower-layer PCB board shield region, and the lower-layer PCB board shield region is configured to reduce electrical interference to the lower-layer PCB board.

6. The vehicle-mounted power supply apparatus according to claim 1, wherein the bottom housing comprises a base plate, a front side wall, a rear side wall, a left side wall, and a right side wall, the front side wall and the rear side wall are arranged opposite to each other, the left side wall and the right side wall are arranged opposite to each other, and the base plate, the front side wall, the rear side wall, the left side wall, and the right side wall form a groove structure; and
a height of any one of the front side wall, the rear side wall, the left side wall, and the right side wall is greater than a height of the upper-layer PCB board along a height direction of the vehicle-mounted power supply apparatus.

7. The vehicle-mounted power supply apparatus according to claim 6, wherein the lower-layer PCB board and the plurality of transformers are tiled above the base plate, the upper-layer PCB board is stacked above the lower-layer PCB board and the plurality of transformers, the heat dissipator is stacked above the upper-layer PCB board, and an orthographic projection of the lower-layer PCB board on the base plate and an orthographic projection of the heat dissipator on the base plate are staggered.

8. The vehicle-mounted power supply apparatus according to claim 6, wherein the front side wall comprises a plurality of electrical interfaces, and the rear side wall comprises a cooling channel interface;
the lower-layer PCB board is closer to the front side wall than the heat dissipator, and the lower-layer PCB board and the upper-layer PCB board are configured to electrically connect to at least one of the plurality of electrical interfaces; and
the heat dissipator is closer to the rear side wall than the lower-layer PCB board, and the heat dissipator is configured to connect to the cooling channel interface.

9. The vehicle-mounted power supply apparatus according to claim 6, wherein the front side wall comprises a first direct current interface and a control signal interface, and the power conversion circuit outputs a first direct current through the first direct current interface and receives a control signal through the control signal interface;
a lower surface of the upper-layer PCB board comprises a control signal connector, and the control signal connector is configured to electrically connect the control signal interface to the upper-layer PCB board; and
an upper surface of the lower-layer PCB board comprises at least a part of a low-voltage filter circuit, and the low-voltage filter circuit is configured to electrically connect the first direct current interface to the lower-layer PCB board.

10. The vehicle-mounted power supply apparatus according to claim 9, wherein a shield can is disposed between the upper-layer PCB board and the lower-layer PCB board, and the shield can is configured to:
form a control signal shield cavity together with the lower surface of the upper-layer PCB board, wherein the control signal shield cavity is configured to accommodate the control signal connector; and
form a low-voltage filter shield cavity together with the upper surface of the lower-layer PCB board, wherein the low-voltage filter shield cavity is configured to accommodate at least a part of the low-voltage filter circuit.

11. The vehicle-mounted power supply apparatus according to claim 6, wherein the heat dissipator comprises an upper-layer cooling channel, the bottom housing comprises a lower-layer cooling channel, the rear side wall comprises a cooling channel interface, the cooling channel interface is configured for an external cooling system to communicate with the lower-layer cooling channel and the upper-layer cooling channel, and the external cooling system is configured to exchange a cooling medium with the lower-layer cooling channel and the upper-layer cooling channel through the cooling channel interface.

12. The vehicle-mounted power supply apparatus according to claim 11, wherein the cooling channel interface comprises:
two heat dissipator interfaces, wherein the heat dissipator interfaces are disposed on an upper surface of the rear side wall, and the two heat dissipator interfaces are configured to communicate with an inlet and an outlet of the upper-layer cooling water channel respectively;
two external cooling system interfaces, wherein the external cooling system interfaces are disposed on a side surface, away from the upper-layer PCB board, of the rear side wall, and the two external cooling system interfaces are configured to communicate with an outlet and an inlet of the external cooling system respectively; and
two bottom housing connection interfaces, wherein the two bottom housing connection interfaces are configured to communicate with an inlet and an outlet of the lower-layer cooling water channel respectively.

13. The vehicle-mounted power supply apparatus according to claim 6, wherein the power conversion circuit comprises an AC filter, a PFC capacitor, a PFC inductor, a low-voltage transformer, an LLC transformer, and an HVDC filter;
the PFC capacitor, the PFC inductor, and the LLC transformer are adjacently arranged close to the rear side wall of the vehicle-mounted power supply apparatus;
the PFC capacitor and the AC filter are adjacently arranged close to the right side wall of the vehicle-mounted power supply apparatus; and
the HVDC filter and the LLC transformer are adjacently arranged close to the left side wall of the vehicle-mounted power supply apparatus.

14. The vehicle-mounted power supply apparatus according to claim 13, wherein the base plate comprises a first shield protrusion, a second shield protrusion, a third shield protrusion, and a fourth shield protrusion;
the first shield protrusion and the second shield protrusion form a lower-layer PCB board mounting region, and the lower-layer PCB board mounting region is configured to accommodate the lower-layer PCB board;
the first shield protrusion and the right side wall form an AC filter mounting region, and the AC filter mounting region is configured to accommodate the AC filter;
the second shield protrusion and the left side wall form an HVDC filter mounting region, and the HVDC filter mounting region is configured to accommodate the HVDC filter;
the third shield protrusion and the right side wall form a PFC capacitor mounting region, and the PFC capacitor mounting region is configured to accommodate the PFC capacitor; and
the fourth shield protrusion and the rear side wall form a PFC inductor mounting region, and the PFC inductor mounting region is configured to accommodate the PFC inductor.

15. A vehicle, comprising a first-type load, a battery, and the vehicle-mounted power supply apparatus according to any one of the foregoing claims, wherein the power conversion circuit is configured to output a first direct current and a second direct current, the first direct current is to be transmitted to the first-type load to supply power, the second direct current is to be transmitted to the battery to supply power, and a voltage of the second direct current is higher than a voltage of the first direct current.
